(19) Europäisches Patentamt
European Patent Office
Office européen des brevets

(11) EP 4 701 383 A1

(12) **EUROPEAN PATENT APPLICATION**

(43) Date of publication:
**25.02.2026 Bulletin 2026/09**

(21) Application number: **24195613.5**

(22) Date of filing: **21.08.2024**

(51) International Patent Classification (IPC):
***H10K 59/32*** *(2023.01)* *H10K 85/60* *(2023.01)*

(52) Cooperative Patent Classification (CPC):
**H10K 59/32;** H10K 85/60; H10K 85/615; H10K 85/631; H10K 85/654; H10K 85/657; H10K 85/6572; H10K 2101/40

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Novaled GmbH**
**01099 Dresden (DE)**

(72) Inventors:
- **SCHULZE, Benjamin c/o Novaled GmbH 01099 Dresden (DE)**
- **ROSENOW, Thomas c/o Novaled GmbH 01099 Dresden (DE)**
- **NÜLLEN, Max Peter c/o Novaled GmbH 01099 Dresden (DE)**
- **WUDARCZYK, Jakob Jacek c/o Novaled GmbH 01099 Dresden (DE)**
- **PINTER, Piermaria c/o Novaled GmbH 01099 Dresden (DE)**

(74) Representative: **Michalski Hüttermann & Partner Patentanwälte mbB**
**Kaistraße 16A**
**40221 Düsseldorf (DE)**

(54) **ORGANIC ELECTROLUMINESCENT DEVICE AND A DISPLAY DEVICE COMPRISING THE ORGANIC ELECTROLUMINESCENT DEVICE**

(57) The present invention is directed to an organic electroluminescent device comprising a p-type dopant of formula (I) and a p-type dopant of formula (II), and a display device comprising the organic electroluminescent device.

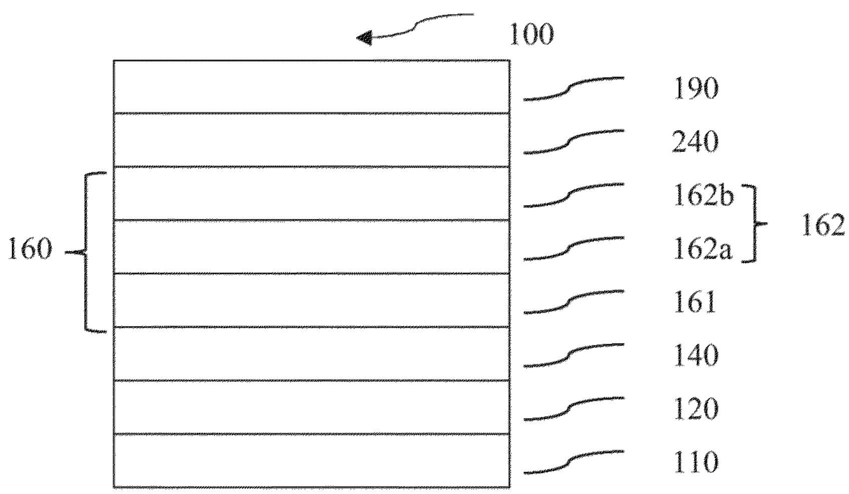


Fig. 1

EP 4 701 383 A1

## Description

### Technical Field

The present invention relates to an organic electroluminescent device comprising a p-type dopant of formula (I) and a p-type dopant of formula (II), and a display device comprising the organic electroluminescent device.

### Background Art

Organic electroluminescent devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

US2023329103 discloses a light-emitting device includes a first electrode, a second electrode facing the first electrode, and an interlayer between the first electrode and the second electrode. The interlayer includes m emitting parts, and m-1 charge generation parts between two adjacent ones of the emitting parts, wherein m is an integer of 2 or more. At least one of the charge generation parts includes an n-type charge generation layer, a first p-type charge generation layer, and a second p-type charge generation layer. A band gap of the second p-type charge generation layer is greater than a band gap of the first p-type charge generation layer.

US2023422538A1 discloses an organic electroluminescent device includes an anode, a cathode, and an organic layer disposed between the anode and cathode; the organic layer includes a first organic layer and a second organic layer; the first organic layer includes a first p-type dopant; the second organic layer includes a second p-type dopant; the first p-type dopant is different from the second dopant; the first organic layer is in contact with the second organic layer, and the second organic layer is above the first organic layer. The organic electroluminescent device including specific p-type dopants and having a specific device structure can significantly improve the overall performance of the device, especially the device lifetime or the device efficiency. Further provided is an electronic assembly including the organic electroluminescent device.

Performance of an organic light emitting diode may be affected by characteristics of the semiconductor layers, and among them, may be affected by characteristics of the compounds contained in the semiconductor layers.

There remains a need to improve performance of organic electroluminescent devices, in particular to achieve improved operating voltage, improved efficiency, improved lifetime, improved operating voltage stability over time and/or improved sheet resistance of the charge generation layer.

### DISCLOSURE

An aspect of the present invention provides an organic electroluminescent device comprising an anode layer, a cathode layer, a first light-emitting unit, a second light-emitting unit, and at least one charge generation layer;

wherein

- the at least one charge generation layer is arranged between the first light-emitting unit and the second light-emitting unit;

wherein

- the at least one charge generation layer comprises a n-type charge generation layer, and a p-type charge generation layer, wherein the n-type charge generation layer is arranged closer to the anode layer and the p-type charge generation layer is arranged closer to the cathode layer;

wherein

- the p-type charge generation layer (p-CGL) comprises a first p-CGL sub-layer (p-CGL1) and a second p-CGL

sub-layer (p-CGL2);

wherein

- the first p-CGL sub-layer (p-CGL1) comprises a first hole transport matrix compound and a p-type dopant of formula (I):

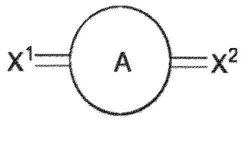
(I),

$X^1$ and $X^2$ are independently selected from formula (Ia):

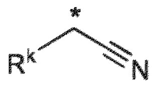
(Ia),

wherein the asterisk "*" denotes the binding position;
$R^k$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
A is selected from a group comprising of B1 or B2:

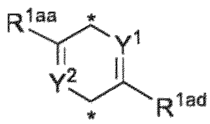
(B1),
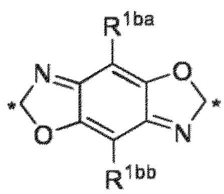
(B2),

wherein each $X^1$ and $X^2$ is conjugated via a double-bond to A;

- $Y^1$ is selected from N or $CR^{1ab}$;
- $Y^2$ is selected from N or $CR^{1ac}$;
- $R^{1aa}$, $R^{1ab}$, $R^{1ac}$, $R^{1ad}$, $R^{1ba}$ and $R^{1bb}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially

fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the second p-CGL sub-layer (p-CGL2) comprises a second hole transport matrix compound and a p-type dopant of formula (II);

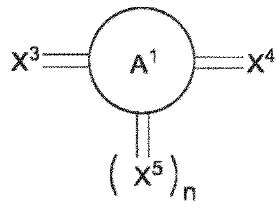
(II),

n is an integer selected from 0 or 1;
$X^3$, $X^4$ and $X^5$ are independently selected from formula (IIa)

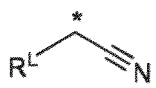
(IIa),

wherein the asterisk "*" denotes the binding position;
$R^L$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$A^1$ is selected from a group comprising of (P1) to (P5):

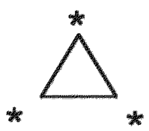
(P1),
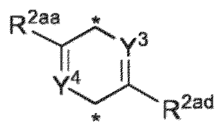
(P2),
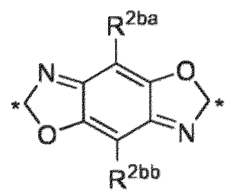
(P3),

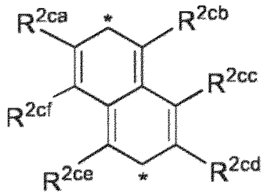 (P4), 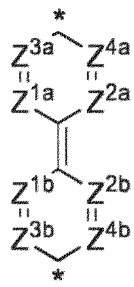 (P5),

wherein each $X^3$, $X^4$, and/or $X^5$ are conjugated via a double-bond to $A^1$;

- $Y^3$ is selected from N or $CR^{2ab}$;
- $Y^4$ is selected from N or $CR^{2ac}$;
- $Z^{1a}$, $Z^{2a}$, $Z^{3a}$, $Z^{4a}$, $Z^{1b}$, $Z^{2b}$, $Z^{3b}$, $Z^{4b}$ are independently selected from N or $CR^{2da}$, preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the p-type dopant of formula (I) is different from the p-type dopant of formula (II);
- the first p-CGL sub-layer (p-CGL1) is in direct contact with the second p-CGL sub-layer (p-CGL2);
- the first p-CGL sub-layer (p-CGL1) is in direct contact to the n-type charge generation layer and the second p-CGL sub-layer (p-CGL2) is arranged closer to the cathode layer;
- the n-type charge generation layer (n-CGL) comprises a n-CGL matrix compound and a metal dopant.

It should be noted that throughout the application and the claims any A, $A^1$, $R^k$, $R^L$, $R^{1aa}$, $R^{1ab}$, $R^{1ac}$, $R^{1ad}$, $R^{1ba}$ and $R^{1bb}$, $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$, $X^1$, $X^2$, $X^3$, $X^4$ and $X^5$, $Y^1$, $Y^2$, $Y^3$ and $Y^4$, $Z^{1a}$, $Z^{2a}$, $Z^{3a}$, $Z^{4a}$, $Z^{1b}$, $Z^{2b}$, $Z^{3b}$ $Z^{4b}$, etc. always refer to the same moieties, unless otherwise noted.

In the present specification, when a definition is not otherwise provided, "substituted" refers to one substituted with a deuterium, $C_1$ to $C_{12}$ alkyl and $C_1$ to $C_{12}$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of

one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms.

The term "cyano moiety" refers to a CN substituent.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include $NO_2$, CN, halogen, Cl, F, partially fluorinated or perfluorinated alkyl and partially fluorinated or perfluorinated $C_1$ to $C_{12}$ alkyl, partially fluorinated or perfluorinated alkoxy, partially fluorinated or perfluorinated $C_1$ to $C_6$ alkoxy and $SF_5$.

In the present specification, the single bond refers to a direct bond.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

The term "top emission device" is understood to mean an organic electronic device wherein the light is emitted through the cathode layer.

The term "bottom emission device" is understood to mean an organic electronic device wherein the light is emitted through the substrate.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

## Advantageous Effects

Surprisingly, it was found that the organic electroluminescent device according to the invention solves the problem underlying the present invention by enabling devices in various aspects superior over the organic electroluminescent devices known in the art, in particular with respect to improved operating voltage, improved efficiency, improved lifetime, improved operating voltage stability over time and/or improved sheet resistance of the charge

generation layer.

**Embodiments**

According to one embodiment the organic electroluminescent device wherein the first light-emitting unit and the second light-emitting unit emit light in the blue region of the spectrum.

According to one embodiment, the organic electroluminescent device further comprises a third light-emitting unit and a second charge generation layer, wherein the second charge generation layer is arranged between the second light-emitting unit and the third light-emitting unit, wherein the second charge generation layer has the same composition as the at least one charge-generation layer arranged between the first light-emitting unit and the second light-emitting unit.

According to one embodiment, the organic electroluminescent device further comprises a third light-emitting unit and a second charge generation layer, wherein the second charge generation layer is arranged between the second light-emitting unit and the third light-emitting unit, wherein the second charge generation layer has the same composition as the at least one charge-generation layer arranged between the first light-emitting unit and the second light-emitting unit, wherein the first light-emitting unit, the second light-emitting unit and the third light-emitting unit emit light in the blue region of the spectrum.

According to one embodiment, the absolute value of the LUMO energy level of the p-type dopant of formula (I) is larger than the absolute value of the LUMO energy level of the p-type dopant of formula (II), when determined by the same method under the same conditions.

According to one embodiment of the organic electroluminescent device comprising an anode layer, a cathode layer, a first light-emitting unit, a second light-emitting unit, and at least one charge generation layer;

wherein

- the at least one charge generation layer is arranged between the first light-emitting unit and the second light-emitting unit;

wherein

- the at least one charge generation layer comprises a n-type charge generation layer, and a p-type charge generation layer, wherein the n-type charge generation layer is arranged closer to the anode layer and the p-type charge generation layer is arranged closer to the cathode layer;

wherein

- the p-type charge generation layer (p-CGL) comprises a first p-CGL sub-layer (p-CGL1) and a second p-CGL sub-layer (p-CGL2);

wherein

- the first p-CGL sub-layer (p-CGL1) comprises a first hole transport matrix compound and a p-type dopant of formula (I):

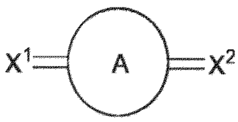
(I),

$X^1$ and $X^2$ are independently selected from formula (Ia):

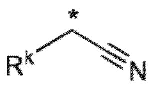
(Ia),

wherein the asterisk "*" denotes the binding position;

$R^k$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl,

$CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,

wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;

wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

A is selected from a group comprising of B1 or B2:

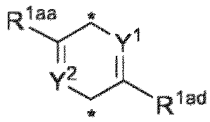 (B1), 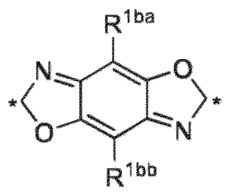 (B2),

wherein each $X^1$ and $X^2$ is conjugated via a double-bond to A;

- $Y^1$ is selected from N or $CR^{1ab}$;
- $Y^2$ is selected from N or $CR^{1ac}$;
- $R^{1aa}$, $R^{1ab}$, $R^{1ac}$, $R^{1ad}$, $R^{1ba}$ and $R^{1bb}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $- NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the second p-CGL sub-layer (p-CGL2) comprises a second hole transport matrix compound and a p-type dopant of formula (II);

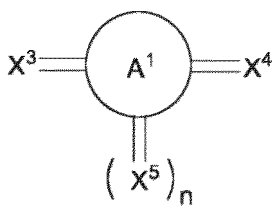 (II),

n is an integer selected from 0 or 1;

$X^3$, $X^4$ and $X^5$ are independently selected from formula (IIa)

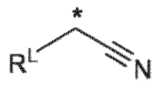 (IIa),

wherein the asterisk "*" denotes the binding position;
$R^L$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$A^1$ is selected from a group comprising of (P1) to (P5):

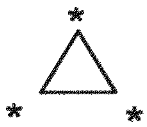 (P1), 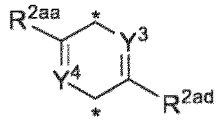 (P2), 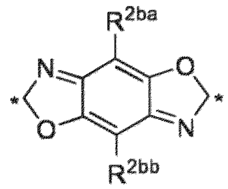 (P3),

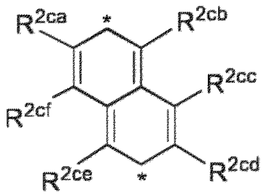 (P4), 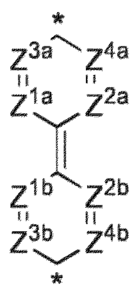 (P5),

wherein each $X^3$, $X^4$, and/or $X^5$ are conjugated via a double-bond to $A^1$;

- $Y^3$ is selected from N or $CR^{2ab}$;
- $Y^4$ is selected from N or $CR^{2ac}$;
- $Z^{1a}$, $Z^{2a}$, $Z^{3a}$, $Z^{4a}$, $Z^{1b}$, $Z^{2b}$, $Z^{3b}$, $Z^{4b}$ are independently selected from N or $CR^{2aa}$, preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the p-type dopant of formula (I) is different from the p-type dopant of formula (II);
- the first p-CGL sub-layer (p-CGL1) is in direct contact with the second p-CGL sub-layer (p-CGL2);
- the first p-CGL sub-layer (p-CGL1) is in direct contact to the n-type charge generation layer and the second p-CGL sub-layer (p-CGL2) is arranged closer to the cathode layer;

  - the n-type charge generation layer (n-CGL) comprises a n-CGL matrix compound and a metal dopant; and
  - wherein the organic electroluminescent device further comprises a hole injection layer, preferably the hole injection layer is in direct contact with the anode layer, more preferred the hole injection layer is a single layer comprising one p-type dopant of formula (I) or one p-type dopant of formula (II).

Thereby, the performance of the organic electroluminescent device may be improved while the number of vacuum thermal sources required for preparation of the organic electroluminescent device is kept to a minimum.
According to one embodiment of the organic electroluminescent device comprising an anode layer, a cathode layer, a first light-emitting unit, a second light-emitting unit, and at least one charge generation layer;

wherein

- the at least one charge generation layer is arranged between the first light-emitting unit and the second light-emitting unit;

wherein

- the at least one charge generation layer comprises a n-type charge generation layer, and a p-type charge generation layer, wherein the n-type charge generation layer is arranged closer to the anode layer and the p-type charge generation layer is arranged closer to the cathode layer;

wherein

- the p-type charge generation layer (p-CGL) comprises a first p-CGL sub-layer (p-CGL1) and a second p-CGL sub-layer (p-CGL2);

wherein

- the first p-CGL sub-layer (p-CGL1) comprises a first hole transport matrix compound and a p-type dopant of formula (I):

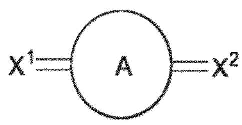
(I),

X[1] and X[2] are independently selected from formula (Ia):

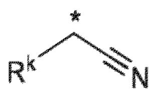
(Ia),

wherein the asterisk "*" denotes the binding position;
$R^k$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
A is selected from a group comprising of B1 or B2:

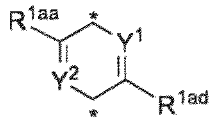 (B1), 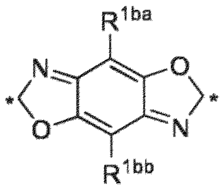 (B2),

wherein each $X^1$ and $X^2$ is conjugated via a double-bond to A;

- $Y^1$ is selected from Nor $CR^{1ab}$;
- $Y^2$ is selected from N or $CR^{1ac}$;
- $R^{1aa}$, $R^{1ab}$, $R^{1ac}$, $R^{1ad}$, $R^{1ba}$ and $R^{1bb}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $- NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the second p-CGL sub-layer (p-CGL2) comprises a second hole transport matrix compound and a p-type dopant of formula (II);

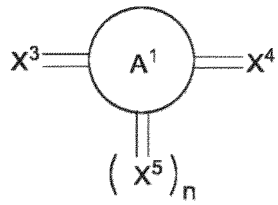

(II),

n is an integer selected from 0 or 1;
$X^3$, $X^4$ and $X^5$ are independently selected from formula (IIa)

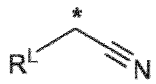

(IIa),

wherein the asterisk "*" denotes the binding position;
$R^L$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$A^1$ is selected from a group comprising of (P1) to (P5):

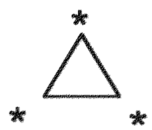

(P1),

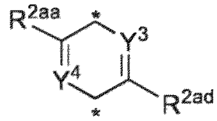

(P2),

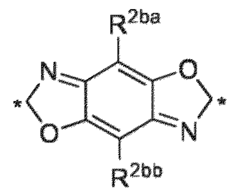

(P3),

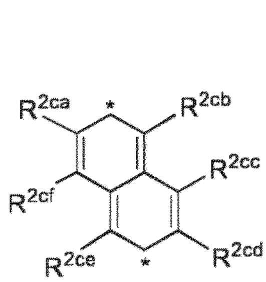

(P4),

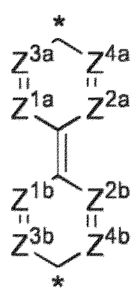

(P5),

wherein each $X^3$, $X^4$, and/or $X^5$ are conjugated via a double-bond to $A^1$;

- $Y^3$ is selected from N or $CR^{22b}$;
- $Y^4$ is selected from N or $CR^{2ac}$;

- $Z^{1a}$, $Z^{2a}$, $Z^{3a}$, $Z^{4a}$, $Z^{1b}$, $Z^{2b}$, $Z^{3b}$, $Z^{4b}$ are independently selected from N or $CR^{2da}$, preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the p-type dopant of formula (I) is different from the p-type dopant of formula (II);
- the first p-CGL sub-layer (p-CGL1) is in direct contact with the second p-CGL sub-layer (p-CGL2);
- the first p-CGL sub-layer (p-CGL1) is in direct contact to the n-type charge generation layer and the second p-CGL sub-layer (p-CGL2) is arranged closer to the cathode layer;

  - the n-type charge generation layer (n-CGL) comprises a n-CGL matrix compound and a metal dopant; and
  - wherein the organic electroluminescent device further comprises a hole injection layer, preferably the hole injection layer is in direct contact with the anode layer, more preferred the hole injection layer is a single layer comprising one p-type dopant of formula (I) or one p-type dopant of formula (II).
    and wherein the organic electroluminescent device further comprises a hole injection layer, wherein the hole injection layer comprises one p-type dopant of formula (I) or one p-type dopant formula (II); preferably the hole injection layer is in direct contact with the anode layer, and/or preferably the concentration of the p-type dopant of formula (I) or the p-type dopant formula (II) in the hole injection layer is lower than the concentration of the p-type dopant of formula (I) in the first p-CGL sub-layer and/or the concentration of the p-type dopant of formula (II) in the second p-CGL sub-layer.

Thereby, the performance of the organic electroluminescent device may be improved while the number of vacuum thermal sources required for preparation of the organic electroluminescent device is kept to a minimum.

According to one embodiment of the organic electroluminescent device comprising an anode layer, a cathode layer, a first light-emitting unit, a second light-emitting unit, and at least one charge generation layer;

wherein

- the at least one charge generation layer is arranged between the first light-emitting unit and the second light-emitting unit;

wherein

- the at least one charge generation layer comprises a n-type charge generation layer, and a p-type charge generation layer, wherein the n-type charge generation layer is arranged closer to the anode layer and the p-type charge generation layer is arranged closer to the cathode layer;

wherein

- the p-type charge generation layer (p-CGL) comprises a first p-CGL sub-layer (p-CGL1) and a second p-CGL sub-layer (p-CGL2);

wherein

- the first p-CGL sub-layer (p-CGL1) comprises a first hole transport matrix compound and a p-type dopant of formula (I):

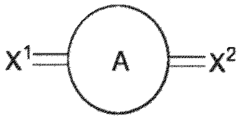

(I),

$X^1$ and $X^2$ are independently selected from formula (Ia):

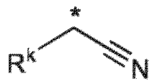

(Ia),

wherein the asterisk "*" denotes the binding position;
$R^k$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, -$NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, -$NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, -$NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
A is selected from a group comprising of B1 or B2:

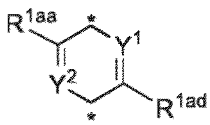

(B1),

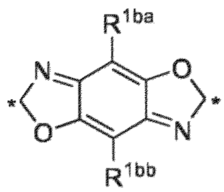

(B2),

wherein each $X^1$ and $X^2$ is conjugated via a double-bond to A;

- $Y^1$ is selected from N or $CR^{1ab}$;
- $Y^2$ is selected from N or $CR^{1ac}$;
- $R^{1aa}$, $R^{1ab}$, $R^{1ac}$, $R^{1ad}$, $R^{1ba}$ and $R^{1bb}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, -$NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, -$NO_2$, $SF_5$, substituted or unsubstituted $C_6$ to $C_{12}$ aryl, substituted or unsubstituted $C_3$ to $C_{12}$ heteroaryl;

wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, - $NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the second p-CGL sub-layer (p-CGL2) comprises a second hole transport matrix compound and a p-type dopant of formula (II);

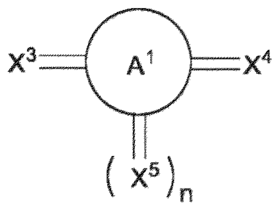

(II),

n is an integer selected from 0 or 1;
$X^3$, $X^4$ and $X^5$ are independently selected from formula (IIa)

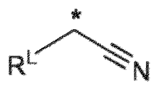

(IIa),

wherein the asterisk "*" denotes the binding position;
$R^L$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$A^1$ is selected from a group comprising of (P1) to (P5):

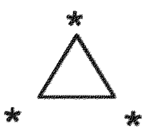

(P1),

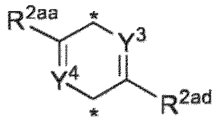

(P2),

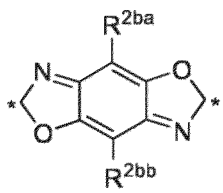

(P3),

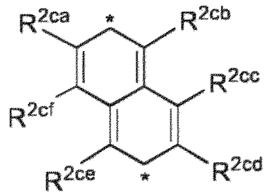 (P4), 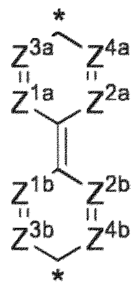 (P5),

wherein each $X^3$, $X^4$, and/or $X^5$ are conjugated via a double-bond to $A^1$;

- $Y^3$ is selected from N or $CR^{2ab}$;
- $Y^4$ is selected from N or $CR^{2ac}$;
- $Z^{1a}$, $Z^{2a}$, $Z^{3a}$, $Z^{4a}$, $Z^{1b}$, $Z^{2b}$, $Z^{3b}$, $Z^{4b}$ are independently selected from N or $CR^{2da}$, preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the p-type dopant of formula (I) is different from the p-type dopant of formula (II);
- the first p-CGL sub-layer (p-CGL1) is in direct contact with the second p-CGL sub-layer (p-CGL2);
- the first p-CGL sub-layer (p-CGL1) is in direct contact to the n-type charge generation layer and the second p-CGL sub-layer (p-CGL2) is arranged closer to the cathode layer;

  - the n-type charge generation layer (n-CGL) comprises a n-CGL matrix compound and a metal dopant; and
  - wherein the organic electroluminescent device further comprises a hole injection layer, preferably the hole injection layer is in direct contact with the anode layer, more preferred the hole injection layer is a single layer comprising one p-type dopant of formula (I) or one p-type dopant of formula (II).
    and wherein the p-type dopant of formula (I) and/or the p-type dopant of formula (II) comprises at least two groups independently selected from substituted $C_6$ to $C_{30}$ aryl groups or substituted $C_3$ to $C_{30}$ heteroaryl groups, wherein the one or more substituents are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$; preferably F, $CF_3$, $OCF_3$, CN, isocyano, SCN, OCN, $-NO_2$, $SF_5$; more preferred F, $CF_3$, $OCF_3$, CN, $-NO_2$.

Thereby, the p-type dopant of formula (I) and/or the p-type dopant of formula (II) may have physical properties suitable for mass production of organic electroluminescent devices.

According to one embodiment of the organic electroluminescent device comprising an anode layer, a cathode layer, a first light-emitting unit, a second light-emitting unit, and at least one charge generation layer;

wherein

- the at least one charge generation layer is arranged between the first light-emitting unit and the second light-emitting unit;

wherein

- the at least one charge generation layer comprises a n-type charge generation layer, and a p-type charge generation layer, wherein the n-type charge generation layer is arranged closer to the anode layer and the p-type charge generation layer is arranged closer to the cathode layer;

wherein

- the p-type charge generation layer (p-CGL) comprises a first p-CGL sub-layer (p-CGL1) and a second p-CGL sub-layer (p-CGL2);

wherein

- the first p-CGL sub-layer (p-CGL1) comprises a first hole transport matrix compound and a p-type dopant of formula (I):

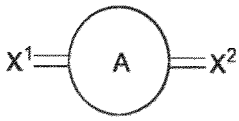
(I),

$X^1$ and $X^2$ are independently selected from formula (Ia):

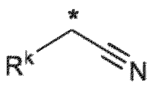
(Ia),

wherein the asterisk "*" denotes the binding position;
$R^k$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
A is selected from a group comprising of B1 or B2:

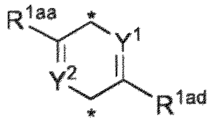 (B1), 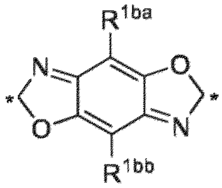 (B2),

wherein each $X^1$ and $X^2$ is conjugated via a double-bond to A;

- $Y^1$ is selected from N or $CR^{1ab}$;
- $Y^2$ is selected from N or $CR^{1ac}$;
- $R^{1aa}$, $R^{1ab}$, $R^{1ac}$, $R^{1ad}$, $R^{1ba}$ and $R^{1bb}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the second p-CGL sub-layer (p-CGL2) comprises a second hole transport matrix compound and a p-type dopant of formula (II);

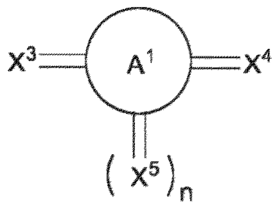 (II),

n is an integer selected from 0 or 1;
$X^3$, $X^4$ and $X^5$ are independently selected from formula (IIa)

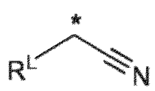 (IIa),

wherein the asterisk "*" denotes the binding position;
$R^L$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy,

partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl; wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^1$ is selected from a group comprising of (P1) to (P5):

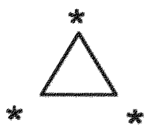
(P1),
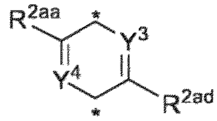
(P2),
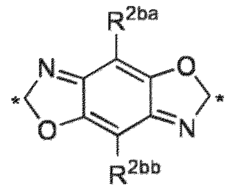
(P3),

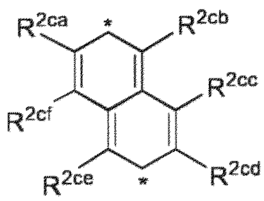
(P4),
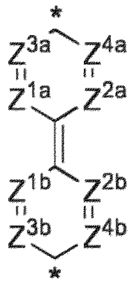
(P5),

wherein each $X^3$, $X^4$, and/or $X^5$ are conjugated via a double-bond to $A^1$;

- $Y^3$ is selected from Nor $CR^{2ab}$;
- $Y^4$ is selected from N or $CR^{2ac}$;
- $z^{1a}$, $Z^{2a}$, $Z^{3a}$, $Z^{4a}$, $Z^{1b}$, $Z^{2b}$, $Z^{3b}$, $Z^{4b}$ are independently selected from Nor $CR^{2da}$, preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $- NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the p-type dopant of formula (I) is different from the p-type dopant of formula (II);
- the first p-CGL sub-layer (p-CGL1) is in direct contact with the second p-CGL sub-layer (p-CGL2);
- the first p-CGL sub-layer (p-CGL1) is in direct contact to the n-type charge generation layer and the second p-CGL sub-layer (p-CGL2) is arranged closer to the cathode layer;

- the n-type charge generation layer (n-CGL) comprises a n-CGL matrix compound and a metal dopant; and
- wherein the organic electroluminescent device further comprises a hole injection layer, preferably the hole injection layer is in direct contact with the anode layer, more preferred the hole injection layer is a single layer comprising one p-type dopant of formula (I) or one p-type dopant of formula (II); and

  wherein the p-type dopant of formula (I) and/or the p-type dopant of formula (II) comprises at least two groups independently selected from substituted $C_6$ to $C_{30}$ aryl groups or substituted $C_3$ to $C_{30}$ heteroaryl groups, wherein the one or more substituents are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$; preferably F, $CF_3$, $OCF_3$, CN, isocyano, SCN, OCN, $-NO_2$, $SF_5$; more preferred F, $CF_3$, $OCF_3$, CN, $-NO_2$; and wherein the concentration of the p-type dopant of formula (I) or formula (II) in the hole injection layer is lower than the concentration of p-type dopant of formula (I) in the first p-CGL sub-layer and/or of the p-type dopant of formula (II) in the second p-CGL sub-layer.

Thereby, the p-type dopant of formula (I) and/or the p-type dopant of formula (II) may have physical properties suitable for mass production of organic electroluminescent devices.

Additionally, the performance of the organic electroluminescent device may be improved while the number of vacuum thermal sources required for preparation of the organic electroluminescent device is kept to a minimum.

According to one embodiment of the organic electroluminescent device comprising an anode layer, a cathode layer, a first light-emitting unit, a second light-emitting unit, and at least one charge generation layer;

wherein

- the at least one charge generation layer is arranged between the first light-emitting unit and the second light-emitting unit;

wherein

- the at least one charge generation layer comprises a n-type charge generation layer, and a p-type charge generation layer, wherein the n-type charge generation layer is arranged closer to the anode layer and the p-type charge generation layer is arranged closer to the cathode layer;

wherein

- the p-type charge generation layer (p-CGL) comprises a first p-CGL sub-layer (p-CGL1) and a second p-CGL sub-layer (p-CGL2);

wherein

- the first p-CGL sub-layer (p-CGL1) comprises a first hole transport matrix compound and a p-type dopant of formula (I):

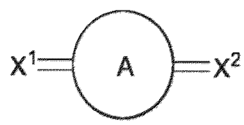

(I),

$X^1$ and $X^2$ are independently selected from formula (Ia):

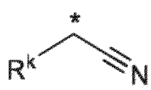

(Ia),

wherein the asterisk "*" denotes the binding position;

$R^k$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl,

$CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
A is selected from a group comprising of B1 or B2:

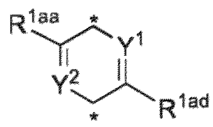
(B1),

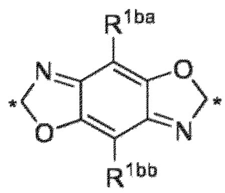
(B2),

wherein each $X^1$ and $X^2$ is conjugated via a double-bond to A;

- $Y^1$ is selected from N or $CR^{1ab}$;
- $Y^2$ is selected from N or $CR^{1ac}$;
- $R^{1aa}$, $R^{1ab}$, $R^{1ac}$, $R^{1ad}$, $R^{1ba}$ and $R^{1bb}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $- NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the second p-CGL sub-layer (p-CGL2) comprises a second hole transport matrix compound and a p-type dopant of formula (II);

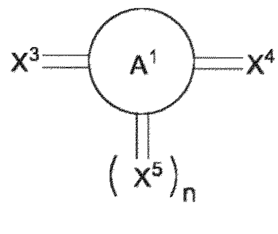
(II),

n is an integer selected from 0 or 1;

$X^3$, $X^4$ and $X^5$ are independently selected from formula (IIa)

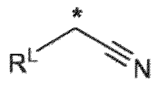 (IIa),

wherein the asterisk "*" denotes the binding position;

$R^L$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,

wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;

wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^1$ is selected from a group comprising of (P1) to (P5):

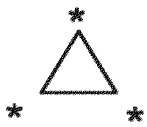 (P1), 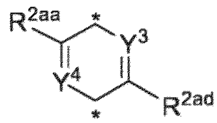 (P2), 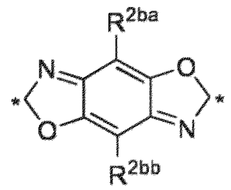 (P3),

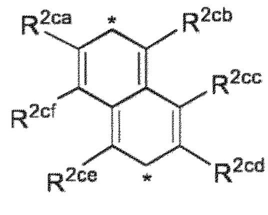 (P4), 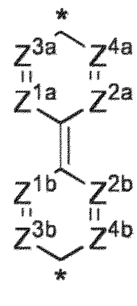 (P5),

wherein each $X^3$, $X^4$, and/or $X^5$ are conjugated via a double-bond to $A^1$;

- $Y^3$ is selected from N or $CR^{2ab}$;
- $Y^4$ is selected from N or $CR^{2ac}$;
- $Z^{1a}$, $Z^{2a}$, $Z^{3a}$, $Z^{4a}$, $Z^{1b}$, $Z^{2b}$, $Z^{3b}$, $Z^{4b}$ are independently selected from N or $CR^{2da}$, preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,

  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl; wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, - $NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the p-type dopant of formula (I) is different from the p-type dopant of formula (II);
- the first p-CGL sub-layer (p-CGL1) is in direct contact with the second p-CGL sub-layer (p-CGL2);
- the first p-CGL sub-layer (p-CGL1) is in direct contact to the n-type charge generation layer and the second p-CGL sub-layer (p-CGL2) is arranged closer to the cathode layer;

  - the n-type charge generation layer (n-CGL) comprises a n-CGL matrix compound and a metal dopant; and
  - wherein the organic electroluminescent device further comprises a hole injection layer, preferably the hole injection layer is in direct contact with the anode layer, more preferred the hole injection layer is a single layer comprising one p-type dopant of formula (I) or one p-type dopant of formula (II); and

wherein the p-type dopant of formula (I) and/or the p-type dopant of formula (II) comprises at least two groups independently selected from substituted $C_6$ to $C_{30}$ aryl groups or substituted $C_3$ to $C_{30}$ heteroaryl groups, wherein the one or more substituents are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$; preferably F, $CF_3$, $OCF_3$, CN, isocyano, SCN, OCN, $-NO_2$, $SF_5$; more preferred F, $CF_3$, $OCF_3$, CN, $-NO_2$; and wherein the p-dopant of formula (I) and/or the p-type dopant of formula (II) comprises at least two 6-membered carbocyclic rings, at least two groups selected from substituted $C_6$ to $C_{12}$ aryl groups or at least two groups selected from substituted $C_3$ to $C_{12}$ heteroaryl groups.

According to one embodiment, wherein the p-type dopant of formula (I) and/or the p-type dopant of formula (II) comprises at least two groups independently selected from substituted $C_6$ to $C_{30}$ aryl groups or substituted $C_3$ to $C_{30}$ heteroaryl groups, wherein the one or more substituents are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, - $NO_2$, $SF_5$; preferably F, $CF_3$, $OCF_3$, CN, isocyano, SCN, OCN, $-NO_2$, $SF_5$; more preferred F, $CF_3$, $OCF_3$, CN, $-NO_2$.

According to one embodiment, wherein the p-type dopant of formula (I) and/or the p-type dopant of formula (II) comprises at least two 6-membered carbocyclic rings, at least two groups selected from substituted $C_6$ to $C_{12}$ aryl groups or at least two groups selected from substituted $C_3$ to $C_{12}$ heteroaryl groups.

**p-type dopant of formula (I)**

According to one embodiment, wherein the LUMO energy level of the p-type dopant of formula (I) is selected in the range of $\leq$ -4.8 and $\geq$ -6 eV, preferably $\leq$ -4.85 and $\geq$ -5.8 eV, more preferred $\leq$ -4.9 and $\geq$ -5.8 eV, even more preferred $\leq$ -5 and > 5.5 eV, calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) by applying the hybrid functional B3LYP with a Def2-TZVP basis set from the optimized geometries obtained by applying the HF3c composite method (Hartree Fock based 3C composite method with minimal basis set, gCP and D3(BJ)) in the gas phase.

Thereby, the LUMO energy of the p-type dopant of formula (I) may be in the range for suitable for organic electroluminescent devices.

According to one embodiment, wherein the energy gap $E_{gap}$ of the p-type dopant of formula (I) is selected in the range of $\geq$ 2.4 and $\leq$ 5 eV, preferably in the range of $\geq$ 2.45 and $\leq$ 4.5 eV, more preferred in the range of $\geq$ 2.5 and $\leq$ 3.5 eV, calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) by applying the hybrid functional B3LYP with a Def2-TZVP basis set from the optimized geometries obtained by applying the

HF3c composite method (Hartree Fock based 3C composite method with minimal basis set, gCP and D3(BJ)) in the gas phase.

Without being bound by theory, when the energy gap $E_{gap}$ of compounds of formula (I) is selected in this range, reduced absorption of light emitted by the light-emitting unit may be obtained. Thereby, the performance of the organic electroluminescent device may be improved.

The energy gap $E_{gap}$, measured in electron volt (eV), is determined by calculating the gap between the HOMO energy and the LUMO energy, wherein the HOMO energy and LUMO energy are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) by applying the hybrid functional B3LYP with a Def2-TZVP basis set from the optimized geometries obtained by applying the HF3c composite method (Hartree Fock based 3C composite method with minimal basis set, gCP and D3(BJ)) in the gas phase.

According to one embodiment, the p-type dopant of formula (I) comprises less than ten cyano moieties.

According to one embodiment, the p-type dopant of formula (I) comprises less than nine cyano moieties.

According to one embodiment, the p-type dopant of formula (I) comprises four to eight cyano moieties.

According to one embodiment, the p-type dopant of formula (I) comprises at least at least four cyano moieties and optionally at least one nitrogen atom.

According to one embodiment, the p-type dopant of formula (I) comprises 3 to 7 cyano moieties and 1 to 4 nitrogen atoms, preferably 3 to 7 cyano moieties and 1 to 3 nitrogen atoms, or 4 to 8 cyano moieties and optionally 1 to 4 N atoms, preferably 5 to 8 cyano moieties and optionally 1 to 4 N atoms.

For the avoidance of doubt, the nitrogen atoms are part of the heteroaryl ring. The nitrogen atoms are not part of the cyano moieties.

According to one embodiment, the p-type dopant of formula (I) comprises 2 to 8 cyano moieties, preferably 4 to 8 cyano moieties.

Thereby, the LUMO energy of the p-type dopant of formula (I) may be in the range for suitable for organic electroluminescent devices.

According to one embodiment, the p-type dopant of formula (I) comprises at least 2 fluorine atoms, at least 4 fluorine atoms, at least 6 fluorine atoms, at least 8 fluorine atoms.

According to one embodiment, the p-type dopant of formula (I) comprises 2 to 14 fluorine atoms, or 2 to 12 fluorine atoms or 4 to 10 fluorine atoms.

According to one embodiment, the p-type dopant formula (I) comprises 4 to 8 cyano moieties and 2 to 14 fluorine atoms.

Thereby, the LUMO energy of the p-type dopant of formula (I) may be in the range for suitable for organic electroluminescent devices.

According to one embodiment, the p-type dopant of formula (I) comprises ≥ 2 to ≤ 10 cyano moieties and ≥ 1 to ≤ 4 nitrogen atoms, preferably ≥ 4 to ≤ 8 cyano moieties and ≥ 1 to ≤ 4 nitrogen atoms, further preferred ≥ 3 to ≤ 7 cyano moieties and ≥ 1 to ≤ 4 nitrogen atoms, further more preferred ≥ 4 to ≤ 6 cyano moieties and ≥ 1 to ≤ 4 N atoms, also preferred ≥ 4 to ≤ 8 cyano moieties and ≥ 1 to 2 N atoms.

According to one embodiment, the p-type dopant of formula (I) comprises ≥ 2 and ≤ 10 cyano moieties, ≥ 3 and ≤ 8 cyano moieties, ≥ 4 and ≤ 8 cyano moieties or ≥ 5 and ≤ 6 cyano moieties.

According to one embodiment, the p-type dopant of formula (I) comprises ≥ 2 fluorine atoms, ≥ 4 fluorine atoms, ≥ 6 fluorine atoms, ≥ 8 fluorine atoms, ≥ 12 fluorine atoms.

According to one embodiment, the p-type dopant of formula (I) comprises ≥ 2 to ≤ 14 fluorine atoms, ≥ 2 to < 12 fluorine atoms or ≥ 4 to < 10 fluorine atoms.

According to one embodiment, the p-type dopant of formula (I) comprises ≥ 4 to ≤ 8 cyano moieties and ≥ 2 to ≤ 14 fluorine atoms.

According to one embodiment, the p-type dopant of formula (I) comprises ≥ 2 to ≤ 8 cyano moieties and ≥ 2 to ≤ 14 nitrogen atoms, and ≥ 2 to ≤ 12 fluorine atoms.

According to one embodiment, the p-type dopant of formula (I) comprises ≥ 2 to ≤ 7 cyano moieties and ≥ 1 to ≤ 3 nitrogen atoms and ≥ 4 to ≤ 14 fluorine atoms.

According to one embodiment, the p-type dopant of formula (I) comprises ≥ 3 to ≤ 8 cyano moieties and ≥ 1 to ≤ 4 nitrogen atoms and ≥ 6 to ≤ 12 fluorine atoms.

According to one embodiment, the p-type dopant of formula (I) comprises ≥ 5 to ≤ 8 cyano moieties and ≥ 2 to ≤ 4 nitrogen atoms and > 8 to ≤ 14 fluorine atoms.

According to one embodiment, the p-type dopant of formula (I) comprises ≥ 3 to ≤ 7 cyano moieties, ≥ 1 to ≤ 4 nitrogen atoms, and ≥ 4 to ≤ 14 fluorine atoms.

According to one embodiment, the p-type dopant of formula (I) comprises ≥ 3 to ≤ 7 cyano moieties, ≥ 1 to ≤ 3 nitrogen atoms, and ≥ 6 to ≤ 12 fluorine atoms.

According to one embodiment, the p-type dopant of formula (I) comprises ≥ 4 to ≤ 8 cyano moieties and ≥ 1 to ≤ 4

nitrogen atoms, and ≥ 6 to ≤ 12 fluorine atoms.

According to one embodiment, the p-type dopant of formula (I) comprises ≥ 5 to ≤ 8 cyano moieties, ≥ 1 to ≤ 4 N nitrogen atoms, and ≥ 4 to ≤ 14 fluorine atoms.

According to one embodiment, the p-type dopant of formula (I) the p-type dopant of formula (I) comprises:

- ≥ 2 to ≤ 10 cyano moieties and > 1 to <_ 4 nitrogen atoms, preferably ≥ 4 to ≤ 8 cyano moieties and ≥ 1 to ≤ 4 nitrogen atoms, further preferred > 3 to <_ 7 cyano moieties and ≥ 1 to ≤ 4 nitrogen atoms, further more preferred ≥ 4 to ≤ 6 cyano moieties and > 1 to ≤ 4 N atoms, also preferred ≥ 4 to ≤ 8 cyano moieties and ≥ 1 to 2 N atoms; or
- ≥ 2 and ≤ 8 cyano moieties, ≥ 3 and ≤ 8 cyano moieties, ≥ 4 and ≤ 8 cyano moieties or ≥ 5 and ≤ 6 cyano moieties; or
- ≥ 2 fluorine atoms, ≥ 4 fluorine atoms, ≥ 6 fluorine atoms, ≥ 8 fluorine atoms, ≥ 12 fluorine atoms; or
- ≥ 2 to ≤ 14 fluorine atoms, ≥ 2 to ≤ 12 fluorine atoms or ≥ 4 to ≤ 10 fluorine atoms;
- ≥ 4 to ≤ 8 cyano moieties and ≥ 2 to ≤ 14 fluorine atoms; or
- ≥ 2 to ≤ 8 cyano moieties and ≥ 2 to ≤ 14 nitrogen atoms, and ≥ 2 to ≤ 12 fluorine atoms; or
- ≥ 2 to ≤ 7 cyano moieties and ≥ 1 to ≤ 3 nitrogen atoms and ≥ 4 to ≤ 14 fluorine atoms;
- ≥ 3 to ≤ 8 cyano moieties and ≥ 1 to ≤ 4 nitrogen atoms and ≥ 6 to ≤ 12 fluorine atoms; or
- ≥ 5 to ≤ 8 cyano moieties and ≥ 2 to ≤ 4 nitrogen atoms and ≥ 8 to ≤ 14 fluorine atoms;

preferably the p-type dopant of formula (I) comprises:

- >_ 3 to ≤ 7 cyano moieties, ≥ 1 to ≤ 4 nitrogen atoms, and ≥ 4 to ≤ 14 fluorine atoms, or ≥ 3 to ≤ 7 cyano moieties, ≥ 1 to ≤ 3 nitrogen atoms, and ≥ 6 to ≤ 12 fluorine atoms, or ≥ 4 to ≤ 8 cyano moieties and ≥ 1 to ≤ 4 nitrogen atoms, and ≥ 6 to ≤ 12 fluorine atoms, or ≥ 5 to ≤ 8 cyano moieties, ≥ 1 to ≤ 4 N nitrogen atoms, and ≥ 4 to ≤ 14 fluorine atoms.

According to one embodiment, formula (I) comprises at least one to three of 6 member hetero aryl rings and/or at least one to three of 6-member aryl rings.

According to one embodiment, formula (I) comprises at least one 6 member hetero aryl rings and/or at least two of 6-member aryl rings.

According to one embodiment, formula (I) comprises at least two 6 member hetero aryl rings and/or at least one of 6-member aryl rings.

According to one embodiment, formula (I) comprises at least one to three of 6 member hetero aryl rings and/or at least one to three of 6-member aryl rings, wherein each of the 6 member hetero aryl rings comprises one to two N-atoms.

According to one embodiment, formula (I) comprises at least one 6 member hetero aryl rings and/or at least two of 6-member aryl rings wherein the at least one 6 member hetero aryl ring comprises one to two N-atoms.

According to one embodiment, formula (I) comprises at least two 6 member hetero aryl rings and/or at least one of 6-member aryl rings, wherein each of the 6 member hetero aryl rings comprises one to two N-atoms.

According to one embodiment, wherein the p-type dopant of formula (I) is selected from formulae C1 to C30:

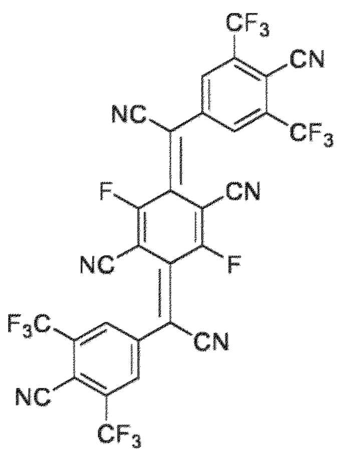
(C1),
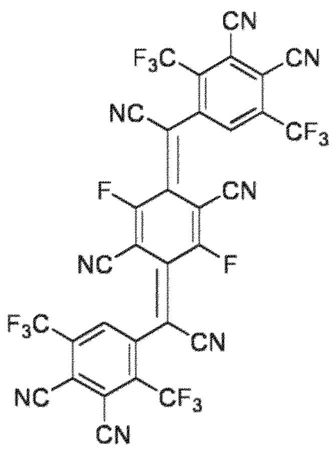
(C2),

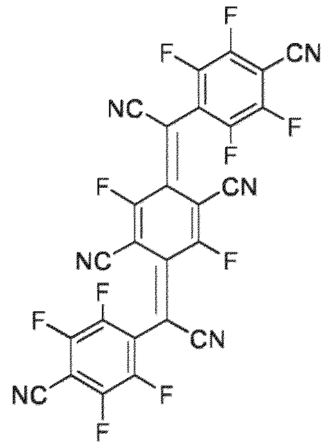 (C3), 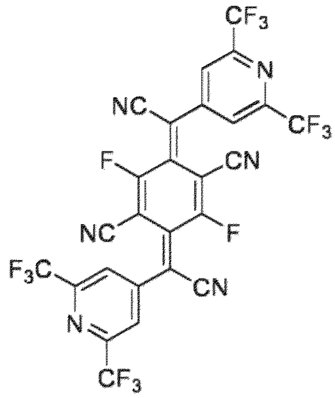 (C4),

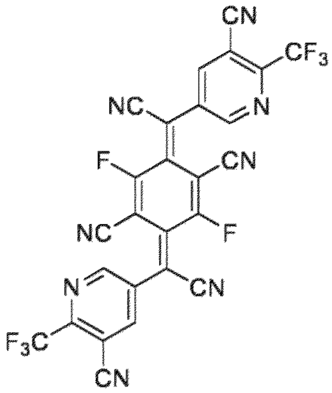 (C5), 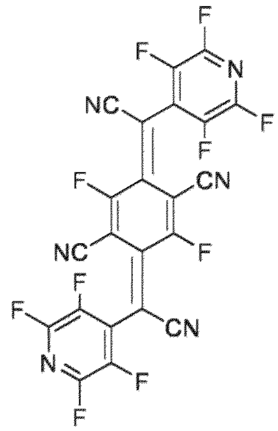 (C6),

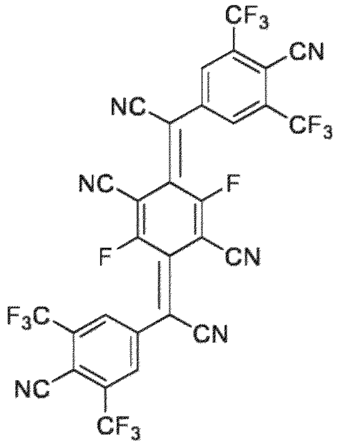 (C7), 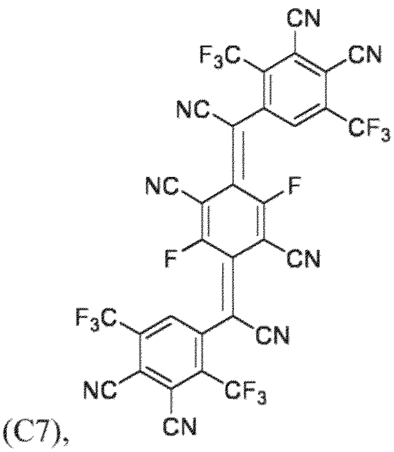 (C8),

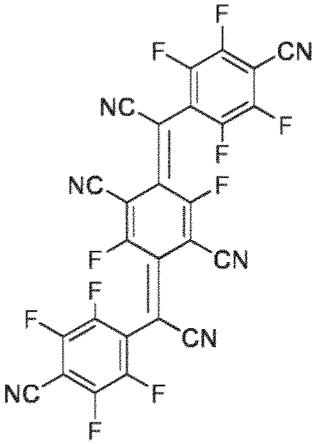 (C9), 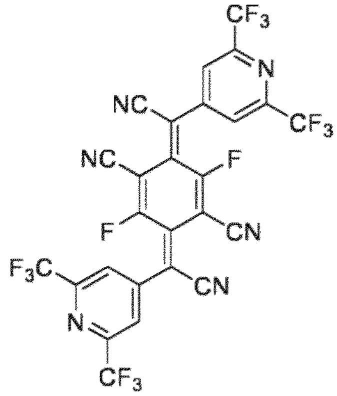 (C10),

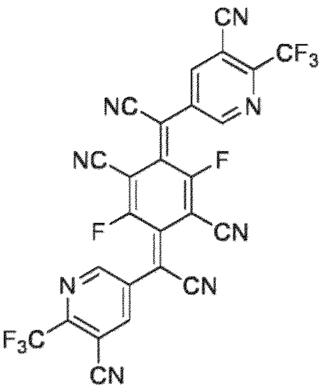 (C11), 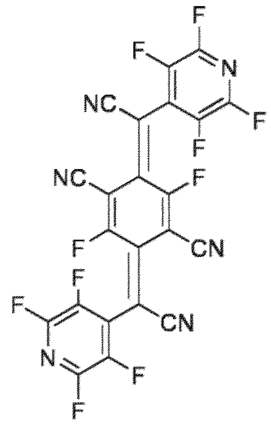 (C12),

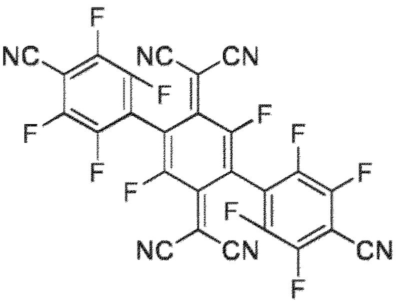 (C13), 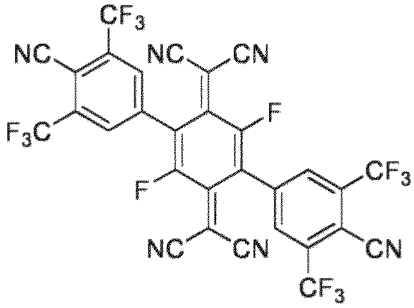 (C14),

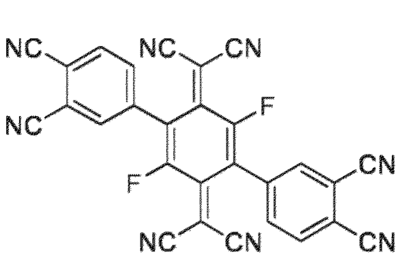 (C15), 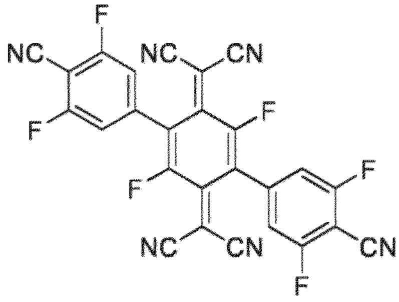 (C16),

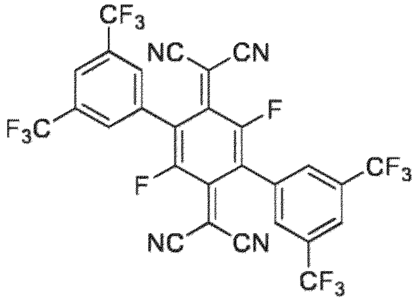 (C17), 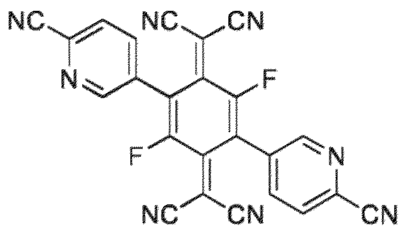 (C18),

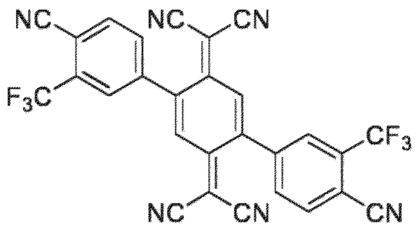 (C19), 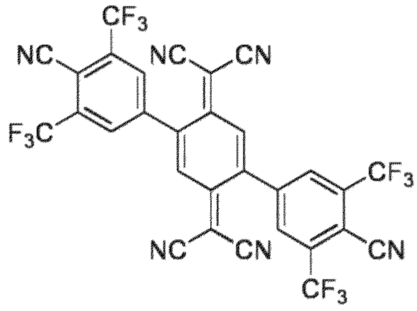 (C20),

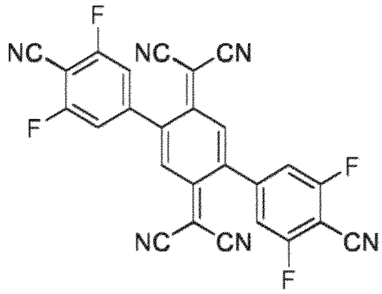 (C21), 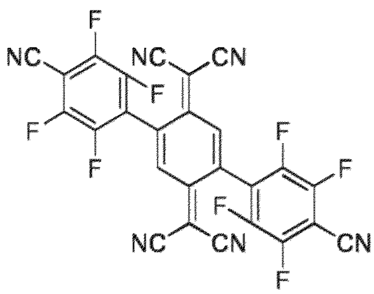 (C22),

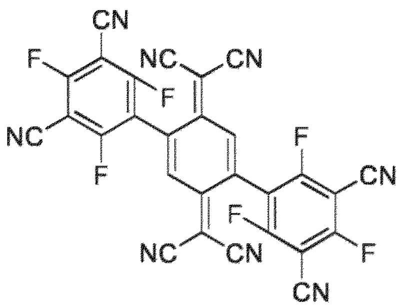 (C23), 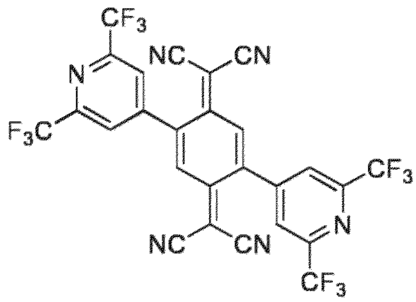 (C24),

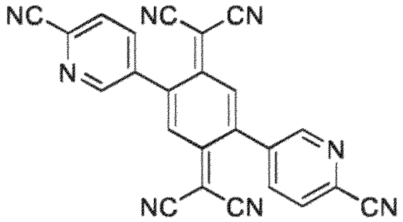 (C25),

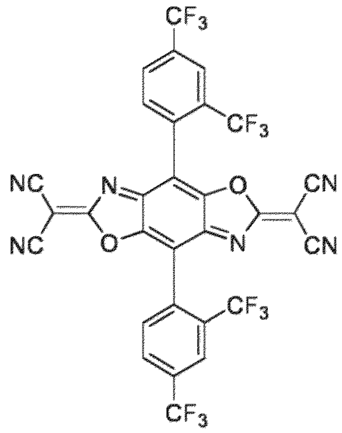 (C26),

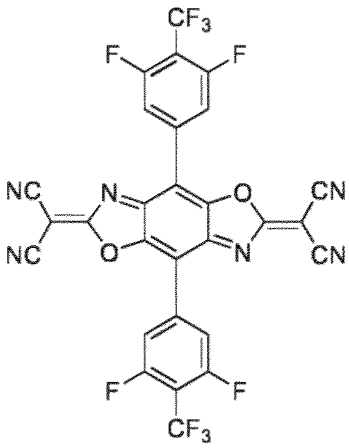 (C27),

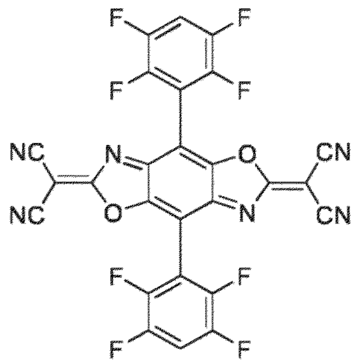 (C28),

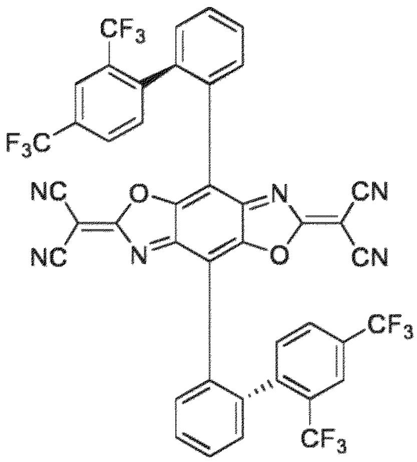 (C29),

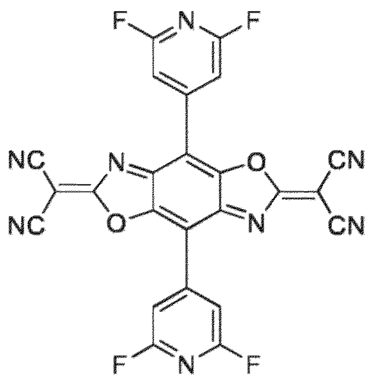 (C30).

Thereby, particularly improved properties of the organic electroluminescent device may be obtained, in particular reduced operating voltage, improved efficiency, improved lifetime and/or reduced voltage rise over time.

According to one embodiment, p-dopant of formula (I) is selected from formulae C1 to C25. Thereby, particularly improved performance of the organic electroluminescent device may be obtained, as the energy gap $E_{gap}$ of the p-dopant of formula (I) may be in the range for reduced absorption in the blue region of the emission spectrum of the light-emitting compound.

According to one embodiment, p-dopant of formula (I) is selected from formulae C1 to C12. Thereby, particularly improved performance of the organic electroluminescent device may be obtained, as the LUMO energy and energy gap $E_{gap}$ of the p-dopant of formula (I) may be in the range high doping strength and/or reduced absorption in the blue region of the emission spectrum of the light-emitting compound.

**R^k and R^L**

According to one embodiment, wherein each $R^k$ according to formula (Ia) and/or each $R^L$ according to formula (IIa) is independently selected from CN or formulae D1 to D80:

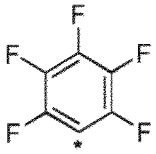 (D1), 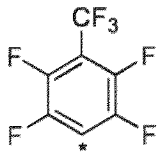 (D2), 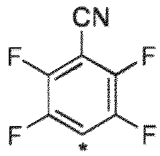 (D3), 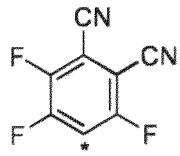 (D4),

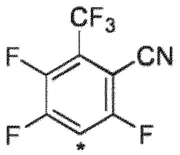 (D5), 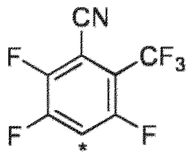 (D6), 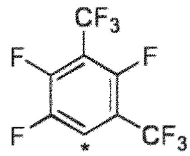 (D7), 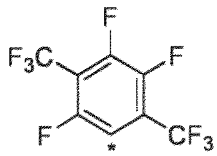 (D8),

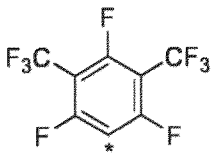 (D9), 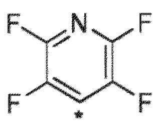 (D10), 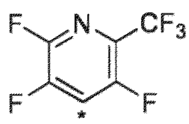 (D11), 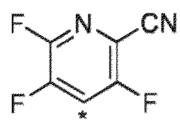 (D12),

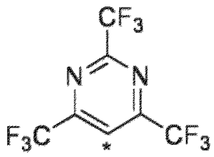 (D13), 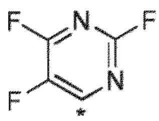 (D14), 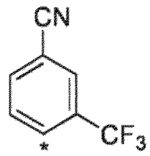 (D15), 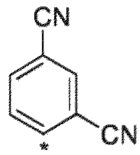 (D16),

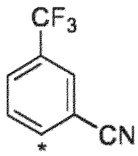 (D17), 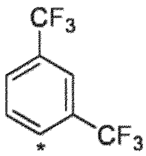 (D18), 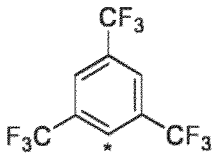 (D19), 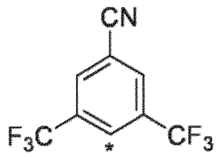 (D20),

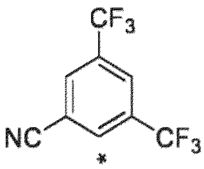 (D21), 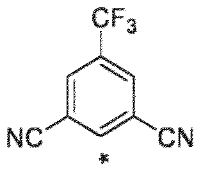 (D22), 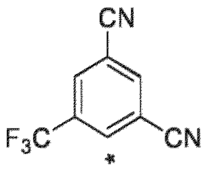 (D23), 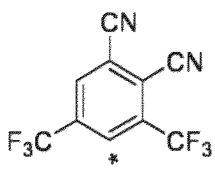 (D24),

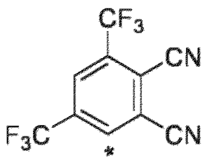 (D25), 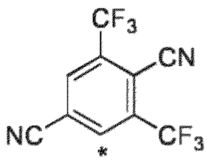 (D26), 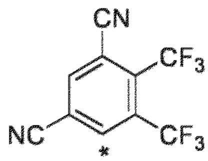 (D27), 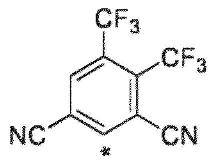 (D28),

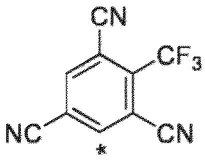 (D29), 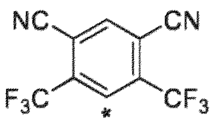 (D30), 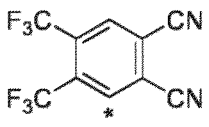 (D31),

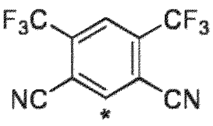 (D32), 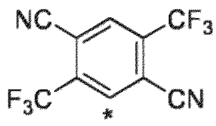 (D33), 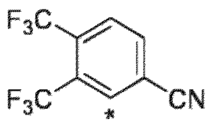 (D34),

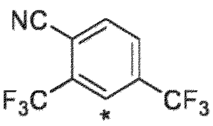 (D35), 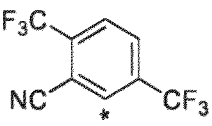 (D36), 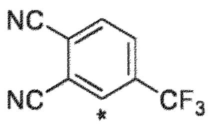 (D37),

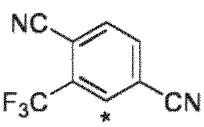 (D38), 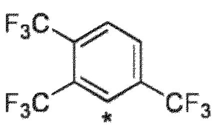 (D39), 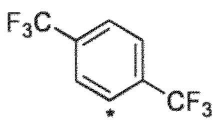 (D40),

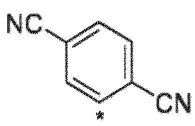 (D41), 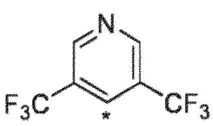 (D42), 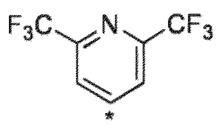 (D43), 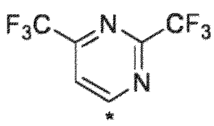 (D44),

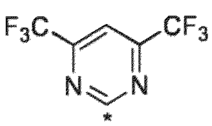 (D45), 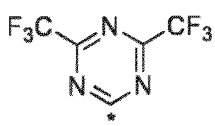 (D46), 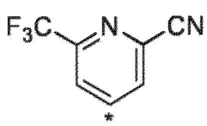 (D47), 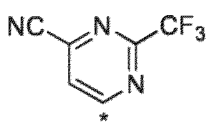 (D48),

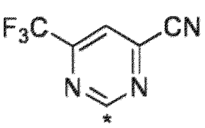 (D49), 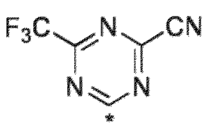 (D50), 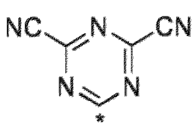 (D51), 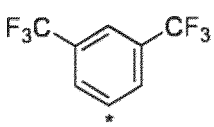 (D52),

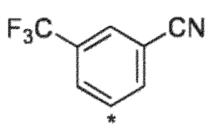 (D53), 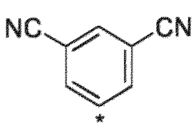 (D54), 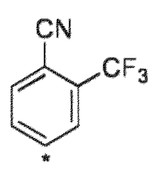 (D55), 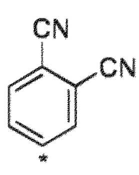 (D56),

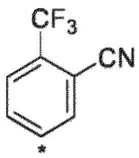 (D57), 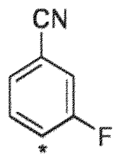 (D58), 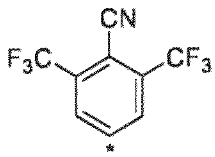 (D59), 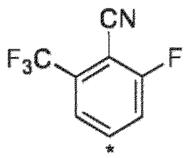 (D60),

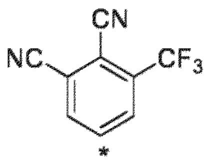 (D61), 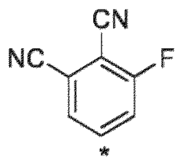 (D62), 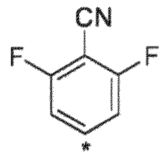 (D63), 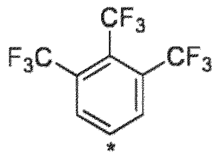 (D64),

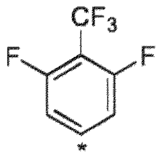 (D65), 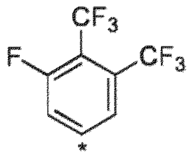 (D66), 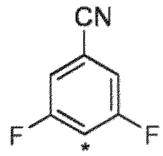 (D67), 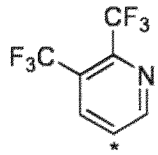 (D68),

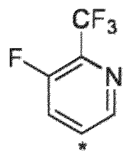 (D69), 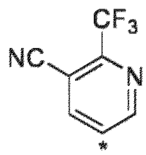 (D70), 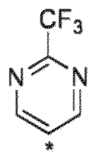 (D71), 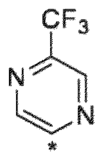 (D72), 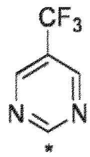 (D73),

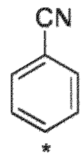 (D74), 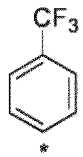 (D75), 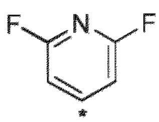 (D76), 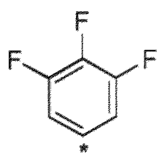 (D77), 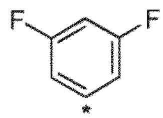 (D78),

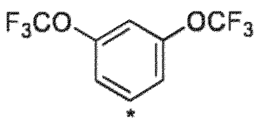 (D79), 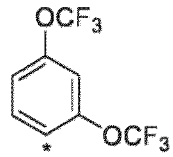 (D80),

wherein the asterisk "*" denotes the binding position.

**Formulae (Ia)**

According to one embodiment, wherein $X^1$ and $X^2$ of the p-type dopant of formula (I) are selected the same. According to one embodiment, wherein $X^1$ and $X^2$ of the p-type dopant of formula (I) are selected different. According to one embodiment, in formula (I) $X^1$ and $X^2$ are selected the same or different, preferably $X^1$ and $X^2$ are selected the same.

Thereby, particularly improved LUMO, $E_{gap}$ and/or performance of organic electroluminescent devices may be obtained, in particular reduced operating voltage, improved efficiency, improved lifetime and/or reduced voltage rise over time.

According to one embodiment, wherein $X^1$ and $X^2$ of the p-type dopant of formula (I) are selected the same; and/or $X^3$ and $X^4$ of the p-type dopant of formula (II) are selected the same; and/or $X^3$, $X^4$ and $X^5$ of the p-type dopant of formula (II) are selected the same.

According to one embodiment, the substituents on $R^k$ can be independently selected from the group consisting of an electron-withdrawing group, halogen, Cl, F, CN, partially fluorinated alkyl, and perfluorinated alkyl.

According to one embodiment, the substituents on $R^k$ can be independently selected from the group consisting of Cl, F, CN, and perfluorinated alkyl.

According to one embodiment, the substituents on $R^k$ can be independently selected from the group consisting of F, CN, and perfluorinated alkyl.

According to one embodiment, the substituents on $R^k$ can be independently selected from the group consisting of F, CN, and $CF_3$.

According to one embodiment, the substituents on $R^k$ can be independently selected from the group consisting of

CN, and $CF_3$.

According to one embodiment, the substituents on $R^k$ can be independently selected from the group consisting of CN.

According to one embodiment, the substituents on $R^k$ can be independently selected from the group consisting of $CF_3$.

According to one embodiment, on $R^k$ can be independently each comprise more than one and less than five substituents, preferably two, three or four substituents, more preferred two or three substituents.

According to one embodiment, $R^k$ may comprises two or three substituents or $R^k$ may comprises three, four or five substituents.

According to one embodiment, $R^k$ according to formula (Ia) are independently selected from substituted or unsubstituted $C_6$ to $C_{12}$ aryl and substituted or unsubstituted $C_3$ to $C_{12}$ heteroaryl.

According to one embodiment, $R^k$ in formula (I) is selected from CN.

According to one embodiment, $R^k$ in formula (I) comprises a 6-member aryl ring or heteroaryl ring.

According to one embodiment, $R^k$ according to formula (Ia) are independently selected from substituted or unsubstituted $C_6$ aryl and substituted $C_3$ to $C_5$ heteroaryl.

According to one embodiment, $R^k$ according to formula (Ia) are independently selected from substituted or unsubstituted $C_6$ to $C_{12}$ aryl and substituted or unsubstituted $C_3$ to $C_{12}$ heteroaryl, wherein the heteroaryl atom is selected from N.

According to one embodiment, $R^k$ according to formula (Ia) are independently selected from substituted or unsubstituted $C_6$ aryl and substituted $C_3$ to $C_5$ heteroaryl, wherein the heteroaryl atom is selected from N.

According to one embodiment, $R^k$ according to formula (Ia) are independently selected from substituted $C_6$ to $C_{12}$ aryl and substituted $C_3$ to $C_{12}$ heteroaryl, wherein the heteroaryl atom is selected from N, and wherein the substituents on the substituted $C_6$ to $C_{12}$ aryl and substituted $C_3$ to $C_5$ heteroaryl are selected from F, $CF_3$, $OCF_3$, CN.

According to one embodiment, $R^k$ according to formula (Ia) are independently selected from substituted $C_6$ aryl and substituted $C_3$ to $C_5$ heteroaryl, wherein the heteroaryl atom is selected from N, and wherein the substituents on the substituted $C_6$ to $C_{12}$ aryl and substituted $C_3$ to $C_5$ heteroaryl are selected from F, $CF_3$, $OCF_3$, CN.

According to one embodiment, $R^k$ according to formula (Ia) are independently selected from substituted $C_6$ to $C_{12}$ aryl and substituted $C_3$ to $C_{12}$ heteroaryl, wherein the heteroaryl atom is selected from N, and wherein the substituents on the substituted $C_6$ to $C_{12}$ aryl and substituted $C_3$ to $C_{12}$ heteroaryl are selected from F, $CF_3$, $OCF_3$, CN, and wherein the substituents on the substituted $C_6$ to $C_{12}$ aryl and substituted $C_3$ to $C_{12}$ heteroaryl comprises at least 2 to 4 substituents.

According to one embodiment, $R^k$ according to formula (Ia) are independently selected from substituted $C_6$ aryl and substituted $C_3$ to $C_5$ heteroaryl, wherein the heteroaryl atom is selected from N, and wherein the substituents on the substituted $C_6$ to $C_{12}$ aryl and substituted $C_3$ to $C_5$ heteroaryl are selected from F, $CF_3$, $OCF_3$, CN, and wherein the substituents on the substituted $C_6$ to $C_{12}$ aryl and substituted $C_3$ to $C_{12}$ heteroaryl comprises at least 2 to 4 substituents.

According to one embodiment, $R^k$ according to formula (Ia) are independently selected from substituted $C_6$ to $C_{12}$ aryl and substituted $C_3$ to $C_{12}$ heteroaryl, wherein the heteroaryl atom is selected from N, and wherein the substituents on the substituted $C_6$ to $C_{12}$ aryl and substituted $C_3$ to $C_{12}$ heteroaryl are selected from F, $CF_3$, $OCF_3$, CN, and wherein the substituents on the substituted $C_6$ to $C_{12}$ aryl and substituted $C_3$ to $C_{12}$ heteroaryl comprises at least 2 to 4 substituents, and wherein the heteroaryl comprises 1 to 3 N-ring atoms.

According to one embodiment, $R^k$ according to formula (Ia) are independently selected from substituted $C_6$ aryl and substituted $C_3$ to $C_5$ heteroaryl, wherein the heteroaryl atom is selected from N, and wherein the substituents on the substituted $C_6$ to $C_{12}$ aryl and substituted $C_3$ to $C_5$ heteroaryl are selected from F, $CF_3$, $OCF_3$, CN, and wherein the substituents on the substituted $C_6$ to $C_{12}$ aryl and substituted $C_3$ to $C_{12}$ heteroaryl comprises at least 2 to 4 substituents, and wherein the heteroaryl comprises 1 to 3 N-ring atoms.

According to one embodiment, $X^1$ and $X^2$ of Formula (I) are independently selected from formula (Ia):

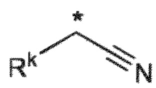 (Ia), wherein

the asterisk "*" denotes the binding position;

$R^k$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl, wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$

alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to one embodiment, wherein each $R^k$ according to formula (Ia) is independently selected from CN or substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted $C_1$ to $C_4$ alkyl, partially fluorinated $C_1$ to $C_4$ alkyl, perfluorinated $C_1$ to $C_4$ alkyl, substituted or unsubstituted $C_1$ to $C_4$ alkoxy, partially fluorinated $C_1$ to $C_4$ alkoxy, perfluorinated $C_1$ to $C_4$ alkoxy, preferably F, CN, $CF_3$.

According to one embodiment, wherein each $R^k$ according to formula (Ia) is independently selected from CN or formulae D1 to D80. According to one preferred embodiment, wherein each $R^k$ according to formula (Ia) is independently selected from CN or D1 to D78. According to one further preferred embodiment, wherein each $R^k$ according to formula (Ia) is independently selected from CN or D1 to D67. According to one more preferred embodiment, wherein each $R^k$ according to formula (Ia) is independently selected from CN or D1 to D48, and furthermore preferred independently selected from CN or formulae D1 to D45 and D47 to D66.

According to one embodiment, in formulae (Ia) $R^k$ is selected from the following groups D3, D4, D11, D19, D13, D20, D32, D61 or D62:

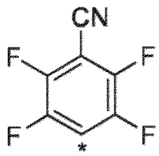 (D3), 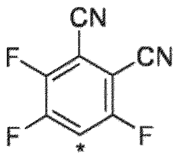 (D4), 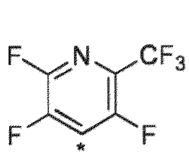 (D11), 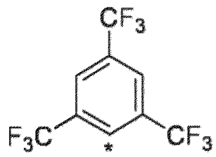 (D19),

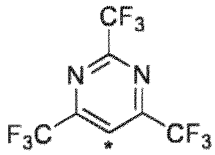 (D13), 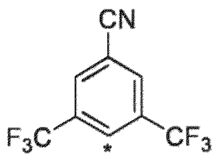 (D20), 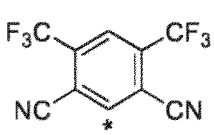 (D32), 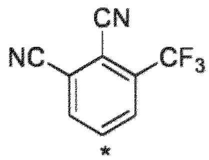 (D61),

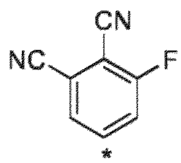 (D62);

wherein the asterisk "*" denotes the binding position.

**A of formula (I)**

According to one embodiment of formula (I), wherein

- A is B1 and each $R^k$ in formula (Ia) is selected from CN or formulae D1 to D80;
- A is B2 and each $R^k$ in formula (Ia)is selected from CN.

According to one embodiment of formula (I), wherein A of formula (I) is selected from formulae (B1) and/or (B2):

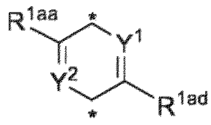 (B1), 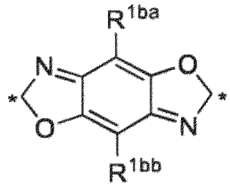 (B2),

wherein each $X^1$ and $X^2$ are conjugated via a double-bond to A;
wherein $X^1$ and $X^2$ are independently selected from formula (Ia); and
wherein in formula (Ia) each $R^k$ is independently selected from CN or formulae D1 to D80.

According to one embodiment, wherein in formula (I) A is selected from formula (B1)

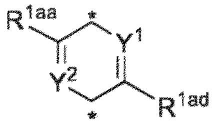 (B1),

wherein each $X^1$ and $X^2$ are conjugated via a double-bond to A;

- $X^1$ and $X^2$ are independently selected from formula (Ia), wherein in formula (Ia) each $R^k$ is independently selected from CN or formulae D1 to D80.

According to one embodiment, wherein in formula (I) A is selected from formula (B2):

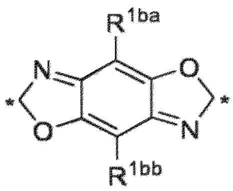 (B2),

wherein each $X^1$ and $X^2$ are conjugated via a double-bond to A;

- $X^1$ and $X^2$ are independently selected from formula (Ia), and in formula (Ia) each $R^k$ is independently selected from CN.

**Formulae B1 and B2**

According to one embodiment, wherein in formulae (B1) and/or (B2):

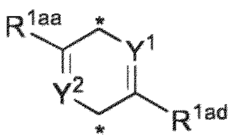 (B1), 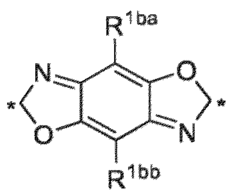 (B2),

- $R^{1aa}$, $R^{1ad}$, $R^{1ba}$ and $R^{1bb}$ are independently selected from formulae E1 to E73:

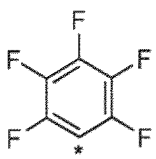 (E1), 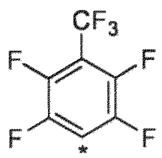 (E2), 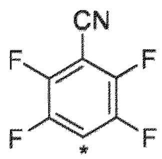 (E3), 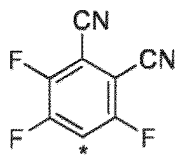 (E4), 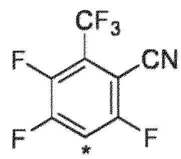 (E5),

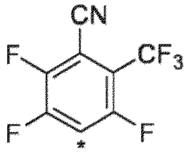 (E6), 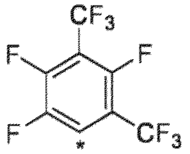 (E7), 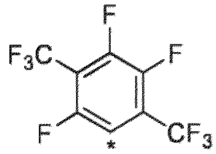 (E8), 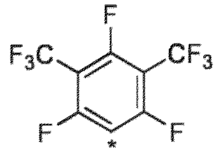 (E9),

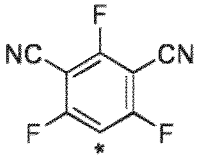 (E10), 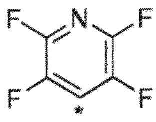 (E11), 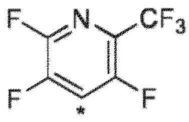 (E12), 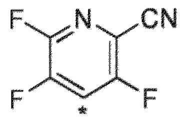 (E13),

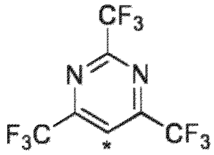 (E14), 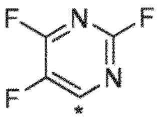 (E15), 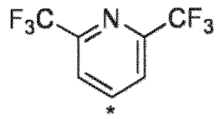 (E16), 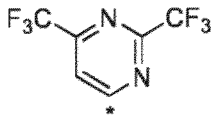 (E17),

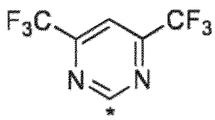 (E18), 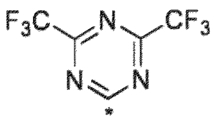 (E19), 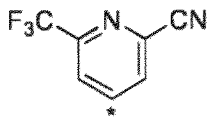 (E20), 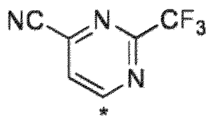 (E21),

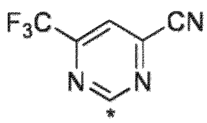 (E22), 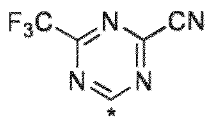 (E23), 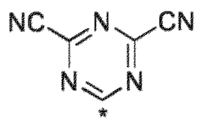 (E24), 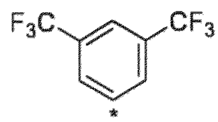 (E25),

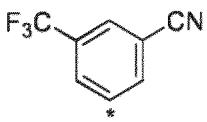 (E26), 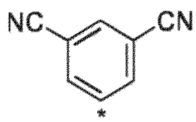 (E27), 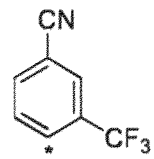 (E28), 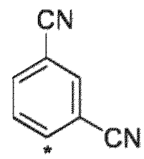 (E29),

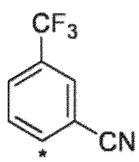 (E30), 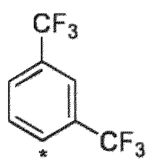 (E31), 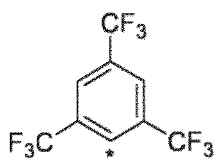 (E32), 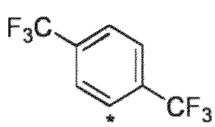 (E33),

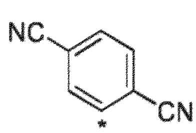 (E34), 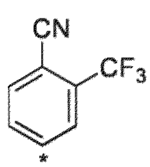 (E35), 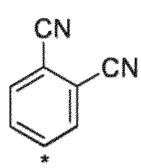 (E36), 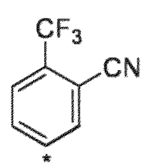 (E37),

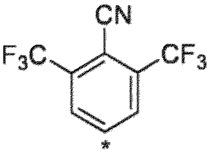 (E38), 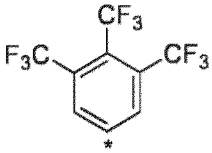 (E39), 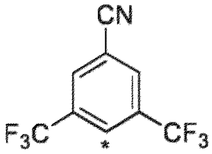 (E40), 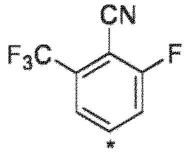 (E41),

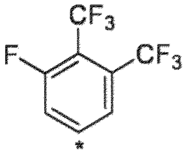 (E42), 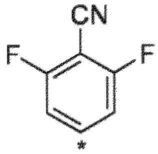 (E43), 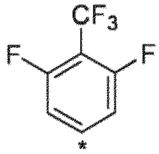 (E44), 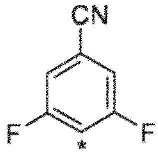 (E45),

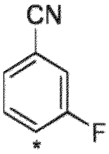 (E46), 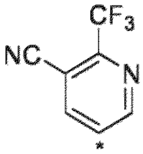 (E47), 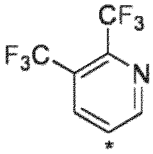 (E48), 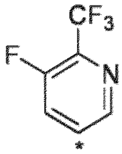 (E49), 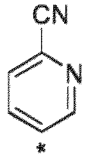 (E50),

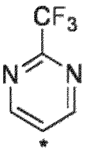 (E51), 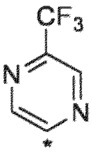 (E52), 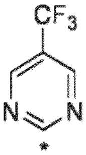 (E53), 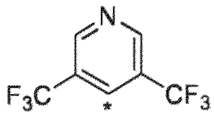 (E54), 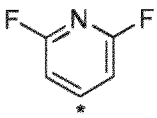 (E55),

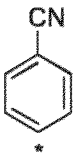 (E56), 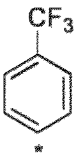 (E57), 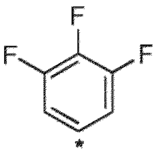 (E58), 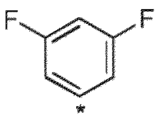 (E59), 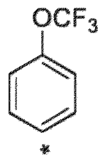 (E60),

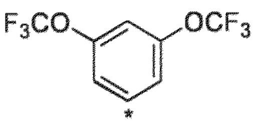 (E61), 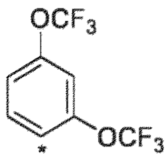 (E62), 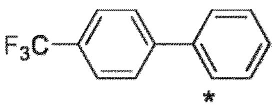 (E63),

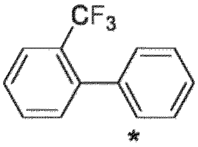 (E64), 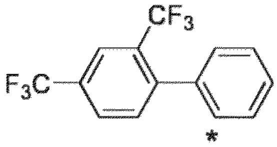 (E65), 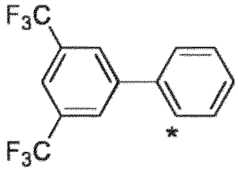 (E66),

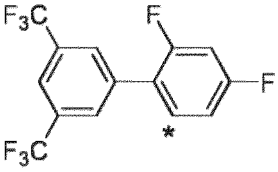 (E67), 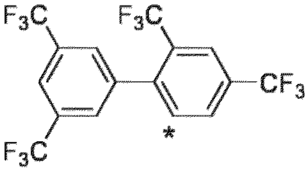 (E68), 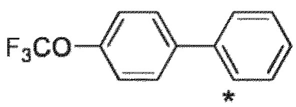 (E69),

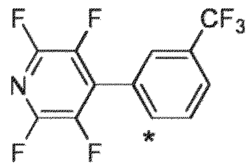 (E70), 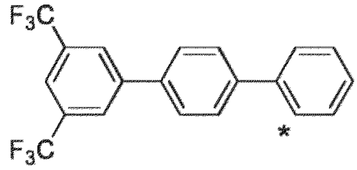 (E71),

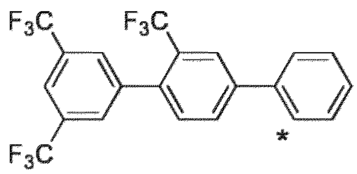 (E72), 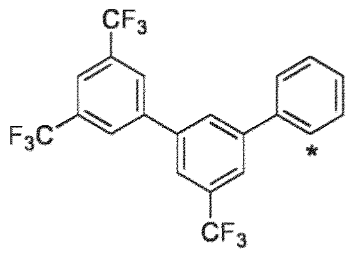 (E73);

wherein the asterix "*" denotes the binding position;

- in formula (Ia) $R^k$ is selected from CN or formulae D1 to D80, preferably $R^k$ is CN; preferably $R^{1aa}$, $R^{1ad}$, $R^{1ba}$ and $R^{1bb}$ are selected the same;
- $Y^1$ is selected from $CR^{1ab}$;
- $Y^2$ is selected from $CR^{1ac}$; and wherein $R^{1ab}$ and $R^{1ac}$ are independently selected from H, D, an electron-withdrawing group, halogen, Cl, F, CN; preferably $R^{1ab}$ and $R^{1ac}$ are selected from H, D, F or CN.

According to one embodiment of formula (I), wherein in formula (I) A is selected from formulae (B1):

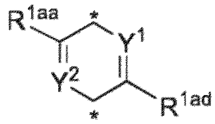 (B1),

- $Y^1$ is selected from $CR^{1ab}$;
- $Y^2$ is selected from $CR^{1ac}$;
- $R^{1aa}$, $R^{1ab}$, $R^{1ac}$, $R^{1ad}$ are independently selected from H, D, an electron-withdrawing group, halogen, Cl, F, CN; preferably $R^{1aa}$, $R^{1ab}$, $R^{1ac}$, $R^{1ad}$ are selected from H, D, F or CN, most preferred $R^{1aa}$, $R^{1ab}$, $R^{1ac}$, $R^{1ad}$ are selected form F or CN, also preferred two of $R^{1aa}$, $R^{1ab}$, $R^{1ac}$, - $R^{1ad}$ are selected from F and two $R^{1aa}$, $R^{1ab}$, $R^{1ac}$, $R^{1ad}$ are selected from CN; and

  - in formula (Ia) each $R^k$ is selected from formulae D1 to D80.

According to one embodiment of formula (I):

- $R^k$ according to formula (Ia) is selected from formulae D1 to D80, preferably two or three $R^k$ are selected the same;
- $R^{1aa}$, $R^{1ad}$, $R^{1ab}$ and $R^{1ac}$ are independently selected from H, D, an electron-withdrawing group, halogen, Cl, F, CN, preferably H, D, F or CN;
- $R^{1ba}$ and $R^{1bb}$ are independently selected from formulae E1 to E73, preferably E1 to E59.

According to one embodiment of formula (I):

- $R^k$ according to formula (Ia) is selected from CN;
- $R^{1aa}$ and $R^{1ad}$ are independently selected from formulae E1 to E73, and $R^{1ab}$ and $R^{1ac}$ are independently selected from H, D, an electron-withdrawing group, halogen, Cl, F, CN, preferably H, D, F or CN;
- $R^{1ba}$ and $R^{1bb}$ are independently selected from formulae E1 to E73, preferably E1 to E59.

According to one embodiment of formula (I):

- each $R^k$ according to formula (Ia) is independently selected from formulae D1 to D80, preferably D1 to D78; and
- A is selected from group B1.

According to one embodiment of formula (I):

- each $R^k$ according to formula (Ia) is independently selected from CN or formulae D1 to D80, preferably each $R^k$ is selected the same;
- A is selected from group B1 or B2; and
- $R^{1aa}$ and $R^{1ad}$ are selected from formulae E1 to E73, preferably E1 to E59, $R^{1ab}$ and $R^{1ac}$ are selected from H, D, an electron-withdrawing group, halogen, Cl, F, CN.

According to one embodiment of formula (I):

- each $R^k$ according to formula (Ia) is independently selected from CN or formulae D1 to D80, preferably each $R^k$ is selected the same;
- A is selected from group B1; and
- $R^{1aa}$ and $R^{1ad}$ are selected from formulae E1 to E73, preferably E1 to E59 $R^{1ab}$ and $R^{1ac}$ are selected from H, D, an electron-withdrawing group, halogen, Cl, F, CN.

According to one embodiment of formula (I):

- $R^k$ according to formula (Ia) is selected from formulae D1 to D80, preferably two or three $R^k$ are selected the same;
- $R^{1aa}$, $R^{1ad}$, $R^{1ab}$ and $R^{1ac}$ are independently selected from H, D, an electron-withdrawing group, halogen, Cl, F, CN, preferably H, D, F or CN;
- $R^{1ba}$ and $R^{1bb}$ are independently selected from formulae E1 to E73, preferably E1 to E59;

or

- $R^k$ according to formula (Ia) is selected from CN;
- $R^{1aa}$ and $R^{1ad}$ are independently selected from formulae E1 to E73, and $R^{1ab}$ and $R^{1ac}$ are independently selected from H, D, an electron-withdrawing group, halogen, Cl, F, CN, preferably H, D, F or CN;
- $R^{1ba}$ and $R^{1bb}$ are independently selected from formulae E1 to E73, preferably E1 to E59;

or

- each $R^k$ according to formula (Ia) is independently selected from formulae D1 to D80, preferably D1 to D78; and
- A is selected from group B1;

or

- each $R^k$ according to formula (Ia) is independently selected from CN or formulae D1 to D80, preferably each $R^k$ is selected the same;
- A is selected from group B1 or B2; and
- $R^{1aa}$ and $R^{1aa}$ are selected from formulae E1 to E73, preferably E1 to E59, $R^{1ab}$ and $R^{1ac}$ are selected from H, D, an electron-withdrawing group, halogen, Cl, F, CN;

or

- each $R^k$ according to formula (Ia) is independently selected from CN or formulae D1 to D80, preferably each $R^k$ is selected the same;
- A is selected from group B1; and
- $R^{1aa}$ and $R^{1ad}$ are selected from formulae E1 to E73, preferably E1 to E59, $R^{1ab}$ and $R^{1ac}$ are selected from H, D, an electron-withdrawing group, halogen, Cl, F, CN.

According to one embodiment, wherein in formulae B1 and B2:

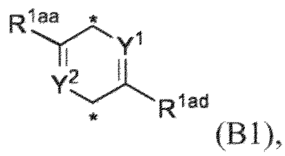 (B1), 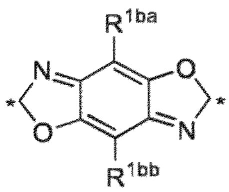 (B2),

wherein $R^{1aa}$, $R^{1ab}$, $R^{1ac}$, $R^{1ad}$, $R^{1ba}$, and $R^{1bb}$ are independently selected from H, D, an electron-withdrawing group, halogen, Cl, F, CN, a substituted $C_6$ to $C_{30}$ aryl, or a substituted $C_3$ to $C_{30}$ heteroaryl,

wherein the one or more substituents are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN; wherein the one or more substituents of the substituted $C_1$ to $C_8$ alkyl, substituted $C_1$ to $C_8$ alkoxy are independently selected from D, an electron-withdrawing group, halogen, Cl, F, CN, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to one embodiment, wherein in formula (I) A is the group B1, wherein

$R^{1aa}$, $R^{1ad}$, $R^{1ac}$, $R^{1ad}$, are independently selected from H, D, an electron-withdrawing group, halogen, Cl, F, CN or substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted $C_1$ to $C_4$ alkyl, partially fluorinated $C_1$ to $C_4$ alkyl, perfluorinated $C_1$ to $C_4$ alkyl, substituted or unsubstituted $C_1$ to $C_4$ alkoxy, partially fluorinated $C_1$ to $C_4$ alkoxy, perfluorinated $C_1$ to $C_4$ alkoxy, preferably F, CN, $CF_3$;
preferably
$R^{1aa}$ and $R^{1ad}$ are independently selected from H, D, an electron-withdrawing group, halogen, Cl, F, CN or substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted $C_1$ to $C_4$ alkyl, partially fluorinated $C_1$ to $C_4$ alkyl, perfluorinated $C_1$ to $C_4$ alkyl, substituted or unsubstituted $C_1$ to $C_4$ alkoxy, partially fluorinated $C_1$ to $C_4$ alkoxy, perfluorinated $C_1$ to $C_4$ alkoxy, preferably F, CN, $CF_3$; and
$R^{1ab}$ and $R^{1ac}$ are independently selected from H, D, an electron-withdrawing group, halogen, Cl, F, CN; and/or
$R^{1ba}$ and $R^{1bb}$ are independently selected from a substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted $C_1$ to $C_4$ alkyl, partially fluorinated $C_1$ to $C_4$ alkyl, perfluorinated $C_1$ to $C_4$ alkyl, substituted or unsubstituted $C_1$ to $C_4$ alkoxy, partially fluorinated $C_1$ to $C_4$ alkoxy, perfluorinated $C_1$ to $C_4$ alkoxy, preferably F, CN, $CF_3$.

According to one embodiment, wherein in formula (B1):
$R^{1ab}$ and $R^{1ac}$ are independently selected from H, D, an electron-withdrawing group, halogen, Cl, F, CN; preferably $R^{1ab}$ and $R^{1ac}$ are selected from H, D, F or CN.

**p-type dopant of formula (II)**

According to one embodiment, $X^3$, $X^4$ and $X^5$ are selected the same.

According to one embodiment, $X^3$ and $X^4$ of the p-type dopant of formula (II) are selected the same; and/or $X^3$, $X^4$ and $X^5$ of the p-type dopant of formula (II) are selected the same.

According to one embodiment, wherein the LUMO energy level of the p-type dopant of formula (II) is selected in the range of ≤ -4.75 and ≥ -5.6 eV, preferably ≤ -4.8 and ≥ -5.5 eV, more preferred ≤ -4.9 and > -5.4 eV, calculated with the program package TURBOMOLE V6.5 (TURBOMOLE GmbH, Litzenhardtstrasse 19, 76135 Karlsruhe, Germany) and WEASEL 1.9.2 (FAccTs GmbH, Rolandstrasse 67, 50677 Köln, Germany) by applying the hybrid functional B3LYP with a Def2-TZVP basis set from the optimized geometries obtained by applying the HF3c composite method (Hartree Fock based 3C composite method with minimal basis set, gCP and D3(BJ)) in the gas phase.

Thereby, the LUMO energy of the p-type dopant of formula (II) may be in the range for suitable for organic electroluminescent devices.

According to one embodiment, wherein the energy gap $E_{gap}$ of the p-type dopant of formula (II) is selected in the range of ≥ 2.3 and ≤ 5 eV, preferably in the range of ≥ 2.35 and ≤ 4 eV, more preferred in the range of ≥ 2.4 and < 3.5 eV, calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) by applying the hybrid functional B3LYP with a Def2-TZVP basis set from the optimized geometries obtained by applying the HF3c composite method (Hartree Fock based 3C composite method with minimal basis set, gCP and D3(BJ)) in the gas phase.

Without being bound by theory, when the energy gap $E_{gap}$ of p-type dopants of formula (II) is selected in this range, less absorption of light emitted by the light-emitting unit may be obtained. Thereby, the performance of the organic electroluminescent device may be improved.

According to one embodiment, wherein the p-type dopant of formula (II) comprises at least two groups selected from substituted $C_6$ to $C_{30}$ aryl groups or substituted $C_3$ to $C_{30}$ heteroaryl groups, wherein the one or more substituents are independently selected from D, an electron-withdrawing group, halogen, Cl, F, substituted or unsubstituted $C_1$ to $C_8$ alkyl,

partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$; preferably F, $CF_3$, $OCF_3$, CN, isocyano, SCN, OCN, $-NO_2$, $SF_5$; more preferred F, $CF_3$, $OCF_3$, CN, $-NO_2$.

According to one embodiment, the p-type dopant of formula (II) comprises ≥ 2 to ≤ 10 cyano moieties and ≥ 1 to ≤ 4 nitrogen atoms or ≥ 2 to ≤ 9 cyano moieties and ≥ 1 to ≤ 4 nitrogen atoms, preferably ≥ 4 to ≤ 8 cyano moieties and ≥ 1 to ≤ 4 nitrogen atoms, further preferred ≥ 3 to ≤ 7 cyano moieties and ≥ 1 to ≤ 4 nitrogen atoms, further more preferred ≥ 4 to ≤ 6 cyano moieties and ≥ 1 to ≤ 4 N atoms, also preferred ≥ 4 to ≤ 8 cyano moieties and ≥ 1 to 2 N atoms.

According to one embodiment, the p-type dopant of formula (II) comprises ≥ 2 to ≤ 9 cyano moieties and ≥ 1 to ≤ 4 nitrogen atoms, preferably ≥ 4 to ≤ 8 cyano moieties and ≥ 1 to ≤ 4 nitrogen atoms, further preferred ≥ 3 to ≤ 7 cyano moieties and ≥ 1 to ≤ 4 nitrogen atoms, further more preferred ≥ 4 to ≤ 6 cyano moieties and ≥ 1 to ≤ 4 N atoms, also preferred ≥ 4 to ≤ 8 cyano moieties and ≥ 1 to 2 N atoms.

According to one embodiment, the p-type dopant of formula (II) comprises ≥ 2 and ≤ 9 cyano moieties, ≥ 3 and ≤ 8 cyano moieties, ≥ 4 and ≤ 7 cyano moieties or ≥ 5 and ≤ 6 cyano moieties.

According to one embodiment, the p-type dopant of formula (II) comprises ≥ 2 fluorine atoms, ≥ 4 fluorine atoms, ≥ 6 fluorine atoms, ≥ 8 fluorine atoms, ≥ 12 fluorine atoms.

According to one embodiment, the p-type dopant of formula (II) comprises ≥ 2 to ≤ 14 fluorine atoms, ≥ 2 to < 12 fluorine atoms or ≥ 4 to ≤ 10 fluorine atoms.

According to one embodiment, the p-type dopant of formula (II) comprises ≥ 4 to ≤ 9 cyano moieties and ≥ 2 to ≤ 14 fluorine atoms.

According to one embodiment, the p-type dopant of formula (II) comprises ≥ 2 to ≤ 9 cyano moieties and ≥ 2 to ≤ 14 nitrogen atoms, and ≥ 2 to < 12 fluorine atoms.

According to one embodiment, the p-type dopant of formula (II) comprises ≥ 2 to ≤ 7 cyano moieties and ≥ 1 to ≤ 3 nitrogen atoms and ≥ 4 to ≤ 14 fluorine atoms.

According to one embodiment, the p-type dopant of formula (II) comprises ≥ 3 to ≤ 8 cyano moieties and ≥ 1 to ≤ 4 nitrogen atoms and ≥ 6 to ≤ 12 fluorine atoms.

According to one embodiment, the p-type dopant of formula (II) comprises ≥ 5 to ≤ 8 cyano moieties and ≥ 2 to ≤ 4 nitrogen atoms and ≥ 8 to ≤ 14 fluorine atoms.

According to one embodiment, the p-type dopant of formula (II) comprises ≥ 3 to ≤ 7 cyano moieties, ≥ 1 to ≤ 4 nitrogen atoms, and ≥ 4 to ≤ 14 fluorine atoms.

According to one embodiment, the p-type dopant of formula (II) comprises ≥ 3 to ≤ 7 cyano moieties, ≥ 1 to ≤ 3 nitrogen atoms, and ≥ 6 to ≤ 12 fluorine atoms.

According to one embodiment, the p-type dopant of formula (II) comprises ≥ 4 to ≤ 8 cyano moieties and ≥ 1 to < 4 nitrogen atoms, and ≥ 6 to ≤ 12 fluorine atoms.

According to one embodiment, the p-type dopant of formula (II) comprises ≥ 5 to ≤ 8 cyano moieties, ≥ 1 to ≤ 4 N nitrogen atoms, and ≥ 4 to ≤ 14 fluorine atoms.

According to one embodiment, the p-type dopant of formula (II) the p-type dopant of formula (II) comprises:

- ≥ 2 to ≤ 8 cyano moieties and ≥ 1 to ≤ 4 nitrogen atoms, preferably ≥ 4 to ≤ 8 cyano moieties and ≥ 1 to ≤ 4 nitrogen atoms, further preferred ≥ 3 to ≤ 7 cyano moieties and > 1 to ≤ 4 nitrogen atoms, further more preferred ≥ 4 to ≤ 6 cyano moieties and ≥ 1 to ≤ 4 N atoms, also preferred ≥ 4 to <_ 8 cyano moieties and ≥ 1 to 2 N atoms; or
- ≥ 2 and ≤ 8 cyano moieties, ≥ 3 and ≤ 8 cyano moieties, ≥ 4 and ≤ 8 cyano moieties or ≥ 5 and ≤ 6 cyano moieties; or
- ≥ 2 fluorine atoms, ≥ 4 fluorine atoms, ≥ 6 fluorine atoms, ≥ 8 fluorine atoms, ≥ 12 fluorine atoms; or
- ≥ 2 to ≤ 14 fluorine atoms, ≥ 2 to ≤ 12 fluorine atoms or ≥ 4 to ≤ 10 fluorine atoms;
- ≥ 4 to ≤ 8 cyano moieties and ≥ 2 to ≤ 14 fluorine atoms; or
- ≥ 2 to ≤ 8 cyano moieties and ≥ 2 to ≤ 14 nitrogen atoms, and ≥ 2 to ≤ 12 fluorine atoms; or
- ≥ 2 to ≤ 7 cyano moieties and ≥ 1 to ≤ 3 nitrogen atoms and ≥ 4 to ≤ 14 fluorine atoms;
- ≥ 3 to ≤ 8 cyano moieties and ≥ 1 to ≤ 4 nitrogen atoms and ≥ 6 to ≤ 12 fluorine atoms; or
- ≥ 5 to ≤ 8 cyano moieties and ≥ 2 to ≤ 4 nitrogen atoms and ≥ 8 to ≤ 14 fluorine atoms; preferably the p-type dopant of formula (II) comprises:
- ≥ 3 to ≤ 7 cyano moieties, ≥ 1 to ≤ 4 nitrogen atoms, and ≥ 4 to ≤ 14 fluorine atoms, or ≥ 3 to ≤ 7 cyano moieties, ≥ 1 to ≤ 3 nitrogen atoms, and ≥ 6 to ≤ 12 fluorine atoms, or ≥ 4 to < 8 cyano moieties and ≥ 1 to ≤ 4 nitrogen atoms, and ≥ 6 to ≤ 12 fluorine atoms, or ≥ 5 to ≤ 8 cyano moieties, ≥ 1 to ≤ 4 N nitrogen atoms, and > 4 to <_ 14 fluorine atoms.

According to one embodiment, formula (II) comprises at least one to three of 6 member hetero aryl rings and/or at least one to three of 6-member aryl rings.

According to one embodiment, formula (II) comprises at least one 6 member hetero aryl rings and/or at least two of 6-member aryl rings.

According to one embodiment, formula (II) comprises at least two 6 member hetero aryl rings and/or at least one

of 6-member aryl rings.

According to one embodiment, formula (II) comprises at least one to three of 6 member hetero aryl rings and/or at least one to three of 6-member aryl rings, wherein each of the 6 member hetero aryl rings comprises one to two N-atoms.

According to one embodiment, formula (II) comprises at least one 6 member hetero aryl rings and/or at least two of 6-member aryl rings wherein the at least one 6 member hetero aryl ring comprises one to two N-atoms.

According to one embodiment, formula (II) comprises at least two 6 member hetero aryl rings and/or at least one of 6-member aryl rings, wherein each of the 6 member hetero aryl rings comprises one to two N-atoms.

According to one embodiment, wherein the p-type dopant of formula (II) is selected from formulae F1 to F60:

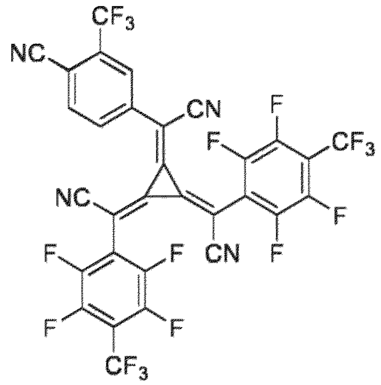
(F1),

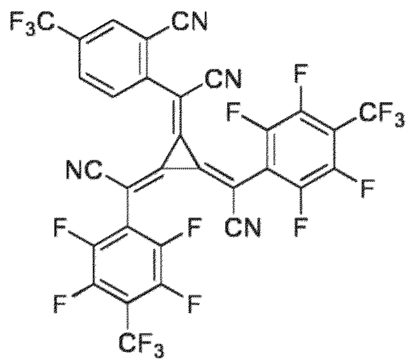
(F2),

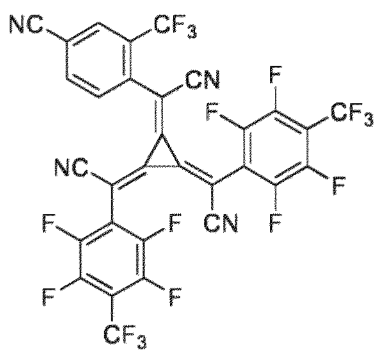
(F3),

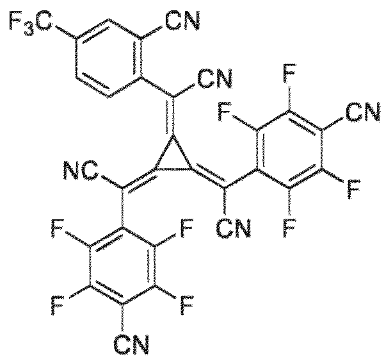
(F4),

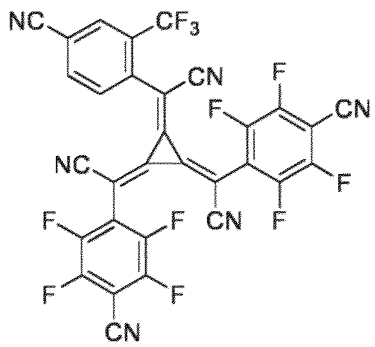
(F5),

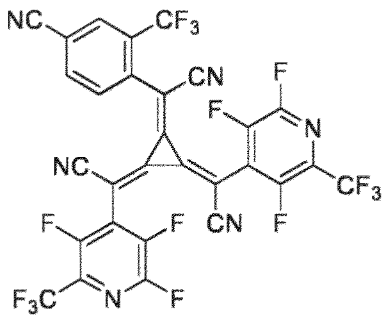
(F6),

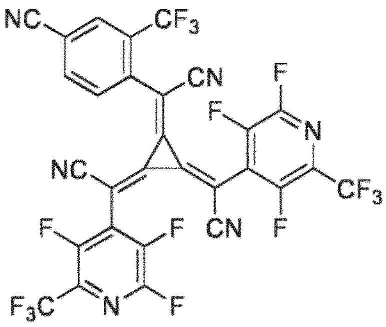 (F7), 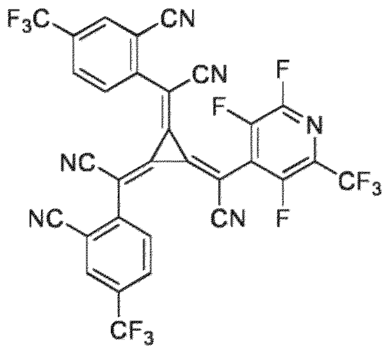 (F8),

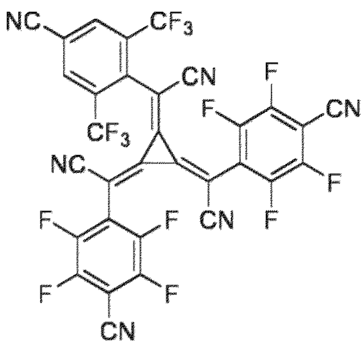 (F9), 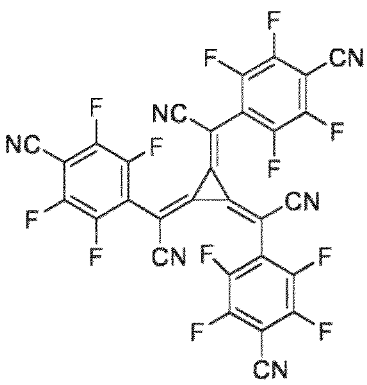 (F10),

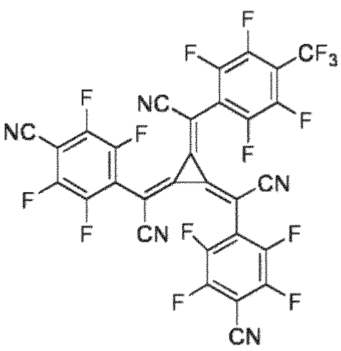 (F11), 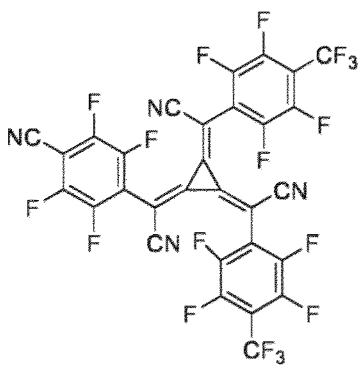 (F12),

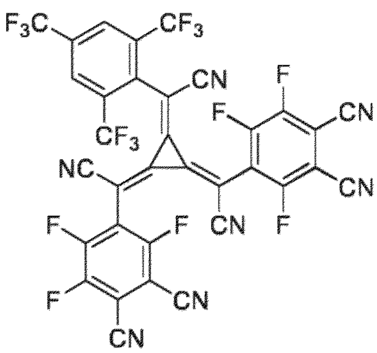 (F13), 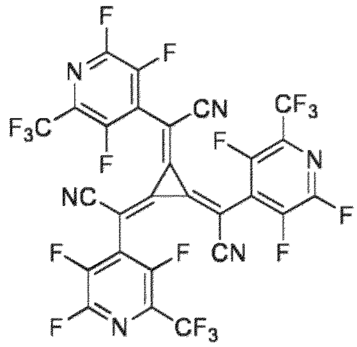 (F14),

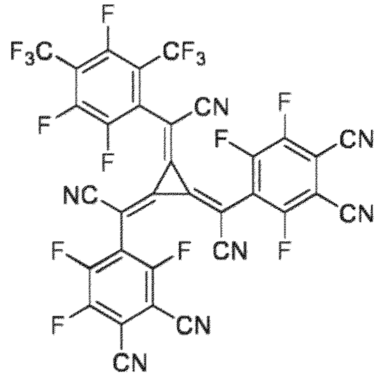
(F15),

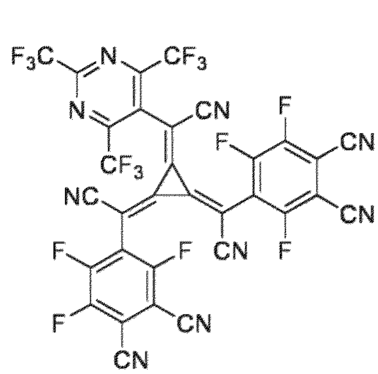
(F16),

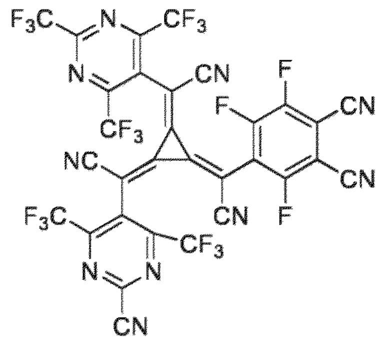
(F17),

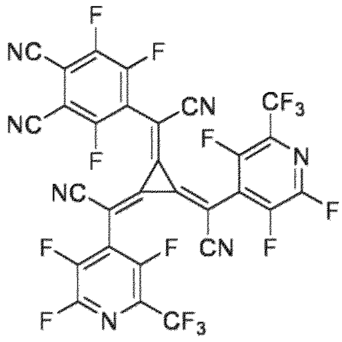
(F18),

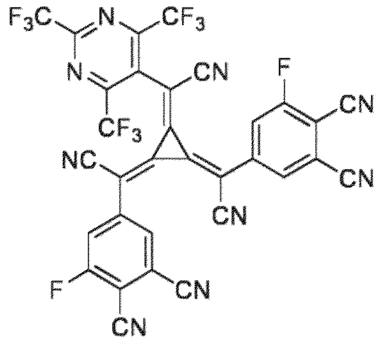
(F19),

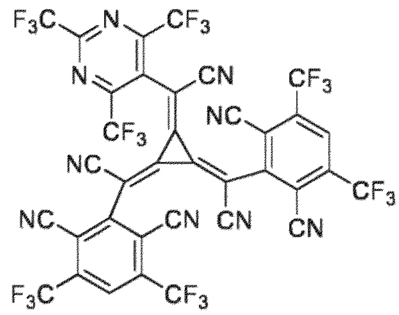
(F20),

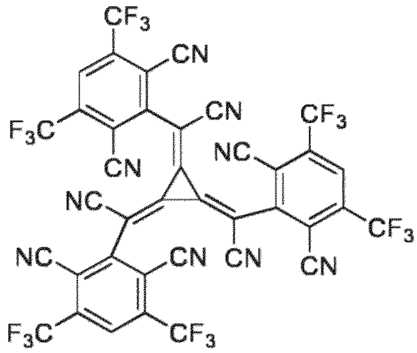
(F21),

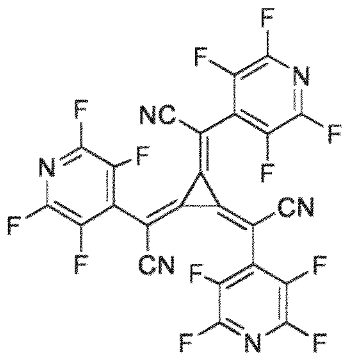
(F22),

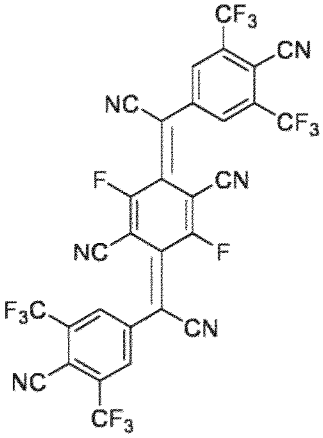
(F23),
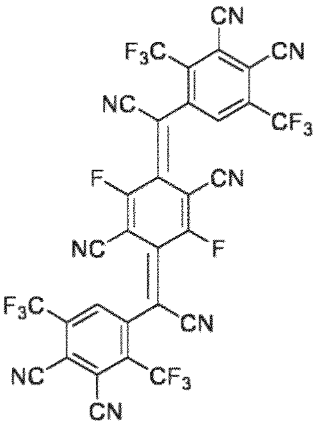
(F24),

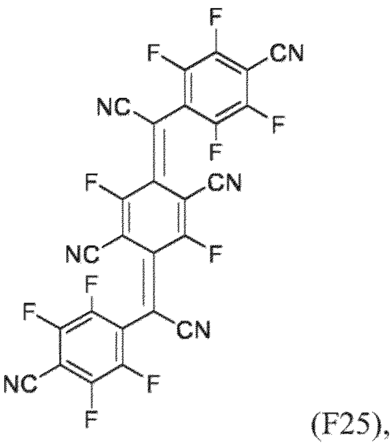
(F25),
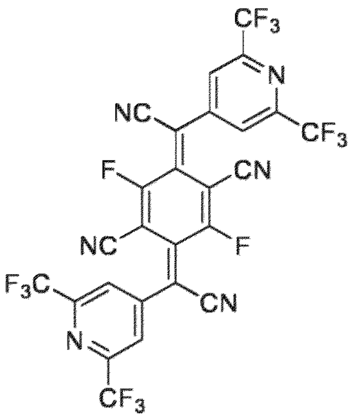
(F26),

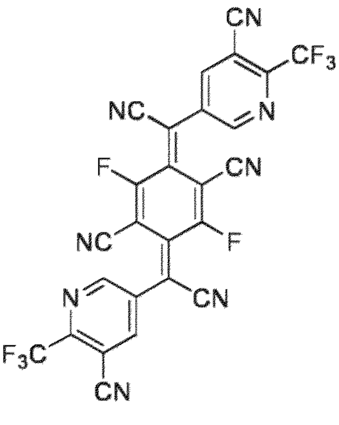
(F27),
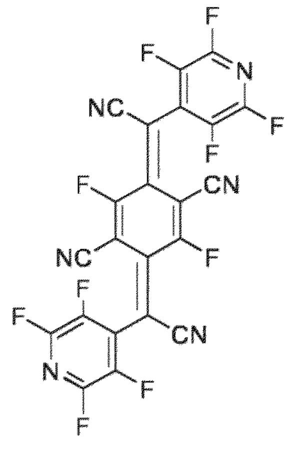
(F28),

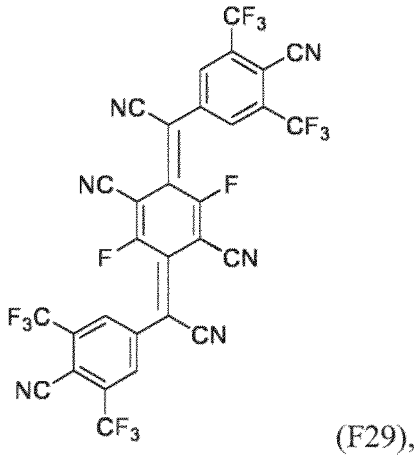
(F29),

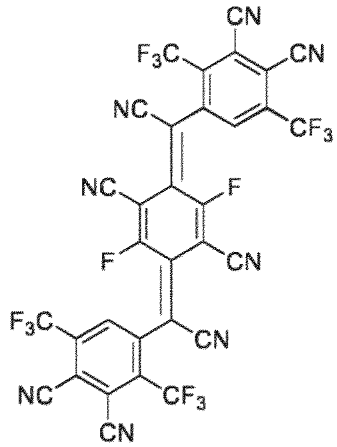
(F30),

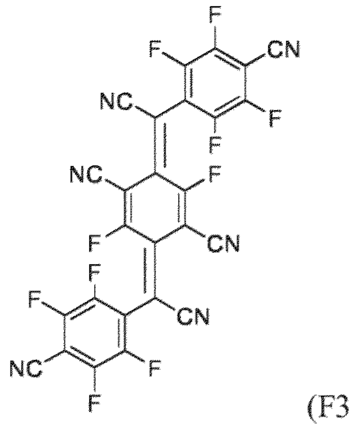
(F31),

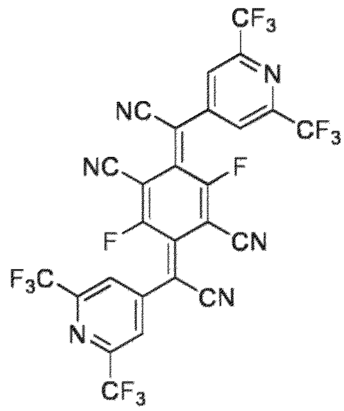
(F32),

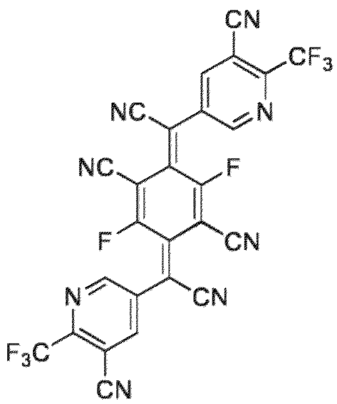
(F33),

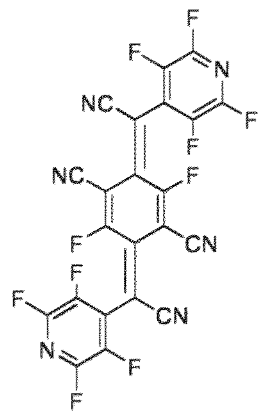
(F34),

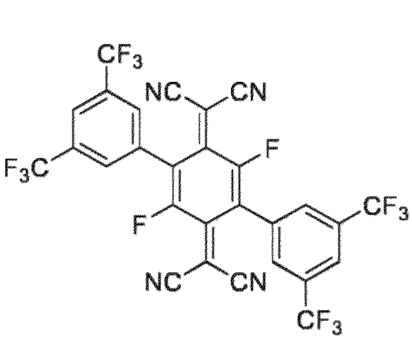
(F35),

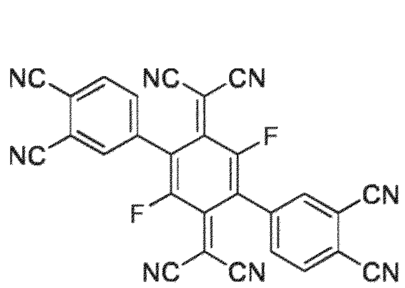
(F36),

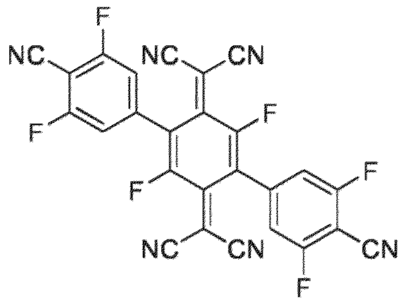 (F37),

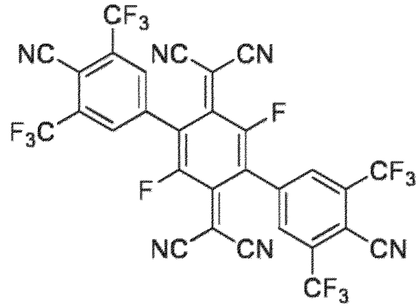 (F38),

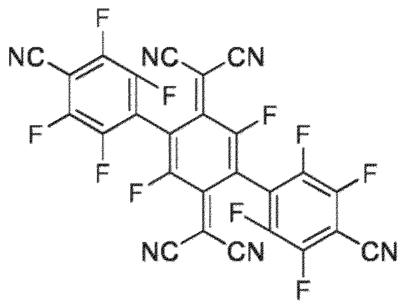 (F39),

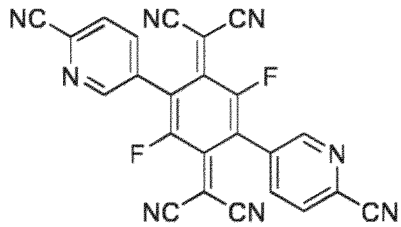 (F40),

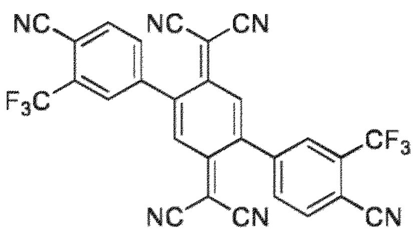 (F41),

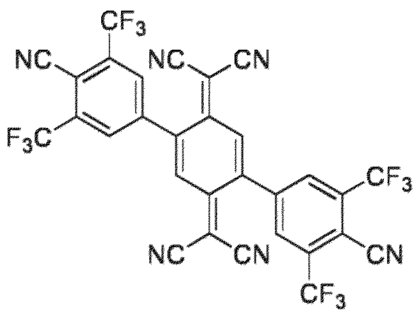 (F42),

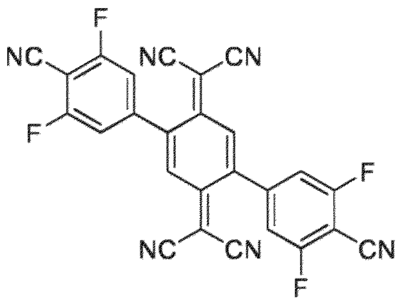 (F43),

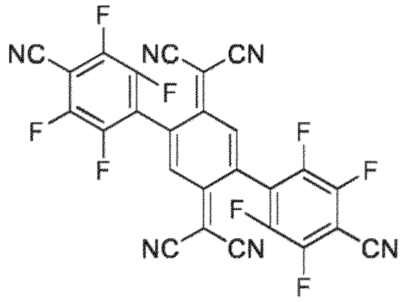 (F44),

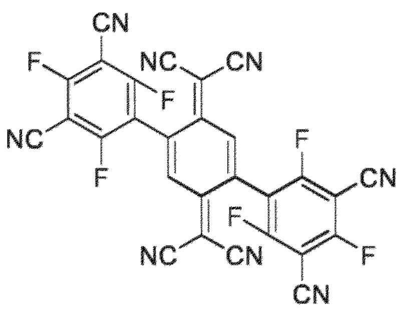 (F45),

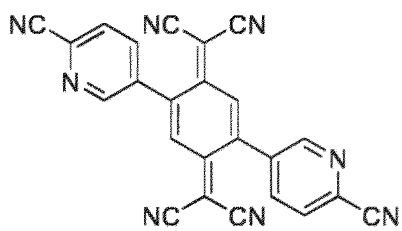 (F46),

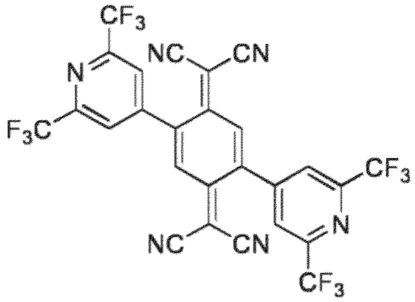
(F47),

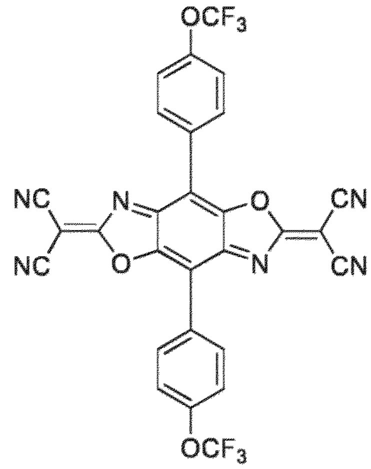
(F48),

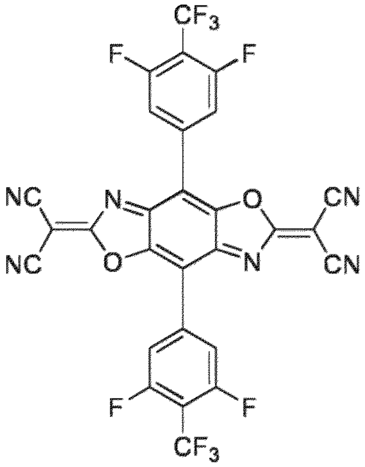
(F49),

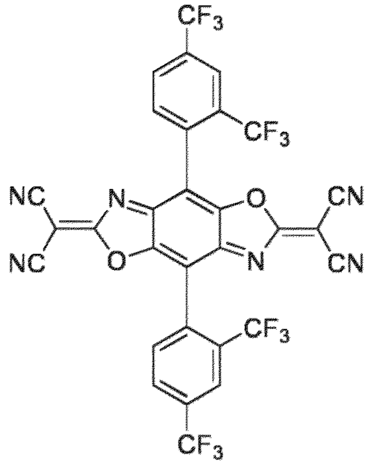
(F50),

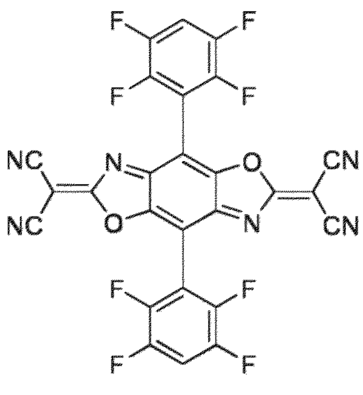
(F51),

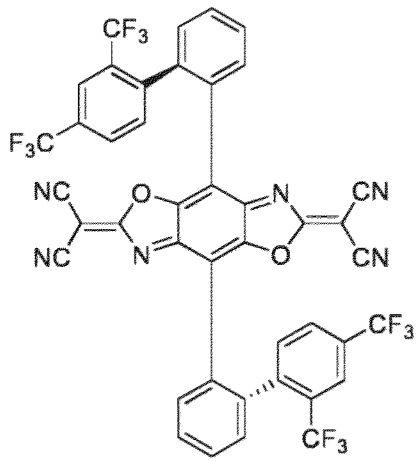
(F52),

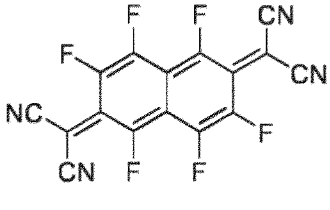
(F53),

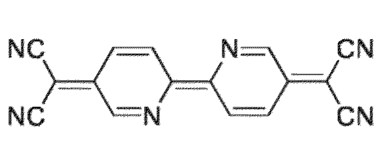
(F54),

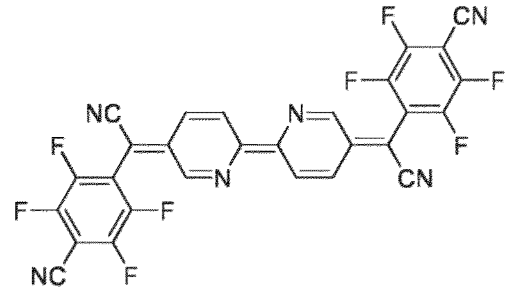 (F55), 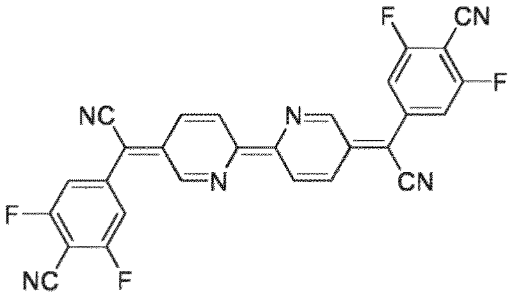 (F56),

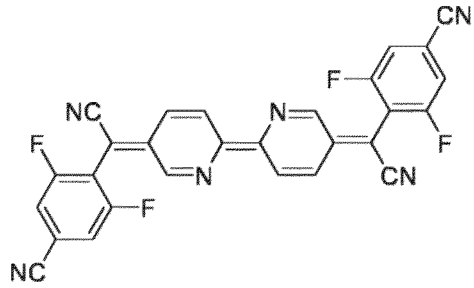 (F57), 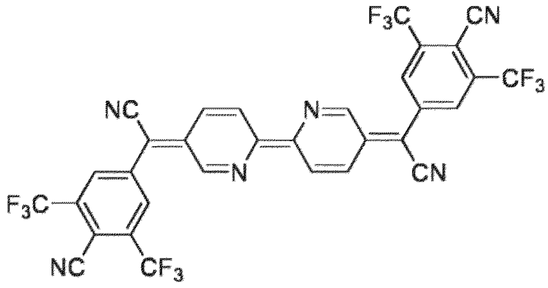 (F58),

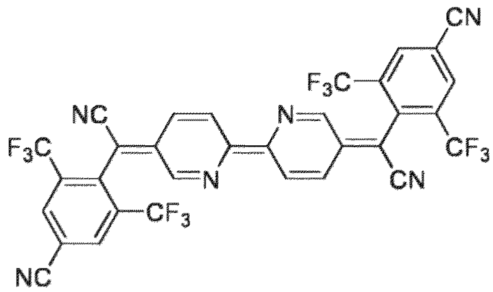 (F59), 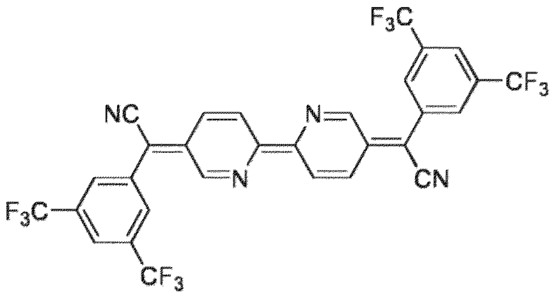 (F60).

Thereby, particularly improved properties of the organic electroluminescent device may be obtained, in particular reduced operating voltage, improved efficiency, improved lifetime and/or reduced voltage rise over time.

According to one embodiment, p-dopant of formula (I) is selected from formulae F1 to F52. Thereby, particularly improved performance of the organic electroluminescent device may be obtained, as the LUMO energy of the p-dopant of formula (I) may be in the range for particularly improved hole generation in the organic electroluminescent device.

According to one embodiment, p-dopant of formula (I) is selected from formulae F1 to F47. Thereby, particularly improved performance of the organic electroluminescent device may be obtained, as the energy gap $E_{gap}$ of the p-dopant of formula (I) may be in the range for reduced absorption in the blue region of the emission spectrum of the light-emitting compound.

According to one embodiment, p-dopant of formula (I) is selected from formulae F1 to F34. Thereby, particularly improved performance of the organic electroluminescent device may be obtained, as the LUMO energy and energy gap $E_{gap}$ of the p-dopant of formula (I) may be in the range high doping strength and/or reduced absorption in the blue region of the emission spectrum of the light-emitting compound.

**Formula (IIa)**

According to one embodiment, $X^3$, $X^4$ and $X^5$ are selected the same. According to one embodiment, $X^3$ and $X^4$ of the p-type dopant of formula (II) are selected the same; and/or $X^3$, $X^4$ and $X^5$ of the p-type dopant of formula (II) are selected the same.

According to one embodiment, $X^3$, $X^4$ and $X^5$ are independently selected from formula (IIa)

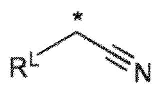 (IIa),

wherein the asterisk "*" denotes the binding position;

$R^L$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl, wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$A^1$ is selected from a group comprising of (P1) to (P5):

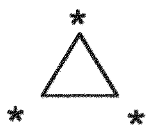 (P1), 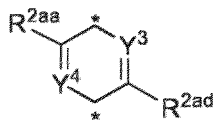 (P2), 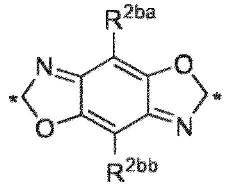 (P3),

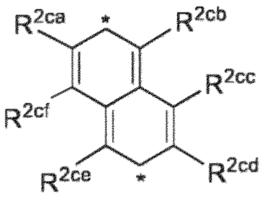 (P4), 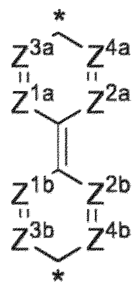 (P5),

wherein each $X^3$, $X^4$, and/or $X^5$ are conjugated via a double-bond to $A^1$;

- $Y^3$ is selected from N or $CR^{2ab}$;
- $Y^4$ is selected from N or $CR^{2ac}$;
- $Z^{1a}$, $Z^{2a}$, $Z^{3a}$, $Z^{4a}$, $Z^{1b}$, $Z^{2b}$, $Z^{3b}$, $Z^{4b}$ are independently selected from N or $CR^{2da}$, preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$, $R^{2ac}$ , $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to one embodiment, wherein each $R^L$ according to formula (IIa) is independently selected from CN or substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted $C_1$ to $C_4$ alkyl, partially fluorinated $C_1$ to $C_4$ alkyl, perfluorinated $C_1$ to $C_4$ alkyl, substituted or unsubstituted $C_1$ to $C_4$ alkoxy, partially fluorinated $C_1$ to $C_4$ alkoxy, perfluorinated $C_1$ to $C_4$ alkoxy, preferably F, CN, $CF_3$.

According to one embodiment, wherein each $R^L$ of formula (IIa) is independently selected from CN or substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted C1 to C4 alkyl, partially fluorinated C1 to C4 alkyl, perfluorinated C1 to C4 alkyl, substituted or unsubstituted C1 to C4 alkoxy, partially fluorinated C1 to C4 alkoxy, perfluorinated C1 to C4 alkoxy, preferably F, CN, CF3.

According to one embodiment, wherein each $R^L$ according to formula (IIa) is independently selected from CN or formulae D1 to D80.

According to one embodiment, wherein each $R^L$ according to formula (IIa) is independently selected from CN or formulae D1 to D80. According to one preferred embodiment, wherein each $R^L$ according to formula (IIa) is independently selected from CN or D1 to D78.

According to one further preferred embodiment, wherein each $R^L$ according to formula (IIa) is independently selected from CN or D1 to D67. According to one more preferred embodiment, wherein each $R^L$ according to formula (IIa) is independently selected from CN or D1 to D48, and furthermore preferred independently selected from CN or formulae D1 to D45 and D47 to D66.

According to one further preferred embodiment, wherein each $R^L$ according to formula (IIa) is independently selected from CN or D1 to D78, more preferred each $R^L$ is selected from CN or D1 to D67. According to one embodiment, wherein each $R^L$ is independently selected from CN or D1 to D43, more preferred each $R^L$ is selected from CN or D1 to D41.

According to one embodiment, in formulae (IIa) $R^L$ is selected from the following groups D3, D4, D11, D19, D13, D20, D32, D61 or D62:

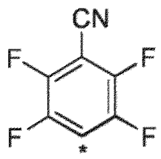 (D3), 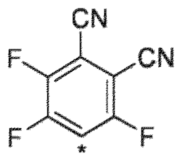 (D4), 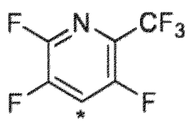 (D11), 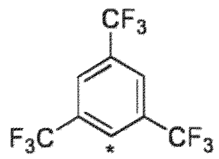 (D19),

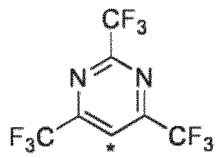 (D13), 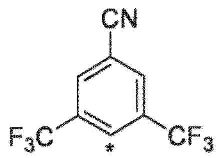 (D20), 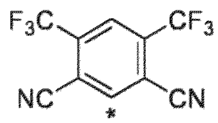 (D32), 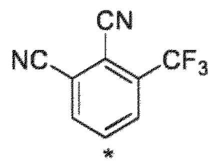 (D61),

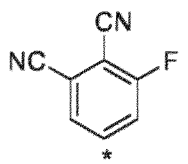 (D62);

wherein the asterisk "*" denotes the binding position.

According to one embodiment, wherein in formula (IIa) each $R^L$ is independently selected from CN or formulae K1 to K24:

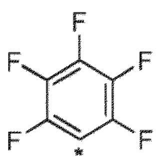 (K1), 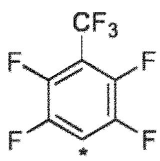 (K2), 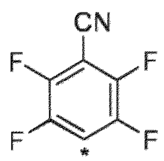 (K3), 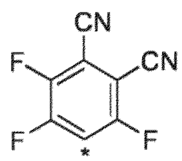 (K4), 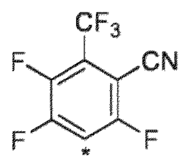 (K5),

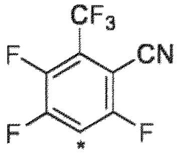 (K6), 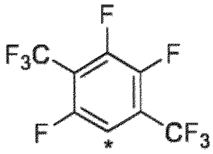 (K7), 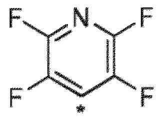 (K8), 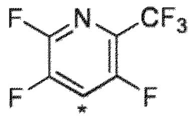 (K9),

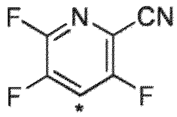 (K10), 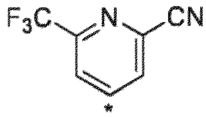 (K11), 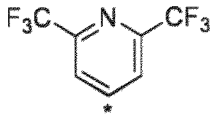 (K12), 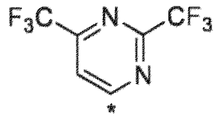 (K13),

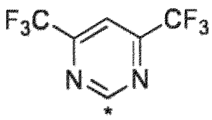 (K14), 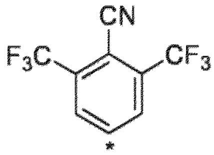 (K15), 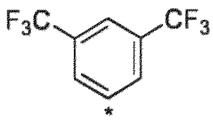 (K16), 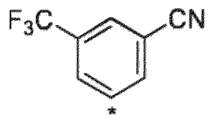 (K17),

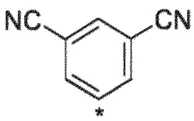 (K18), 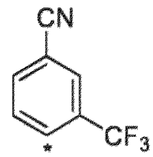 (K19), 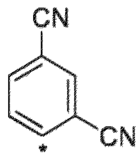 (K20), 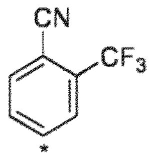 (K21),

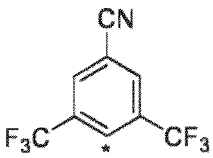 (K22), 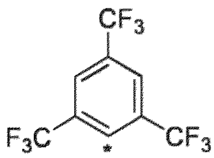 (K23), 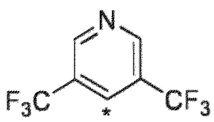 (K24),

wherein the asterisk "*" denotes the binding position.

**Formulae P1, P2, P3, P4 and P5**

According to one embodiment regarding $A^1$ of Formula (II), wherein $A^1$ is represented by formulae (P1) to (P5):

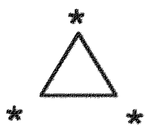 (P1), 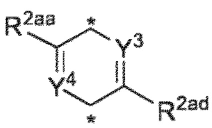 (P2), 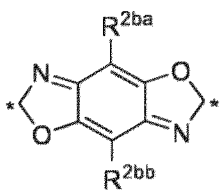 (P3),

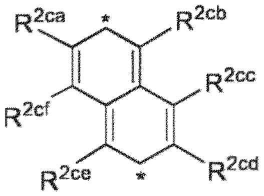 (P4), 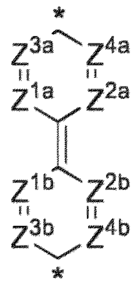 (P5),

wherein each $X^3$, $X^4$, and/or $X^5$ are conjugated via a double-bond to $A^1$;

- $Y^3$ is selected from N or $CR^{2ab}$;
- $Y^4$ is selected from N or $CR^{2ac}$;
- $Z^{1a}$, $Z^{2a}$, $Z^{3a}$, $Z^{4a}$, $Z^{1b}$, $Z^{2b}$, $Z^{3b}$, $Z^{4b}$ are independently selected from Nor $CR^{2da}$ , preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$ , $R^{2ac}$ , $R^{2ad}$ , $R^{2ba}$ , $R^{2bb}$, $R^{2ca}$, $R^{2cb}$, $R^{2cc}$ , $R^{2cd}$ , $R^{2ce}$ , $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to one embodiment, wherein $X^1$, $X^2$ and $X^3$ are independently selected from formula (IIa), wherein formula (IIa) is selected from the group comprising CN or formulae D1 to D80.

According to one embodiment, wherein in formulae (P1) and/or (P2):

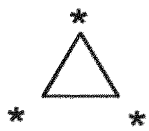 (P1), 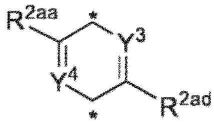 (P2),

- $Y^3$ is selected from $CR^{2ab}$;
- $Y^4$ is selected from $CR^{2ac}$;
- $R^{2aa}$, $R^{2ab}$, $R^{2ac}$, $R^{2ad}$ are independently selected from H, D, an electron-withdrawing group, halogen, Cl, F, CN; preferably $R^{2aa}$, $R^{2ab}$, $R^{2ac}$, $R^{2ad}$ are selected from H, D, F or CN, most preferred $R^{2aa}$, $R^{2ab}$, $R^{2ac}$, $R^{2ad}$ are selected form F or CN, also preferred two of $R^{2aa}$, $R^{2ab}$, $R^{2ac}$, $R^{2ad}$ are selected from F and two $R^{2aa}$, $R^{2ab}$, $R^{2ac}$, $R^{2ad}$ are selected from CN; and
- each $R^L$ according to formula (IIa) is independently selected from formulae D1 to D80, preferably D1 to D78, more preferred D1 to D67;

preferably $A^1$ is (P1) and each $R^L$ may be selected the same or differently; and/or $A^1$ is (P2) and each $R^L$ is selected the same.

According to one embodiment, wherein in formulae (P2) to (P4):

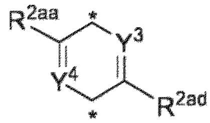 (P2), 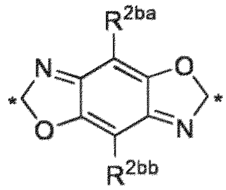 (P3), 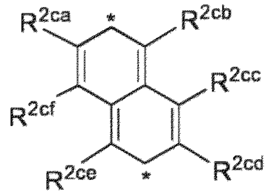 (P4),

- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, CN, a substituted $C_6$ to $C_{30}$ aryl, or a substituted $C_3$ to $C_{30}$ heteroaryl, wherein the one or more substituents are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN;
  wherein the one or more substituents of the substituted $C_1$ to $C_8$ alkyl, substituted $C_1$ to $C_8$ alkoxy are independently selected D, an electron-withdrawing group, halogen, Cl, F, CN, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to one embodiment, wherein in formulae (P2) to (P4):
$R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from formulae E1 to E73:

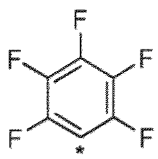 (E1), 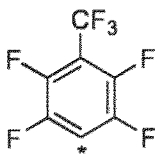 (E2), 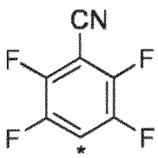 (E3), 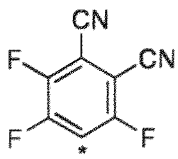 (E4), 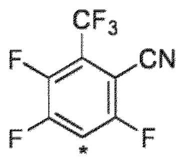 (E5),

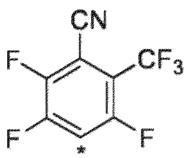 (E6), 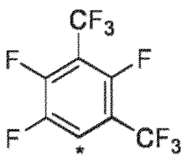 (E7), 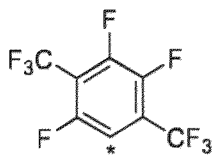 (E8), 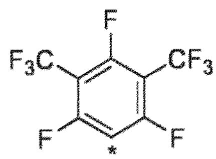 (E9),

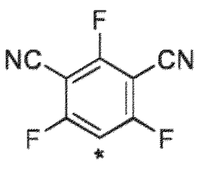 (E10), 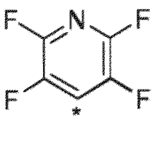 (E11), 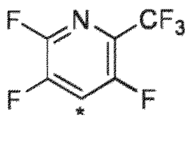 (E12), 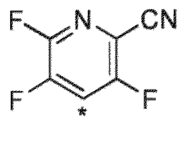 (E13),

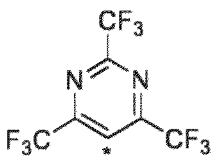 (E14), 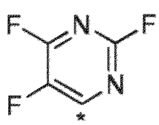 (E15), 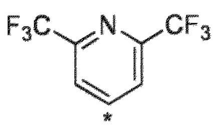 (E16), 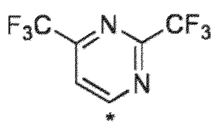 (E17),

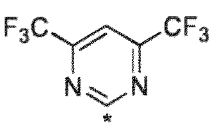 (E18), 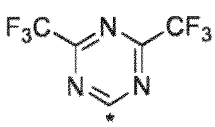 (E19), 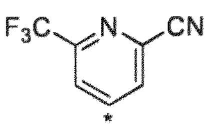 (E20), 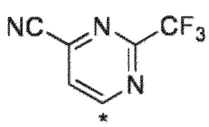 (E21),

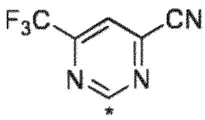 (E22), 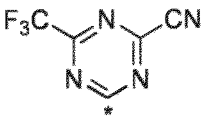 (E23), 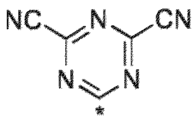 (E24), 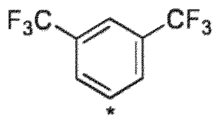 (E25),

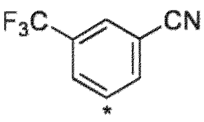 (E26), 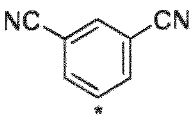 (E27), 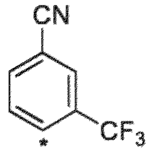 (E28), 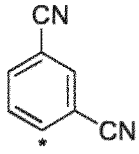 (E29),

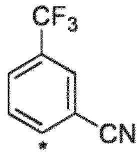 (E30), 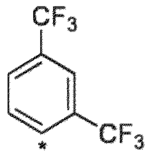 (E31), 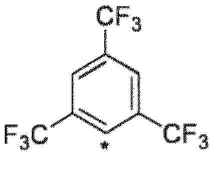 (E32), 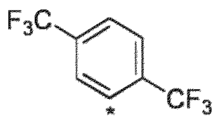 (E33),

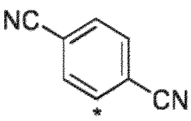 (E34), 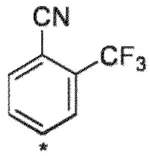 (E35), 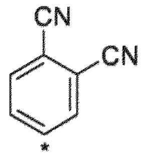 (E36), 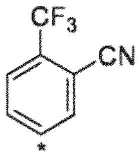 (E37),

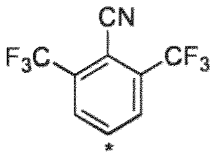 (E38), 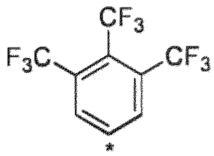 (E39), 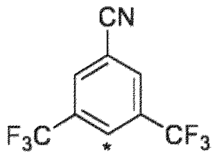 (E40), 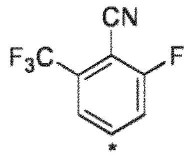 (E41),

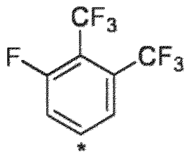 (E42), 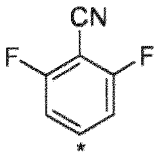 (E43), 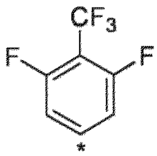 (E44), 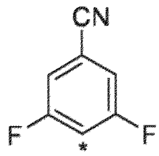 (E45),

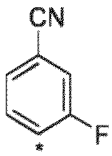 (E46), 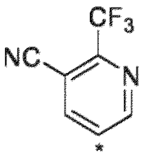 (E47), 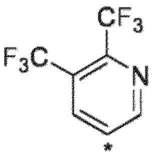 (E48), 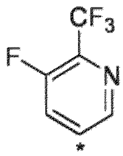 (E49), 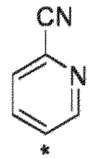 (E50),

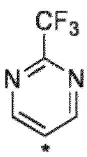 (E51), 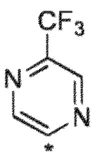 (E52), 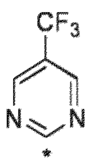 (E53), 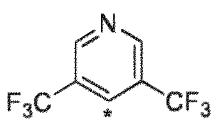 (E54), 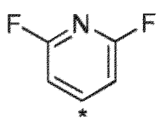 (E55),

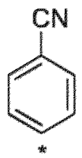 (E56), 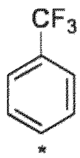 (E57), 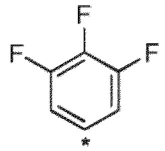 (E58), 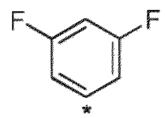 (E59), 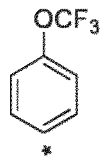 (E60),

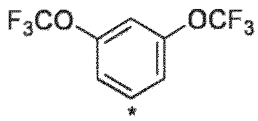 (E61), 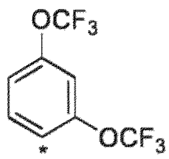 (E62), 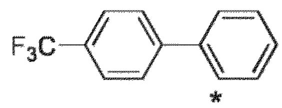 (E63),

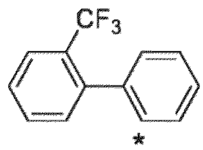 (E64), 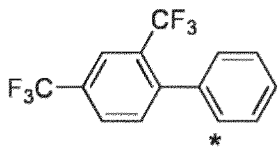 (E65), 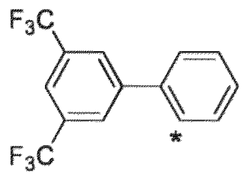 (E66),

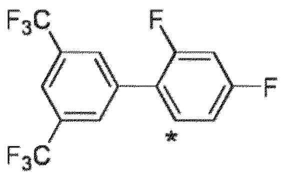 (E67), 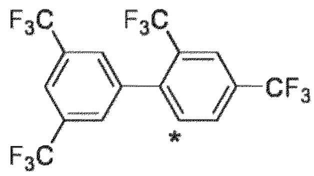 (E68), 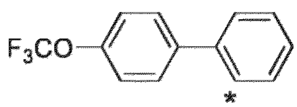 (E69),

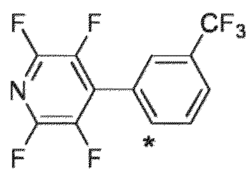 (E70), 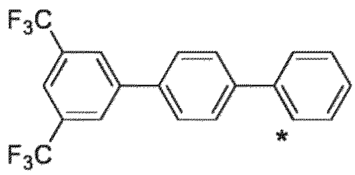 (E71),

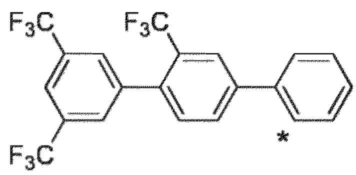 (E72), 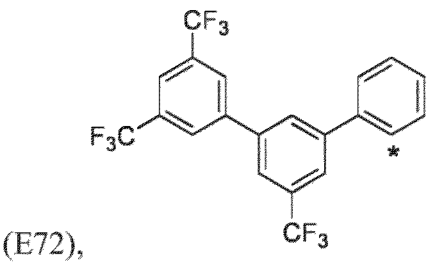 (E73);

wherein the asterix "*" denotes the binding position.

According to one embodiment, wherein in formulae (P2) and (P3):

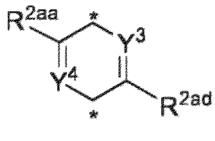 (P2), 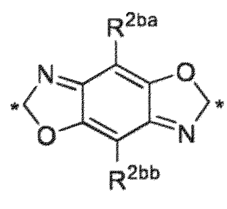 (P3),

- $R^{2aa}$, $R^{2ad}$, $R^{2ba}$ and $R^{2bb}$ are independently selected from formulae E1 to E73; preferably $R^{2aa}$, $R^{2ad}$, $R^{2ba}$ and $R^{2bb}$

are selected the same; and

- $Y^3$ is selected from $CR^{2ab}$;
- $Y^4$ is selected from $CR^{2ac}$;
- $R^{2ab}$ and $R^{2ac}$ are independently selected from H, D, an electron-withdrawing group, halogen, Cl, F, CN; preferably $R^{2ab}$ and $R^{2ac}$ are selected from H, D, F or CN.

According to one embodiment, wherein for the group (P2), $R^{2aa}$, $R^{2ad}$, $R^{2ac}$, $R^{2ad}$, are independently selected from H, D, an electron-withdrawing group, halogen, Cl, F, CN or substituted $C_6$ to $C_{12}$ aryl or substituted $C_3$ to $C_{12}$ heteroaryl,

wherein the substituent of the substituted $C_6$ to $C_{12}$ aryl or substituted $C_3$ to $C_{12}$ heteroaryl is selected from halogen, F, Cl, CN, substituted or unsubstituted $C_1$ to $C_4$ alkyl, partially fluorinated $C_1$ to $C_4$ alkyl, perfluorinated $C_1$ to $C_4$ alkyl, substituted or unsubstituted $C_1$ to $C_4$ alkoxy, partially fluorinated $C_1$ to $C_4$ alkoxy, perfluorinated $C_1$ to $C_4$ alkoxy, preferably F, CN, $CF_3$;
preferably
$R^{2aa}$ and $R^{2ad}$ are independently selected from H, D, an electron-withdrawing group, halogen, Cl, F, CN or substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted $C_1$ to $C_4$ alkyl, partially fluorinated $C_1$ to $C_4$ alkyl, perfluorinated $C_1$ to $C_4$ allcyl, substituted or unsubstituted $C_1$ to $C_4$ alkoxy, partially fluorinated $C_1$ to $C_4$ alkoxy, perfluorinated $C_1$ to $C_4$ alkoxy, preferably F, CN, $CF_3$; and
$R^{2ab}$ and $R^{2ac}$ are independently selected from H, D, an electron-withdrawing group, halogen, Cl, F, CN; and/or
$R^{2ba}$ and $R^{2bb}$ are independently selected from a substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted $C_1$ to $C_4$ alkyl, partially fluorinated $C_1$ to $C_4$ alkyl, perfluorinated $C_1$ to $C_4$ alkyl, substituted or unsubstituted $C_1$ to $C_4$ alkoxy, partially fluorinated $C_1$ to $C_4$ alkoxy, perfluorinated $C_1$ to $C_4$ alkoxy, preferably F, CN, $CF_3$.

According to one embodiment, wherein in formula (P4):

- $R^{2ca}$, $R^{2cb}$, $R^{2cc}$, $R^{2cd}$, $R^{2ce}$ and $R^{2cf}$ are independently selected from H, D, an electron-withdrawing group, halogen, Cl, F, preferably F.

According to one embodiment, wherein in formula (P2):
$R^{2aa}$, $R^{2ad}$, $R^{2ba}$ and $R^{2bb}$ are independently selected from formulae E1 to E73; preferably $R^{2aa}$, $R^{2ad}$, $R^{2ba}$ and $R^{2bb}$ are selected the same.

According to one embodiment, wherein in formulae (P2) and (P4):

- $R^{2ab}$ and $R^{2ac}$ and $R^{2ca}$, $R^{2cb}$, $R^{2cc}$, $R^{2cd}$, $R^{2ce}$ and $R^{2cf}$ are independently selected from H, D, an electron-withdrawing group, halogen, Cl, F, CN;
- preferably $R^{2ab}$ and $R^{2ac}$ are selected from H, D, F or CN; and $R^{2ca}$, $R^{2cb}$, $R^{2cc}$, $R^{2cd}$, $R^{2ce}$ and $R^{2cf}$ are F.

According to one embodiment, wherein in formula (II):

- $R^L$ according to formula (IIa) is selected from formulae D1 to D80, preferably each $R^L$ is selected the same;
- $R^{2aa}$ and $R^{2ad}$ are independently selected from H, D, an electron-withdrawing group, halogen, Cl, F, CN;
- $R^{2ba}$ and $R^{2bb}$ are independently selected from formulae E1 to E70;
- $R^{2ab}$ and $R^{2ac}$ and $R^{2ca}$, $R^{2cb}$, $R^{2cc}$, $R^{2cd}$, $R^{2ce}$ and $R^{2cf}$ are independently selected from H, D, an electron-withdrawing group, halogen, Cl, F, CN; preferably $R^{2ab}$ and $R^{2ac}$ are selected from H, D, F or CN, and $R^{2ca}$, $R^{2cb}$, $R^{2cc}$, $R^{2cd}$, $R^{2ce}$ and $R^{2cf}$ are F.

According to one embodiment, wherein in formula (II):

- $R^L$ according to formula (IIa) is selected from CN;
- $R^{2aa}$, $R^{2ad}$, $R^{2ba}$ and $R^{2bb}$ are independently selected from formulae E1 to E70;
- $R^{2ab}$ and $R^{2ac}$ and $R^{2ca}$, $R^{2cb}$, $R^{2cc}$, $R^{2cd}$, $R^{2ce}$ and $R^{2cf}$ are independently selected from H, D, an electron-withdrawing group, halogen, Cl, F, CN; preferably $R^{2ab}$ and $R^{2ac}$ are selected from H, D, F or CN; and
- $R^{2ca}$, $R^{2cb}$, $R^{2cc}$, $R^{2cd}$, $R^{2ce}$ and $R^{2cf}$ are F.

According to one embodiment, wherein in formula (II),

- each $R^L$ is independently selected from formulae D1 to D80, preferably D1 to D78; and
- A is selected from group (P1) or (P2).

According to one embodiment, wherein in formula (II),

- Each $R^L$ according to formula (IIa) is independently selected from formulae D1 to D80, preferably D1 to D78; and
- A is selected from group (P1).

According to one embodiment, wherein in formula (II),

- Each $R^L$ according to formula (IIa) is independently selected from CN or formulae D1 to D80, preferably each $R^L$ is selected the same;
- A is selected from group (P2) or (P3); and
- $R^{2aa}$ and $R^{2ad}$ are selected from formulae E1 to E59, preferably E1 to E56, $R^{2ab}$ and $R^{2ac}$ are selected from H, D, an electron-withdrawing group, halogen, Cl, F, CN.

According to one embodiment, wherein in formula (II),

- Each $R^L$ according to formula (IIa) is independently selected from CN or formulae D1 to D80, preferably each $R^L$ is selected the same;
- A is selected from group (P2); and
- $R^{2aa}$ and $R^{2ad}$ are selected from formulae E1 to E59, preferably E1 to E56, $R^{2ab}$ and $R^{2ac}$ are selected from H, D, an electron-withdrawing group, halogen, Cl, F, CN.

**First and second hole transport matrix compound**

According to one embodiment, the first hole transport matrix compound and second hole transport matrix compound may be selected from a substantially covalent matrix compound, preferably the first hole transport matrix compound and second hole transport matrix compound may be selected from at least one organic compound.

The first hole transport matrix compound and second hole transport matrix compound can be selected same or different from each other, preferably the same.

The substantially covalent matrix compound may consists substantially of covalently bound C, H, O, N, S, which optionally comprise in addition covalently bound B, P, As and/or Se.

According to one embodiment, the substantially covalent matrix compound may be selected from organic compounds consisting substantially of covalently bound C, H, O, N, S, which optionally comprise in addition covalently bound B, P, As and/or Se.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment, the first hole transport matrix compound and second hole transport matrix compound may have a molecular weight Mw of $\geq$ 400 and $\leq$ 2000 g/mol, preferably a molecular weight Mw of $\geq$ 450 and $\leq$ 1500 g/mol, further preferred a molecular weight Mw of $\geq$ 500 and $\leq$ 1000 g/mol, in addition preferred a molecular weight Mw of $\geq$ 550 and $\leq$ 900 g/mol, also preferred a molecular weight Mw of $\geq$ 600 and $\leq$ 800 g/mol.

Preferably, the first hole transport matrix compound and second hole transport matrix compound comprise at least one arylamine moiety, alternatively a diarylamine moiety, alternatively a triarylamine moiety.

Preferably, the first hole transport matrix compound and second hole transport matrix compound are free of metals and/or ionic bonds.

**Compound of formula (IVa) or a compound of formula (IVb)**

According to one embodiment, the first hole transport matrix compound and/or the second hole transport matrix compound may be selected the same or different from the group comprising at least one arylamine compound, diarylamine compound, triarylamine compound, a compound of formula (IVa) or a compound of formula (IVb):

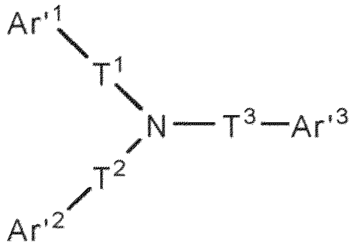 (IVa), 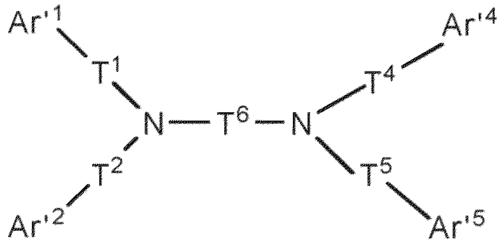 (IVb),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

Ar'[1], Ar'[2], Ar'[3], Ar'[4] and Ar'[5] are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of Ar'[1], Ar'[2], Ar'[3], Ar'[4] and Ar'[5] are selected the same or different from the group comprising H, D, F, C(=O)R'[2], CN, $Si(R'^2)_3$, $P(=O)(R'^2)_2$, OR'[2], S(=O)R'[2], $S(=O)_2R'^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5-to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein R'[2] may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment, wherein $T^1$, $T^2$, $T^3$, $T^4$ and $T^5$ may be independently selected from a single bond, phenylene, biphenylene or terphenylene. According to an embodiment, wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment, wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment, wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment, wherein $T^1$, $T^2$ and $T^3$ may be independently selected from phenylene and one of $T^1$, $T^2$ and $T^3$ are a single bond. According to an embodiment, wherein $T^1$, $T^2$ and $T^3$ may be independently selected from phenylene and two of $T^1$, $T^2$ and $T^3$ are a single bond.

According to an embodiment, wherein $T^6$ may be phenylene, biphenylene, terphenylene. According to an embodiment, wherein $T^6$ may be phenylene. According to an embodiment, wherein $T^6$ may be biphenylene. According to an embodiment, wherein $T^6$ may be terphenylene.

According to an embodiment, wherein Ar'[1], Ar'[2], Ar'[3], Ar'[4] and Ar'[5] may be independently selected from Q1 to

Q16:

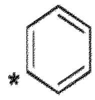 (Q1), 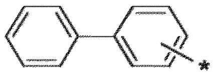 (Q2), 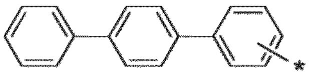 (Q3), 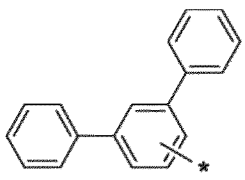 (Q4),

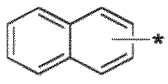 (Q5), 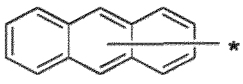 (Q6), 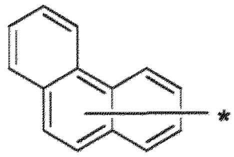 (Q7), 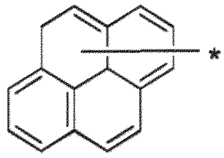 (Q8),

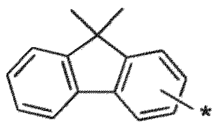 (Q9), 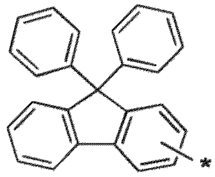 (Q10), 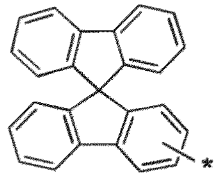 (Q11),

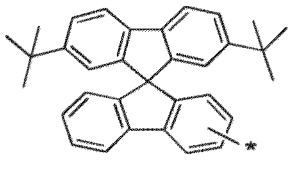 (Q12), 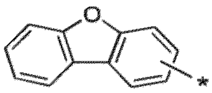 (Q13), 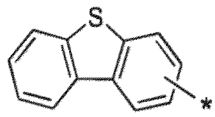 (Q14),

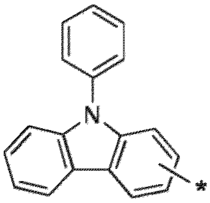 (Q15), 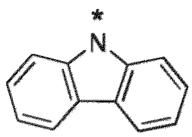 (Q16),

wherein the asterix "*" denotes the binding position.

According to an embodiment, wherein Ar'[1], Ar'[2], Ar'[3], Ar'[4] and Ar'[5] may be independently selected from Q1 to Q15; alternatively selected from Q1 to Q10 and Q13 to Q15.

According to an embodiment, wherein Ar'[1], Ar'[2], Ar'[3], Ar'[4] and Ar'[5] may be independently selected from the group consisting of Q1, Q2, Q5, Q7, Q9, Q10, Q13 to Q16.

The rate onset temperature may be in a range particularly suited to mass production, when Ar'[1], Ar'[2], Ar'[3], Ar'[4] and Ar'[5] are selected in this range.

The "matrix compound of formula (IVa) or formula (IVb)" may be also referred to as "hole transport matrix compound".

According to one embodiment, the first hole transport matrix compound and second hole transport matrix compound comprise at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (IVa) or formula (IVb) are selected from U1 to U23:

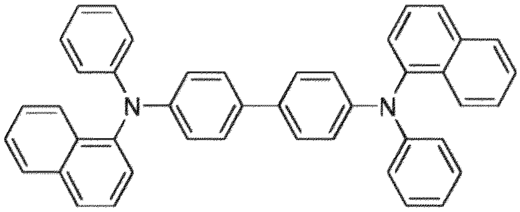 (U1),

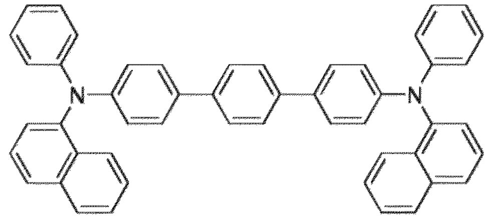 (U2),

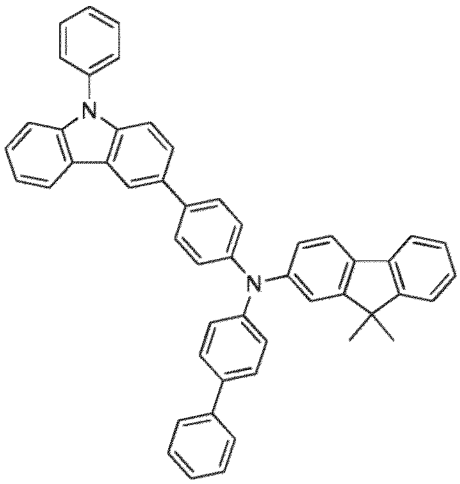 (U3),

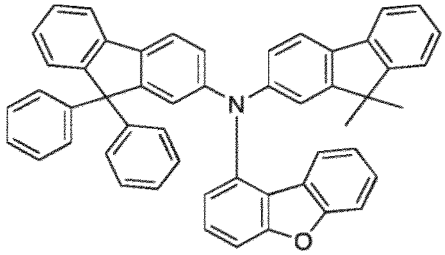 (U4),

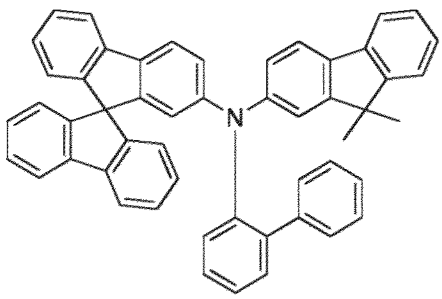 (U5),

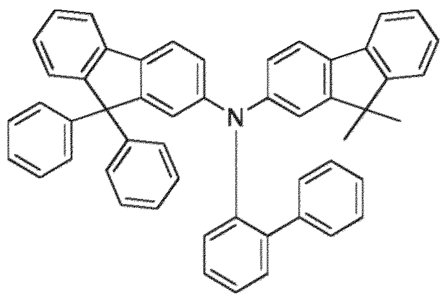 (U6),

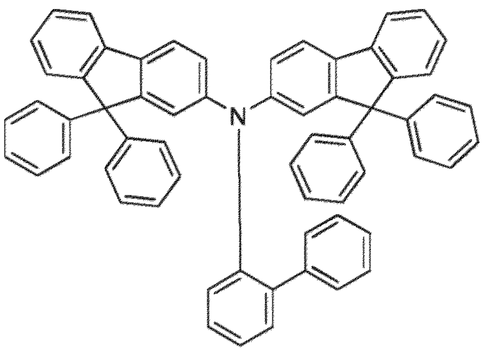 (U7),

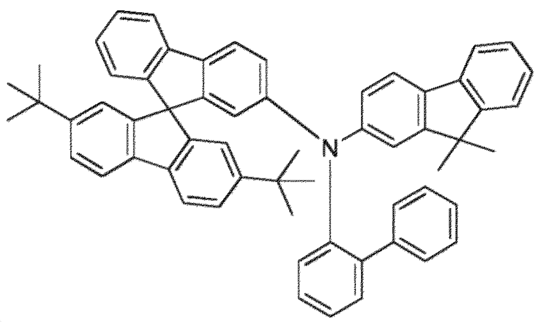 (U8),

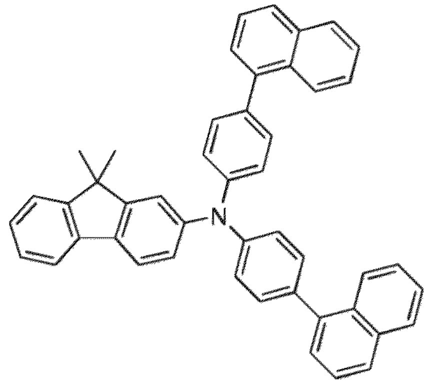 (U9),

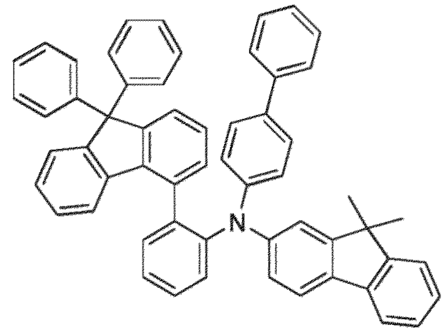 (U10),

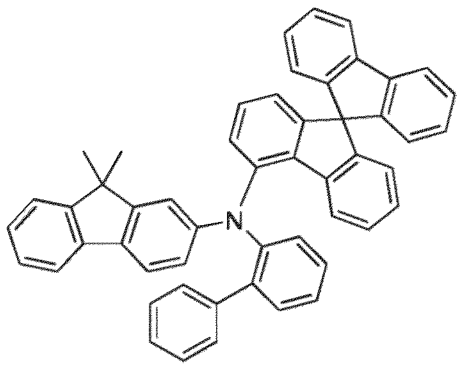 (U11),

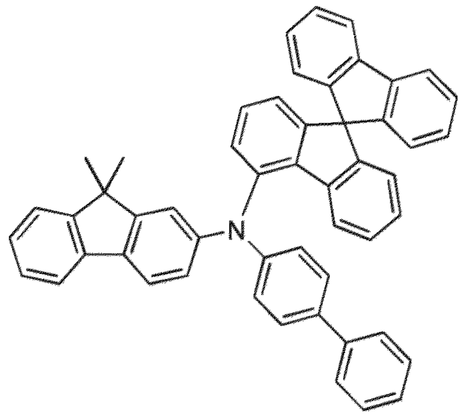 (U12),

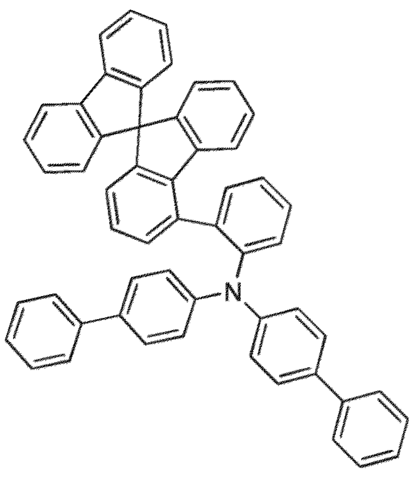 (U13),

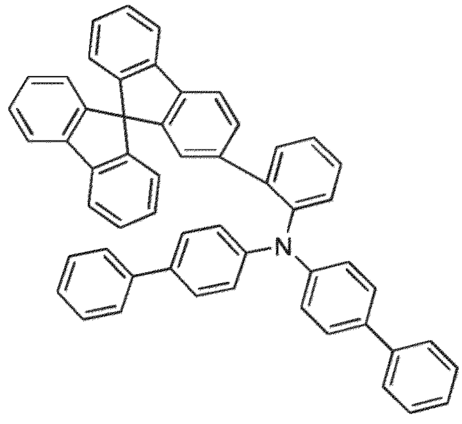 (U14),

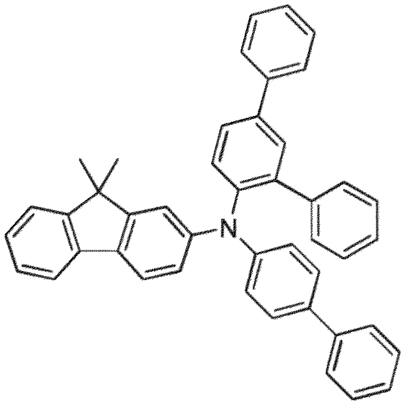
(U15),

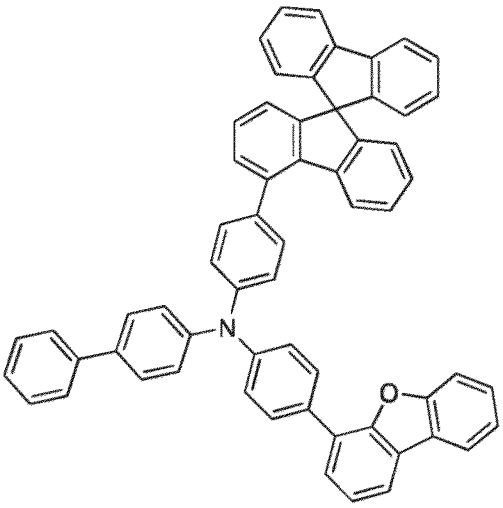
(U16),

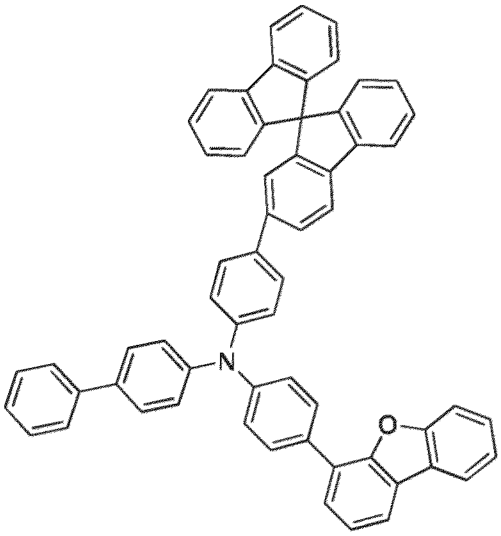
(U17),

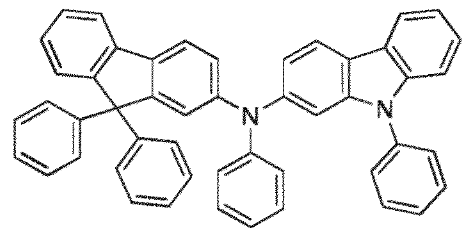
(U18),

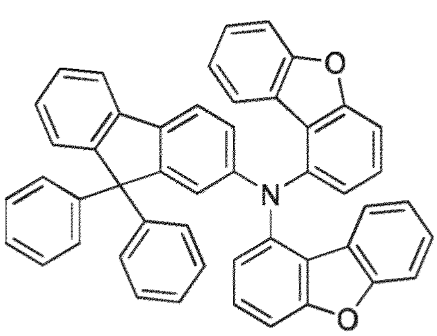
(U19),

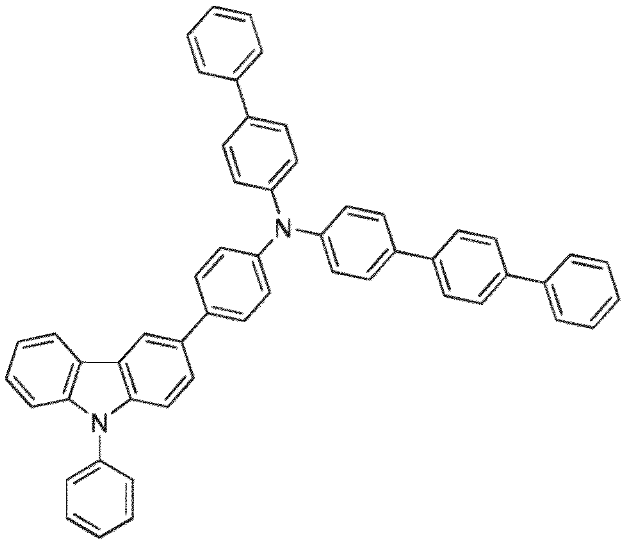
(U20),

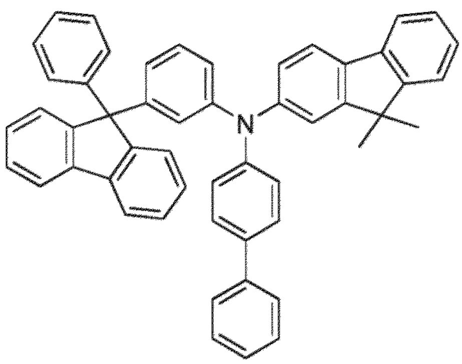 (U21), 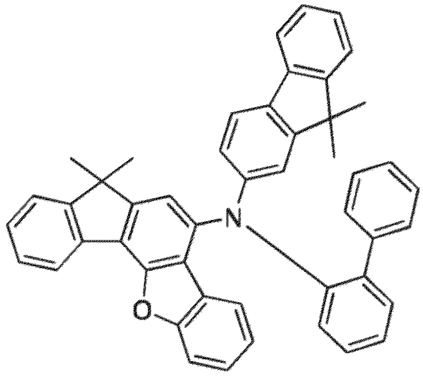 (U22),

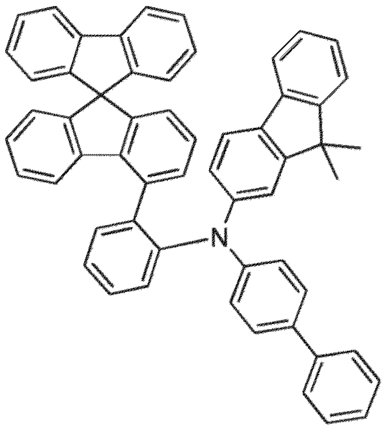 (U23).

**p-type charge generation layer**

The p-type charge generation layer, also named p-CGL, may be formed on the light-emitting unit by vacuum deposition. The deposition conditions may vary according to the compound(s) that are used to form the layer, and the desired structure and thermal properties of the layer. In general, however, conditions for vacuum deposition may include a deposition temperature of 100° C to 350° C, a pressure of $10^{-8}$ to $10^{-3}$ Torr (1 Torr equals 133.322 Pa), and a deposition rate of 0.1 to 10 nm/sec.

According to one embodiment, the thickness of the p-type charge generation layer may be selected in the range of ≥ 5 nm and ≤ 15 nm, preferably ≥ 6 nm and ≤ 12 nm, more preferred ≥ 7 nm and ≤ 11 nm.

According to one embodiment, the thickness of the first p-CGL sub-layer (p-CGL1) is smaller than the thickness of the second p-CGL sub-layer (p-CGL2).

According to one embodiment, the thickness of the first p-CGL sub-layer (p-CGL1) is selected in the range of ≥ 1 nm and ≤ 7 nm, preferably ≥ 1.5 nm and ≤ 5 nm, more preferred ≥ 2 nm and ≤ 4 nm; and the thickness of the second p-CGL sub-layer (p-CGL2) is selected in the range of ≥ 3 nm and ≤ 10 nm, preferably ≥ 5 nm and ≤ 9 nm, more preferred > 6 nm and ≤ 8 nm.

Thereby, particularly improved CGL sheet resistance may be obtained without impacting the other performance parameters of the organic electroluminescent device.

According to one embodiment, the thickness of the p-type charge generation layer is larger than the thickness of the n-type charge generation layer.

Thereby, particularly improved performance may be obtained of an organic electroluminescent devices.

**n-type charge generation layer**

According to one embodiment, the n-CGL matrix compound is selected from an azine compound, preferably an azine compound comprising at least one phenanthrolinyl moiety, more preferred an azine compound comprising one or two phenanthrolinyl moieties, also preferred an azine compound of formula MX-1:

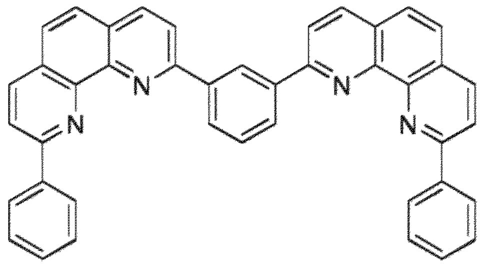

(MX-1).

According to one embodiment, the metal dopant is selected from an alkali metal, alkaline earth metal or rare earth metal, preferably Li or Yb.

According to one embodiment, the n-CGL matrix compound is selected from an azine compound, preferably an azine compound comprising a phenanthrolinyl moiety; and/or the metal dopant is selected from an alkali, alkaline earth metal or rare earth metal dopant, preferably Li or Yb.

The n-type charge generation layer, also named p-CGL, may be formed on the light-emitting unit by vacuum deposition. The deposition conditions may vary according to the compound(s) that are used to form the layer, and the desired structure and thermal properties of the layer. In general, however, conditions for vacuum deposition may include a deposition temperature of 100° C to 350° C, a pressure of $10^{-8}$ to $10^{-3}$ Torr (1 Torr equals 133.322 Pa), and a deposition rate of 0.1 to 10 nm/sec.

The thickness of the n-type charge generation layer may be in the range from about 5 nm to about 15 nm, for example, in the range from about 5 nm to about 8 nm. When the thickness of the n-type charge generation layer is within this range, the n-type charge generation layer may have satisfactory electron-injecting properties, without a substantial penalty in driving voltage.

**First and second light-emitting unit**

According to one embodiment of the invention, the first light-emitting unit comprises a first emission layer and the second light-emitting unit comprises a second emission layer, preferably the first emission layer and the second emission layer are selected the same.

According to one embodiment the organic electroluminescent device, wherein the first light-emitting unit comprises a first emission layer, and the second light-emitting unit comprises a second emission layer, preferably the peak wavelength of the light emitted by the first emission layer and/or second emission layer is in the range of 440 to 490 nm, more preferred 440 to 480 nm.

According to one embodiment of the invention, the first light-emitting unit may further comprise a first hole transport layer and the second light-emitting unit may further comprise a second hole transport layer, wherein the first hole transport layer is arranged between the anode layer and the first emission layer and the second hole transport layer is arranged between the p-type charge generation layer and the second emission layer, preferably the first hole transport layer and the second hole transport layer are selected the same.

According to one embodiment of the invention, the first light-emitting unit may further comprise a first electron blocking layer and the second light-emitting unit may further comprise a second electron blocking layer, wherein the first electron blocking layer is arranged between the anode layer and the first emission layer and the second electron blocking layer is arranged between the p-type charge generation layer and the second emission layer, preferably the first electron blocking layer and the second electron blocking layer are selected the same.

According to one embodiment of the invention, the first light-emitting unit may further comprise a first electron transport layer and the second light-emitting unit may further comprise a second electron transport layer, wherein the first electron transport layer is arranged between the first emission layer and the n-type charge generation layer and the second electron transport layer is arranged between the second emission layer and the cathode layer, preferably the first electron transport layer and the second electron transport layer are selected the same.

According to one embodiment of the invention, the first light-emitting unit may further comprise a first hole blocking layer and the second light-emitting unit may further comprise a second hole blocking layer, wherein the first hole blocking layer is arranged between the first emission layer and the n-type charge generation layer and the second hole blocking layer is arranged between the second emission layer and the cathode layer, preferably the first hole blocking layer and the second hole blocking layer are selected the same.

**Further layers**

In accordance with the invention, the organic electroluminescent device may comprise, besides the layers

already mentioned above, further layers. Exemplary embodiments of respective layers are described in the following:

**Substrate**

The substrate may be any substrate that is commonly used in manufacturing of organic electroluminescent devices and electronic devices comprising these. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

**Anode layer**

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

**Hole injection layer**

According to one embodiment, wherein the organic electroluminescent device further comprises a hole injection layer, preferably the hole injection layer is in direct contact with the anode layer.

According to one embodiment, the organic electroluminescent device may further comprise a hole injection layer, wherein the hole injection layer is selected from a metal halide, a metal oxide, HAT-CN or a composition comprising the p-type dopant of formula (I) or the p-type dopant of formula (II) and a first hole transport matrix compound or a second hole transport matrix compound, wherein the metal in the metal halide or metal oxide may be selected from an alkali metal, alkaline earth metal, transition metal and/or rare earth metal; preferably the metal halide is selected from magnesium fluoride.

According to one embodiment, the organic electroluminescent device may further comprise a hole injection layer, wherein the hole injection layer may comprise the p-type dopant of formula (I) or the p-type dopant formula (II), preferably the hole injection layer comprises one p-type dopant of formula (I) or one p-type dopant of formula (II).

According to one embodiment, the organic electroluminescent device may further comprises a hole injection layer, wherein the hole injection layer comprises the p-type dopant of formula (I), wherein the p-type dopant of formula (I) in the hole injection layer and the p-type dopant of formula (I) in the first p-CGL sub-layer are selected the same of different, preferably the same.

According to one embodiment, wherein the hole injection layer comprises one p-type dopant of formula (I) or one p-type dopant of formula (II); preferably the concentration of the p-type dopant of formula (I) or the p-type dopant of formula (II) in the hole injection layer is lower than the concentration of p-type dopant of formula (I) in the first p-CGL sub-layer and/or the concentration of the p-type dopant of formula (II) in the second p-CGL sub-layer.

According to one embodiment, the organic electroluminescent device may comprises at least two light-emitting units, and at least one charge generation layer, wherein each of the at least one charge generation layer is disposed independently between one set of two adjacent light-emitting units, and wherein the at least two emission layers emit light in the blue region of the spectrum, and wherein the organic electroluminescent device may further comprises a hole injection layer, wherein the hole injection layer may comprise a p-type dopant of formula (I) or a p-type dopant formula (II).

According to one embodiment, the organic electroluminescent device may comprises at least two light-emitting units, and at least one charge generation layer, wherein each of the at least one charge generation layer is disposed independently between one set of two adjacent light-emitting units, and wherein the at least two emission layers emit light in the blue region of the spectrum, and wherein the organic electroluminescent device may further comprises a hole injection layer, wherein the hole injection layer comprises a p-type dopant of formula (I), wherein the p-type dopant of formula (I) in the hole injection layer is selected the same as in the first p-CGL sub-layer.

According to one embodiment, the hole injection layer consists of a single layer consisting of one p-dopant and one hole transport matrix compound, preferably the first hole transport matrix compound.

According to one embodiment, the hole injection layer comprises the p-type dopant of formula (I); more preferred the p-type dopant of formula (I) in the hole injection layer is selected the same as the p-type dopant of formula (I) in the first p-CGL sub-layer.

According to one embodiment, the hole injection layer may comprise a compound of formula (IVa) or (IVb) as described above.

According to one embodiment, the hole injection layer and the first p-CGL sub-layer comprise the same first hole transport matrix compound and the same p-type dopant of formula (I).

According to one embodiment, the hole injection layer and the second p-CGL sub-layer comprise the same second hole transport matrix compound and the same p-type dopant of formula (II).

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

**Hole transport layer**

The organic electroluminescent device according to the present invention may further comprise at least one hole transport layer (HTL), preferably the hole transport layer is in direct contact with the hole injection layer (HIL).

According to one embodiment, the first light-emitting unit comprises a first hole transport layer and the second light-emitting unit comprises a second hole transport layer, preferably the first hole transport layer and the second hole transport layer comprise the same first hole transport matrix compound or second hole transport matrix compound, more preferred the first hole transport matrix compound and the second hole transport matrix compound are selected the same.

A hole transport layer (HTL) may be formed on the HIL or CGL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL or CGL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment, the hole transport layer may comprise a substantially covalent matrix compound as described above.

According to a preferred embodiment, the hole injection layer and the hole transport layer may comprise an identical substantially covalent matrix compound as described above.

According to one embodiment, the hole transport layer may comprise a compound of formula (IVa) or (IVb) as described above.

According to a preferred embodiment, the hole injection layer and the hole transport layer may comprise an identical compound of formula (IVa) or (IVb) as described above.

According to a preferred embodiment, the p-type charge generation layer, the hole injection layer and the hole transport layer may comprise an identical substantially covalent matrix compound.

According to a preferred embodiment, the p-type charge generation layer, the hole injection layer and the hole transport layer may comprise an identical an identical compound of formula (IVa) or (IVb) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

**Electron blocking layer**

The function of an electron blocking layer (EBL) is to prevent electrons from being transferred from an emission

layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

**First and second emission layer (EML)**

The first emission layer and second emission layer may be formed on the HTL by vacuum deposition. The conditions for deposition and coating may be similar to those for the formation of the HIL. However, the conditions for deposition and coating may vary, according to the compound that is used to form the first emission layer and second emission layer.

The first emission layer and second emission layer may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPB1), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp) 3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

According to one embodiment the organic electroluminescent devices comprises at least two emission layers, wherein at least two emission layers emit light in the blue region of the spectrum.

According to a preferred embodiment of the present invention, the first light-emitting unit and/or the second light-emitting unit comprises a light-emitting compound of formula (W):

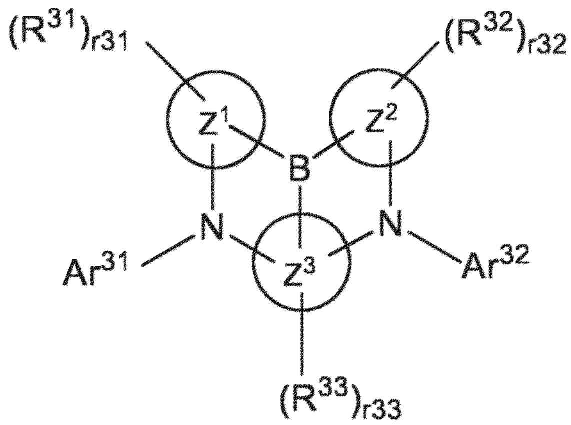

(W),

wherein

$Z^1$, $Z^2$ and $Z^3$ are the same as or different from each other, and are each independently selected from the group comprising a monocyclic to polycyclic aromatic hydrocarbon ring or monocyclic to polycyclic aromatic hetero ring;

$Ar^{31}$ and $Ar^{32}$ are the same as or selected different from each other, and are each independently a substituted or

unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;

$R^{31}$, $R^{32}$ and $R^{33}$ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,

wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;

$r^{31}$, $r^{32}$ and $r^{33}$ are each an integer from 0, 1, 2, 3 or 4, and when $r^{31}$ to $r^{33}$ are 2 or higher, substituents in the parenthesis are the same as or different from each other.

According to one embodiment, for formula (W):

$Z^1$, $Z^2$ and $Z^3$ are the same as or selected different from each other, and are each independently selected from the group comprising a monocyclic to bicyclic aromatic hydrocarbon ring, or a monocyclic to bicyclic aromatic hetero ring containing O, N or S;

$Ar^{31}$ and $Ar^{32}$ are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;

$R^{31}$, $R^{32}$ and $R^{33}$ are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group, or a substituted or unsubstituted heteroaryl group.

According to one embodiment, wherein for formula (W):

$Z^1$, $Z^2$ and $Z^3$ are the same as or selected different from each other, and are each independently selected from the group comprising a benzene ring or a thiophene ring;

$Ar^{31}$ and $Ar^{32}$ are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;

$R^{31}$, $R^{32}$ and $R^{33}$ are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment of the present invention, the first light-emitting unit and/or the second light-emitting unit comprises a light-emitting compound of formula (W) is selected from formulae (BD1) to (BD9):

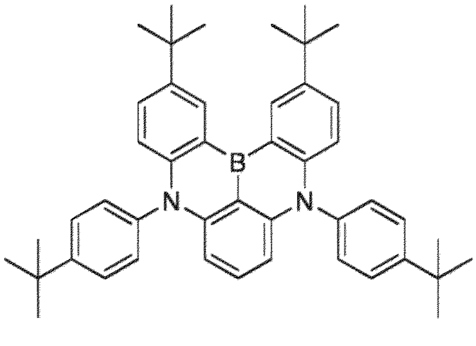
(BD1),

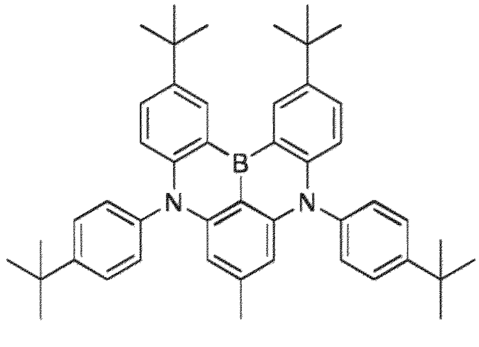
(BD2),

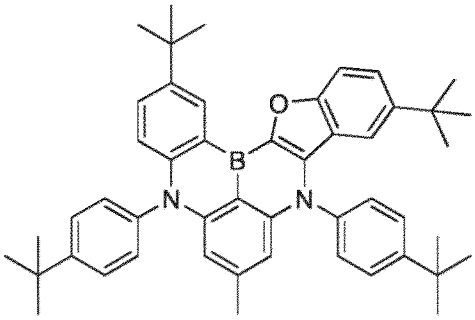
(BD3),

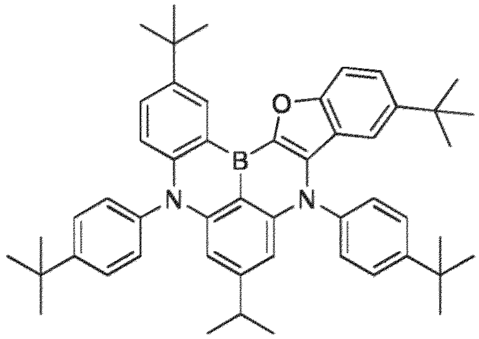
(BD4),

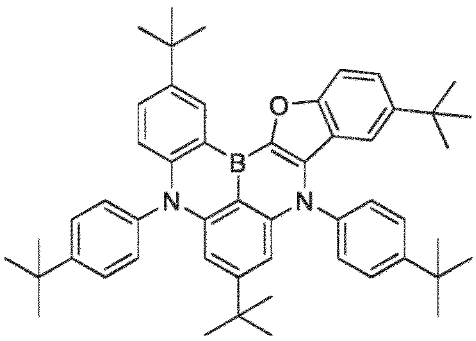
(BD5),

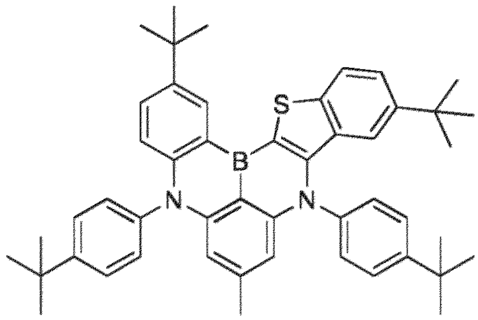
(BD6),

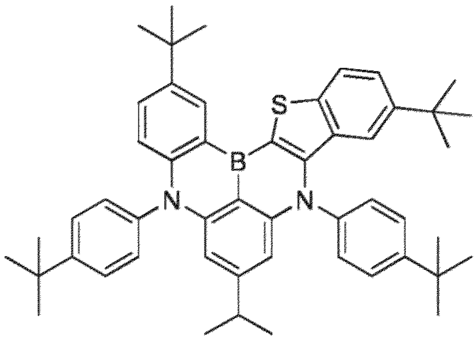
(BD7),

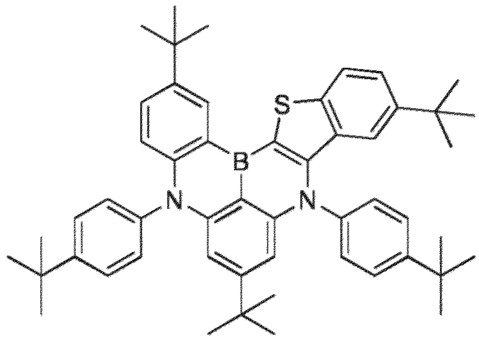
(BD8),

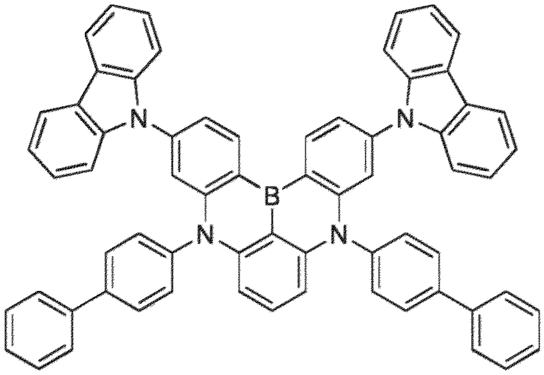

(BD9).

According to a preferred embodiment of the present invention, the first light-emitting unit and/or the second light-emitting unit further comprises an organic emitter host compound, wherein the organic emitter host compound comprises

- at least one condensed aromatic ring system consisting of 3 to 5 rings, and
- 3 to 7 aromatic or heteroaromatic rings, wherein one or more sub-groups of the aromatic and/or heteroaromatic rings may be condensed to form fused aromatic or heteroaromatic ring systems;

wherein the molecular weight Mw of the organic emitter host compound is in the range of ≥ 400 and ≤ 2000 g/mol.

According to a preferred embodiment of the present invention, the organic emitter host compound has the formula (V)

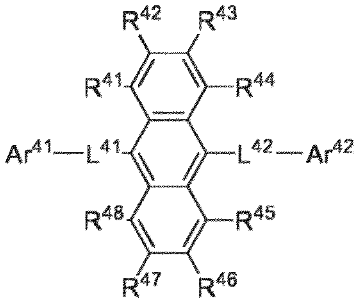

(V),

wherein

$Ar^{41}$ and $Ar^{42}$ are independently selected from substituted or unsubstituted $C_6$ to $C_{24}$ aryl, substituted or unsubstituted $C_3$ to $C_{24}$ heteroaryl;
$L^{41}$ and $L^{42}$ are independently selected from a direct bond or substituted or unsubstituted $C_6$ to $C_{24}$ arylene, substituted or unsubstituted $C_3$ to $C_{24}$ heteroarylene;
$R^{41}$ to $R^{48}$ are independently selected from H, D, substituted or unsubstituted $C_1$ to $C_{12}$ alkyl, substituted or unsubstituted $C_6$ to $C_{19}$ aryl, substituted or unsubstituted $C_3$ to $C_{12}$ heteroaryl;
wherein
the substituents on $Ar^{41}$, $Ar^{42}$, $L^{41}$, $L^{42}$, $R^{41}$ to $R^{48}$ are independently selected from D, $C_6$ to $C_{10}$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, halogen, F or CN.

According to a preferred embodiment of the present invention, the organic emitter host and/or compound of formula (V) is selected from formulae (BH1) to (BH13):

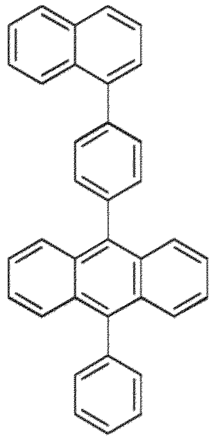 (BH1), 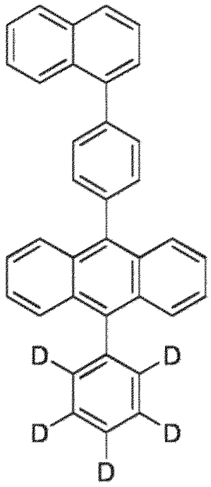 (BH2), 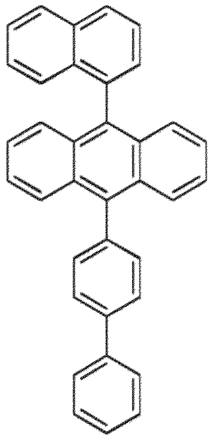 (BH3), 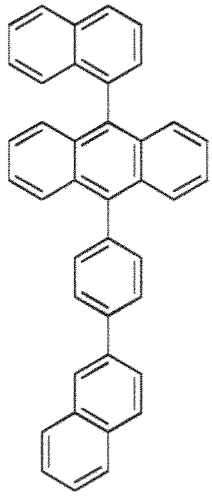 (BH4),

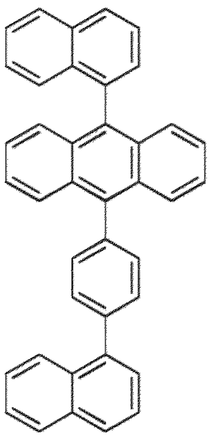 (BH5), 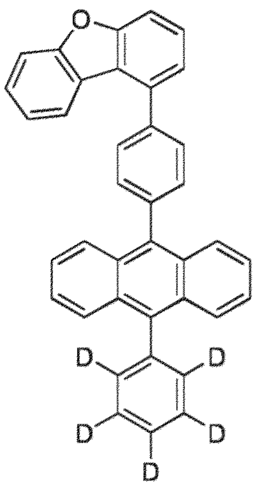 (BH6), 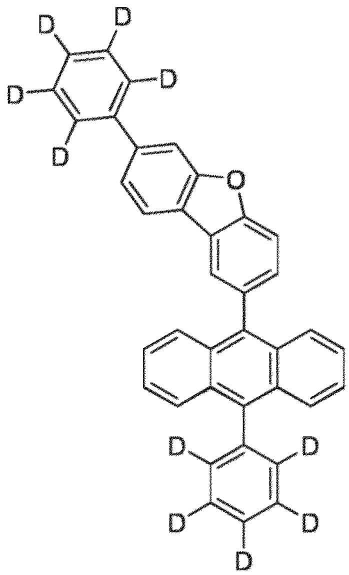 (BH7),

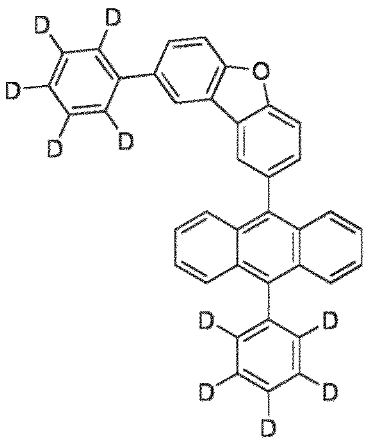 (BH8), 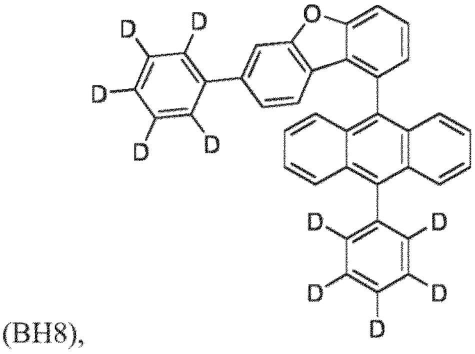 (BH9),

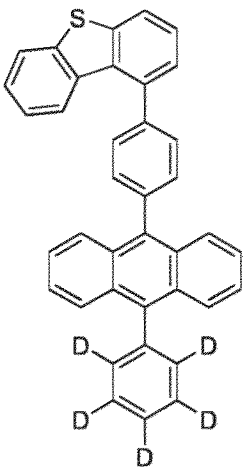
(BH10),

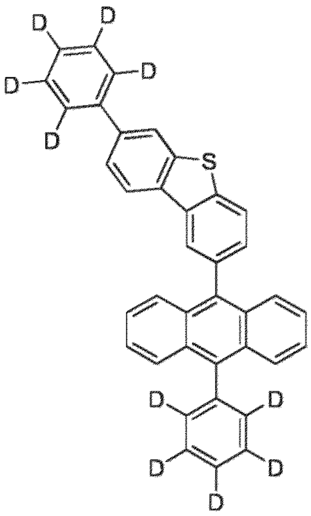
(BH11),

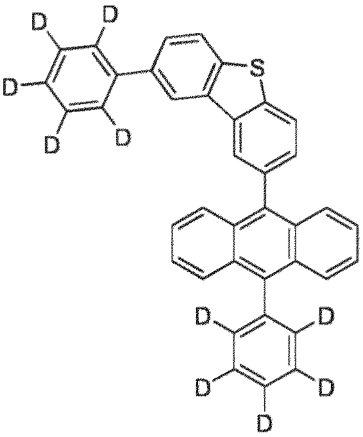
(BH12),

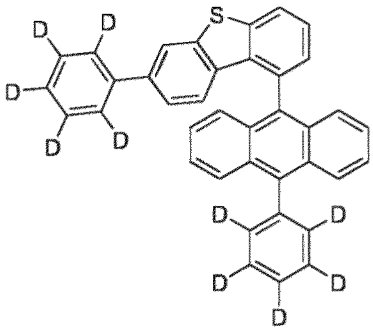
(BH13).

According to a preferred embodiment of the present invention, the first light-emitting unit and/or second light-emitting unit comprises a light-emitting dopant of formula (W) and an organic emitter host of formula (V); preferably the light-emitting dopant of formula (W) and the organic emitter host of formula (V) in the first light-emitting unit and in the second light-emitting unit are selected the same.

According to a preferred embodiment of the present invention, the first light-emitting unit comprises a first emission layer comprising a light-emitting dopant of formula (W) and an organic emitter host of formula (V); and the second light-emitting unit comprises a second emission layer comprising a light-emitting dopant of formula (W) and an organic emitter host of formula (V); preferably the light-emitting dopant of formula (W) and the organic emitter host of formula (V) in the first emission layer and in the second emission layer are selected the same.

The amount of the emitter dopant may be in the range from about 1 to about 50 parts by weight, based on 100 parts by weight of the host. The first emission layer and second emission layer may have a thickness of about 10 nm to about 40 nm, for example, from about 20 nm to about 30 nm. When the thickness of the first emission layer and second emission layer is within this range, the organic electroluminescent device may have excellent light emission, without a substantial penalty in driving voltage.

**Hole blocking layer (HBL)**

A hole blocking layer (HBL) may be formed on the emission layer (EML), by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of

compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

**Electron transport layer (ETL)**

The organic electroluminescent device may further comprise at least one electron transport layer (ETL).

According to one embodiment the organic electroluminescent device, wherein the organic electroluminescent device further comprises a first electron transport layer, wherein the first electron transport layer is in direct contact with the first n-type charge generation layer, preferably the first electron transport layer is in direct contact with the first emission layer.

According to one embodiment, the at least one electron transport layer is comprised in one of the at least two light-emitting units, wherein preferably at least one electron transport layer is comprised in each light-emitting unit.

According to another embodiment, the electron transport layer may further comprise an azine compound, preferably a pyridine, pyrimidine or triazine compound, and most preferably a triazine compound or a pyrimidine compound.

According to another embodiment, the electron transport layer may further comprise 2-([1,1'-biphenyl]-4-yl)-4-(9,9-diphenyl-9H-fluoren-4-yl)-6-phenyl-1,3,5-triazine, 2-(3-(2,6-dimethylpyridin-3-yl)-5-(phenanthren-9-yl)phenyl)-4,6-diphenyl-1,3,5-triazine, 3'-(4-phenyl-6-(spiro[fluorene-9,9'-xanthen]-2'-yl)-1,3,5-triazin-2-yl)-[1,1'-biphenyl]-4-carbonitrile, and 4'-(4-(4-(4,6-diphenyl-1,3,5-triazin-2-yl)phenyl)naphthalen-1-yl)-[1,1 '-biphenyl]-4-carbonitrile.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the ETL is within this range, the ETL may have satisfactory electron-injecting properties, without a substantial penalty in driving voltage.

According to another embodiment, the organic electronic device may further comprise a hole blocking layer and an electron transport layer, wherein the hole blocking layer and the electron transport layer comprise an azine compound. Preferably, the azine compound is a pyridine, pyrimidine or triazine compound, and most preferably a triazine compound.

**Electron injection layer (EIL)**

An optional EIL, which may facilitates injection of electrons from the cathode, may be formed on the ETL preferably closest to the cathode, and more preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

**Cathode layer**

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

In a preferred embodiment, the cathode layer comprises a metal or metal alloy and is transparent.

It is to be understood that the cathode layer is not part of an electron injection layer or the electron transport layer.

**Organic electroluminescent device**

According to one embodiment of the invention, the electronic organic device is an organic light emitting diode.

According to a preferred embodiment of the invention, the organic electroluminescent device is an organic light emitting diode, wherein light is emitted through the cathode layer.

**Electronic device**

The present invention furthermore relates to an organic electroluminescent device, wherein the electronic device is preferably a display device.

**Method of preparing an organic electroluminescent device**

According to one embodiment, the organic electroluminescent device is prepared by performing the following steps:

- Deposition of the first light-emitting unit on the anode layer;
- Deposition of the charge generation layer on the first light-emitting unit; wherein the n-type charge generation layer is deposited on the first light-emitting unit, the first p-type charge generation layer is deposited on the n-type charge generation layer; and the second p-type charge generation layer is deposited on the first p-type charge generation layer;
- Deposition of the second light-emitting unit on the charge generation layer;
- Deposition of the cathode layer on the second light-emitting unit.

According to one embodiment, the organic electroluminescent device further comprises a hole injection layer and the device is prepared by performing the following steps:

- Deposition of the hole injection layer on the anode layer;
- Deposition of the first light-emitting unit on the hole injection layer;
- Deposition of the charge generation layer on the first light-emitting unit; wherein the n-type charge generation layer is deposited on the first light-emitting unit, the first p-type charge generation layer is deposited on the n-type charge generation layer; and the second p-type charge generation layer is deposited on the first p-type charge generation layer;
- Deposition of the second light-emitting unit on the charge generation layer;
- Deposition of the cathode layer on the second light-emitting unit.

**Description of the Drawings**

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic electroluminescent device according to an exemplary embodiment.

FIG. 2 is a schematic sectional view of an organic electroluminescent device according to another exemplary embodiment.

FIG. 3 is a schematic sectional view of an organic electroluminescent device according to another exemplary embodiment.

FIG. 4 is a schematic sectional view of an organic electroluminescent device according to another exemplary embodiment.

Hereinafter, the figures are illustrated in more detail with reference to examples. However, the present disclosure is not limited to the following figures.

Herein, when a first element is referred to as being formed or disposed "on" or "onto" a second element, the first

element can be disposed directly on the second element, or one or more other elements may be disposed there between. When a first element is referred to as being formed or disposed "directly on" or "directly onto" a second element, no other elements are disposed there between.

Fig. 1 is a schematic sectional view of an organic electroluminescent device 100, according to an exemplary embodiment.

Referring to Fig. 1, the organic electroluminescent device 100 includes a substrate 110, an anode layer 120; a first light-emitting unit 140; a charge transport layer 160, wherein the charge transport layer 160 (CGL) comprises a n-type charge generation layer (n-CGL) 161 and a p-type charge generation layer (p-CGL) 162, wherein the p-type charge generation layer (p-CGL) 162 comprises a first p-type charge generation sub-layer (p-CGL1) 162a and a second p-type charge generation sub-layer (p-CGL2) 162b; a second light-emitting unit 240 and a cathode layer 190.

Fig. 2 is a schematic sectional view of an organic electroluminescent device 100, according to another exemplary embodiment.

Referring to Fig. 2, the organic electroluminescent device 100 includes a substrate 110, an anode layer 120; a hole injection layer (HIL) 130; a first light-emitting unit 140; a charge transport layer 160 (CGL), wherein the charge transport layer 160 comprises a n-type charge generation layer (n-CGL) 161 and a p-type charge generation layer (p-CGL) 162, wherein the p-type charge generation layer (p-CGL) 162 comprises a first p-type charge generation sub-layer (p-CGL1) 162a and a second p-type charge generation sub-layer (p-CGL2) 162b; a second light-emitting unit 240 and a cathode layer 190.

Fig. 3 is a schematic sectional view of an organic electroluminescent device 100, according to another exemplary embodiment.

Referring to Fig. 3, the organic electroluminescent device 100 includes a substrate 110, an anode layer 120; a hole injection layer (HIL) 130; a first light-emitting unit 140, wherein the first light-emitting unit comprises a first hole transport layer (HTL1) 141, an optional first electron blocking layer (EBL1) 142, a first emission layer (EML1) 145, an optional first hole blocking layer (HBL1) 147, a first electron transport layer (ETL1) 149; a charge transport layer 160 (CGL), wherein the charge transport layer 160 (CGL) comprises a n-type charge generation layer (n-CGL) 161 and a p-type charge generation layer (p-CGL) 162, wherein the p-type charge generation layer (p-CGL) 162 comprises a first p-type charge generation sub-layer (p-CGL1) 162a and a second p-type charge generation sub-layer (p-CGL2) 162b; a second light-emitting unit 240, wherein the second light-emitting unit 240 comprises a second hole transport layer (HTL2) 241, an optional second electron blocking layer (EBL2) 242, a second emission layer (EML2) 245, an optional second hole blocking layer (HBL2) 247, a second electron transport layer (ETL2) 249; an electron injection layer (EIL) 180 and a cathode layer 190.

Fig. 4 is a schematic sectional view of an organic electroluminescent device 100, according to another exemplary embodiment.

Referring to Fig. 4, the organic electroluminescent device 100 includes a substrate 110, an anode layer 120; a hole injection layer (HIL) 130; a first light-emitting unit 140, wherein the first light-emitting unit comprises a first hole transport layer (HTL1) 141, an optional first electron blocking layer (EBL1) 142, a first emission layer (EML1) 145, an optional first hole blocking layer (HBL1)147, a first electron transport layer (ETL1) 149; a charge transport layer 160 (CGL), wherein the charge transport layer 160 (CGL) comprises a n-type charge generation layer (n-CGL) 161 and a p-type charge generation layer (p-CGL) 162, wherein the p-type charge generation layer 162 comprises a first p-type charge generation sub-layer (p-CGL1) 162a and a second p-type charge generation sub-layer (p-CGL2) 162b; a second light-emitting unit 240, wherein the second light-emitting unit 240 comprises a second hole transport layer (HTL2) 241, an optional second electron blocking layer (EBL2) 242, a second emission layer (EML2) 245, an optional second hole blocking layer (HBL2) 247, a second electron transport layer (ETL2) 249; a second charge transport layer 260 (CGL), wherein the second charge transport layer 260 (CGL) comprises a second n-type charge generation layer (n-CGL) 261, a second p-type charge generation layer (p-CGL) 262, wherein the second p-type charge generation layer (p-CGL) 262 comprises a first p-type charge generation layer (p-CGL1) 262a and a second p-type charge generation layer (p-CGL2) 262b; a third light-emitting unit 340, wherein the third light-emitting unit 340 comprises a third hole transport layer (HTL3) 341, an optional third electron blocking layer (EBL3) 342, a third emission layer (EML3) 345, an optional third hole blocking layer (HBL3) 347, a third electron transport layer (ETL3) 349; an electron injection layer (EIL) 180 and a cathode layer 190.

While not shown in Fig. 1, 2, 3 and 4 a capping and/or a sealing layer may further be formed on the cathode layer 190, in order to seal the organic electronic device 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

## Experimental data

The p-type dopants of formula (I), p-type dopants of formula (II), first hole transport matrix compounds, second

hole transport matrix compounds, n-CGL matrix compounds and further auxiliary compounds may be prepared by methods known in the art.

### HOMO and LUMO energy of p-type dopants of formula (I) and p-type dopants of formula (II)

The HOMO and LUMO energy levels of p-type dopants of formula (I) and p-type dopants of formula (II) in Tables 1 and 2 are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). The HOMO and LUMO energy levels of the molecular structures are determined by applying the hybrid functional B3LYP with a Def2-TZVP basis set from the optimized geometries obtained by applying the HF3c composite method (Hartree Fock based 3C composite method with minimal basis set, gCP and D3(BJ)). All the calculations were performed in the gas phase. If more than one conformation is viable, the conformation with the lowest total energy is selected.

### Energy gap $E_{gap}$ of p-type dopants of formula (I) and p-type dopants of formula (II)

To calculate the energy gap $E_{gap}$ in Tables 2 and 3, in a first step the HOMO and LUMO are determined by the method described above.

In a second step, the absolute value of the LUMO is subtracted from the absolute value of the HOMO.

The larger the energy gap, the more blue-shifted is the absorption spectrum of the compound. Without being bound by theory, if the absorption spectrum is shifted to shorter wavelengths the compound may absorb less light in the visible region of the spectrum. This may be beneficial especially for organic electroluminescent devices comprising several emission layers, wherein one or more emission layers emits blue light. Thereby, less light may be absorbed by the charge generation layer and improved efficiency of the organic electroluminescent may be obtained.

### General procedure for fabrication of OLEDs

For the examples according to the invention and comparative examples in Table 3, a glass substrate with an anode layer comprising a first anode sub-layer of 10 nm ITO, a second anode sub-layer of 120 nm Ag and a third anode sub-layer of 8 nm ITO was cut to a size of 100 mm x 100 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, a hole injection layer (HIL) having a thickness of 10 nm is formed on the anode layer by co-depositing in vacuum 99 vol.-% N-([1,1'-biphenyl]-4-yl)-9,9-dimethyl-N-(4-(9-phenyl-9H-carbazol-3-yl)phenyl)-9H-fluoren-2-amine (U3) as first hole transport matrix compound (HTMC1) and 1 vol.-% p-type dopant of formula (I) C1.

Then N-([1,1'-biphenyl]-4-yl)-9,9-dimethyl-N-(4-(9-phenyl-9H-carbazol-3-yl)phenyl)-9H-fluoren-2-amine (U3) was vacuum deposited on the hole injection layer to form a first hole transport layer (HTL) having a thickness of 29 nm

Then N,N-di([1,1'-biphenyl]-4-yl)-3'-(9H-carbazol-9-yl)-[1,1'-biphenyl]-4-amine was vacuum deposited on the HTL, to form a first electron blocking layer (EBL1) having a thickness of 5 nm.

Then, a first emission layer (EML1) having a thickness of 19 nm is formed on the EBL1 by co-depositing 99 vol.-% Dibenzofuran, 7-(phenyl-2 ,3 ,4 ,5 ,6 -d )-1-[10-(phenyl-2 ,3 ,4 ,5 ,6 -d )-9-anthracenyl] [CAS 2457172-82-4] as EML host and 1 vol.-% 5H ,9H - [1]Benzothieno[2',3':5,6][1,4]azaborino[2,3,4-kl ]phenazaborine, 2,7,11-tris(1,1-dimethylethyl)-5,9-bis[4-(1,1-dimethylethyl)phenyl] [CAS 2482607-57-6] as blue dopant.

Then, (3-(10-(3-(2,6-diphenylpyrimidin-4-yl)phenyl)anthracen-9-yl)phenyl) dimethylphos-phine oxide was vacuum deposited on the EML1, to form a first electron transport layer (ETL1) having a thickness of 15 nm.

Then a n-type charge generation layer (n-CGL) having a thickness of 7.5 nm is formed on the first electron transport layer (ETL1) by co-depositing 98 vol.-% 2,2'-(1,3-Phenylene)bis[9-phenyl-1,10-phenanthroline] (MX-1) as n-CGL matrix compound and 2 vol.-% Yb as metal dopant.

Then, the p-type charge generation layer (p-CGL) is formed on the n-type CGL in two steps.

In a first step, the first p-type charge generation sub-layer (p-CGL1) is formed on the n-type CGL. The composition and thickness can be seen in Table 3.

In a second step, the second p-type charge generation sub-layer (p-CGL2) is formed on the first p-type charge generation sub-layer (p-CGL1). The composition and thickness can be seen in Table 3.

Then a second hole transport layer (HTL2) having a thickness of 43 nm is formed on the p-type charge generation layer by depositing N-(9,9-diphenyl-9H-fluoren-2-yl)-N,9-diphenyl-9H-carbazol-2-amine (U18).

Then a second electron blocking layer (EBL2) having a thickness of 5 nm is formed on the second hole transport layer by depositing N,N-di([1,1'-biphenyl]-4-yl)-3'-(9H-carbazol-9-yl)-[1,1'-biphenyl]-4-amine.

Then, a second emission layer (EML2) having a thickness of 19 nm is formed on the EBL2 by co-depositing 99

vol.-% Dibenzofuran, 7-(phenyl-2 ,3 ,4 ,5 ,6 -d )-1-[10-(phenyl-2 ,3 ,4 ,5 ,6 -d )-9-anthracenyl] [CAS 2457172-82-4] as EML host and 1 vol.-% 5H ,9H - [1]Benzothieno[2',3':5,6][1,4]azaborino[2,3,4-kl ]phenazaborine, 2,7,11-tris(1,1-dimethylethyl)-5,9-bis[4-(1,1-dimethylethyl)phenyl] [CAS 2482607-57-6] as blue dopant.

Then, a first hole blocking layer (HBL1) having a thickness of 5 nm is formed on the EML2 by depositing compound 4-([1,1'-biphenyl]-4-yl)-6-(3'-(9,9-dimethyl-9H-fluoren-4-yl)-[1,1'-biphenyl]-4-yl)-2-phenylpyrimidine (N-14).

Then, a second electron transport layer (ETL2) having a thickness of 31 nm is formed on the HBL1 by co-depositing compound 6,6'-(naphthalene-1,2-diylbis(4,1-phenylene))bis(2,4-diphenyl-1,3,5-triazine) (N-15) and LiQ in a ratio of 50:50 wt.-%.

Then Yb was evaporated at a rate of 0.01 to 1 Å/s at $10^{-7}$ mbar to form an electron injection layer (EIL) with a thickness of 1.3 nm on the second electron transporting layer.

Ag/Mg (10 vol.-%) is evaporated at a rate of 0.01 to 1 Å/s at $10^{-7}$ mbar to form a cathode layer with a thickness of 13 nm on the electron injection layer.

Then, N-([1,1'-biphenyl]-4-yl)-9,9-dimethyl-N-(4-(9-phenyl-9H-carbazol-3-yl)phenyl)-9H-fluoren-2-amine (U3) was vacuum deposited on the cathode layer to form a capping layer with a thickness of 75 nm.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m$^2$ using an Instrument Systems CAS-140CT array spectrometer (calibrated by Deutsche Akkreditierungsstelle (DAkkS)) for each of the voltage values. The cd/A efficiency at 10 mA/cm$^2$ is determined by interpolating the luminance-voltage and current-voltage characteristics, respectively.

The efficiency CEff/CIE-y is determined by dividing the cd/A efficiency by the CIE-y coordinate. Thereby, the efficiency is corrected by the colour coordinate CIE-y.

In bottom emission devices, the emission is predominately Lambertian and quantified in percent external quantum efficiency (EQE). To determine the efficiency EQE in % the light output of the device is measured using a calibrated photodiode at 10 mA/cm$^2$.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 10 mA/cm$^2$.

Lifetime LT of the device is measured at ambient conditions (20°C) and 30 mA/cm$^2$, using a Keithley 2400 source meter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours.

$$\Delta U=[U100\ h)-\ U(1h)].$$

The smaller the value of ΔU the better is the operating voltage stability.

**General method for determining the sheet resistance of the charge generation layer**

The sheet resistance of the charge generation layer, also named "CGL-Rs", is determined in giga Ohm per square (GΩ/sq).

The sheet resistance Rs may be determined via the transfer length method. The measurement may be conducted by methods known in the art or as described in WO2022263524A1.

For the examples according to the invention and comparative examples in Table 3, the Rs is determined of three different devices and the result extrapolated to obtain the Rs of one charge generation layer consisting of one n-type charge generation layer and one p-type charge generation layer. Unless noted otherwise, the CGL-Rs data in Table 3 are provided for the layer arrangement n-CGL/p-CGL2.

In a first step, three devices are prepared:

- Device 1 comprises one charge generation layer comprising one n-type charge generation layer (n-CGL) and one p-type charge generation layer (p-CGL). The number of interfaces between n-CGL and p-CGL is one.
- Device 2 comprises two charge generation layers comprising one n-type charge generation layer and one p-type charge generation layer (p-CGL) each. The number of interfaces between n-CGL and p-CGL is three.

- Device 3 comprises three charge generation layers comprising one n-type charge generation layer and one p-type charge generation layer (p-CGL) each. The number of interfaces between n-CGL and p-CGL is five.

In a second step, the sheet resistance Rs is determined for each device by using the transfer length method.
In a third step, 1/Rs is plotted against the number of interfaces between n-CGL and p-CGL. A linear fit results in 1/Rs for a single charge generation layer.
The higher the sheet resistance of the charge generation layer, the lower is the current flow between adjacent pixels. Thereby, individual pixels in an electronic device can be addressed without adjacent pixels lighting up. Thereby, the so-called pixel crosstalk may be reduced.

**Method for preparation of Devices 1, 2 and 3**

The anode layer is prepared as described above for organic electroluminescent devices.
For Device 1, p-dopant of formula (II) and second hole transport matrix compound are co-deposited in vacuum on the anode layer to form a p-type charge generation layer (p-CGL) having a thickness of 20 nm. The composition can be seen in Table 3. 2 vol.-% Yb and 92 vol.-% MX-1 are co-deposited in vacuum on the p-CGL to form a n-type charge generation layer (n-CGL) having a thickness of 15 nm. A protective electron transport layer (pETL) is formed on the n-CGL by depositing 100 nm 2,4-diphenyl-6-(4',5',6'-triphenyl-[1,1':2',1":3",1‴:3‴,1⁗-quinquephenyl]-3⁗-yl)-1,3,5-triazine in vacuum. A protective hole transport layer (pHTL) is formed on the pETL by depositing 20 nm U18 in vacuum. A protective metal layer is formed on the pHTL by depositing 100 nm Al in vacuum.
For Device 2, p-type dopant of formula (II) and second hole transport matrix compound are co-deposited in vacuum on the anode layer to form a first p-type charge generation layer (p-CGL-1) having a thickness of 20 nm. The composition can be seen in Table 3. 2 vol.-% Yb and 92 vol.-% MX-1 are co-deposited in vacuum on the p-CGL-1 to form a first n-type charge generation layer (n-CGL-1) having a thickness of 15 nm. P-type dopant of formula (IIa) and (IIb) and second hole transport matrix compound are co-deposited in vacuum on the n-CGL-1 to form a second p-type charge generation layer (p-CGL-2) having a thickness of 20 nm. 2 vol.-% Yb and 92 vol.-% MX-1 are co-deposited in vacuum on the p-CGL-2 to form a second n-type charge generation layer (n-CGL-2) having a thickness of 15 nm. A protective electron transport layer (pETL) is formed on the n-CGL-2 by depositing 100 nm 2,4-diphenyl-6-(4',5',6'-triphenyl-[1,1':2',1":3",1‴:3‴,1⁗-quinquephenyl]-3""-yl)-1,3,5-triazine in vacuum. A protective hole transport layer (pHTL) is formed on the pETL by depositing 20 nm U18 in vacuum. A protective metal layer is formed on the pHTL by depositing 100 nm Al in vacuum.
For Device 3, p-dopant of formula (II) and second hole transport matrix compound are co-deposited in vacuum on the anode layer to form a first p-type charge generation layer (p-CGL-1) having a thickness of 20 nm. The composition can be seen in Table 3. 2 vol.-% Yb and 92 vol.-% MX-1 are co-deposited in vacuum on the p-CGL-1 to form a first n-type charge generation layer (n-CGL-1) having a thickness of 15 nm. p-dopant of formula (IIa) and (IIb) and second hole transport matrix compound are co-deposited in vacuum on the n-CGL1 to form a second p-type charge generation layer (p-CGL-2) having a thickness of 20 nm. 2 vol.-% Yb and 92 vol.-% MX-1 are co-deposited in vacuum on the p-CGL2 to form a second n-type charge generation layer (n-CGL2) having a thickness of 15 nm. p-dopant of formula (IIa) and (IIb) and second hole transport matrix compound are co-deposited in vacuum on the n-CGL2 to form a third p-type charge generation layer (p-CGL3) having a thickness of 20 nm. 2 vol.-% Yb and 92 vol.-% MX-1 are co-deposited in vacuum on the p-CGL3 to form a third n-type charge generation layer (n-CGL3) having a thickness of 15 nm. A protective electron transport layer (pETL) is formed on the n-CGL2 by depositing 100 nm 2,4-diphenyl-6-(4',5',6'-triphenyl-[1,1':2',1":3",1‴:3‴,1⁗-quinquephenyl]-3⁗-yl)-1,3,5-triazine in vacuum. A protective hole transport layer (pHTL) is formed on the pETL by depositing 20 nm U18 in vacuum. A protective metal layer is formed on the pHTL by depositing 100 nm Al in vacuum.

**Technical Effect of the invention**

In Table 1 are shown the LUMO energy and energy gap $E_{gap}$ of p-type dopants of formula (I) and comparative compound 1 (CC-1).

Table 1: Properties of p-type dopants of formula (I) and comparative compounds

| Referred to as: | Structure | LUMO (eV) | $E_{gap}$ (eV) |
|---|---|---|---|
| Comparative compound 1 (CC-1) | 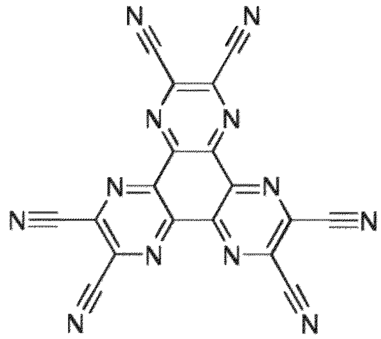 | -4.74 | 4.35 |
| C1 | 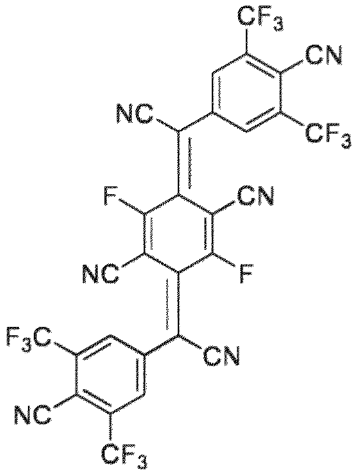 | -5.06 | 3.05 |
| C2 | 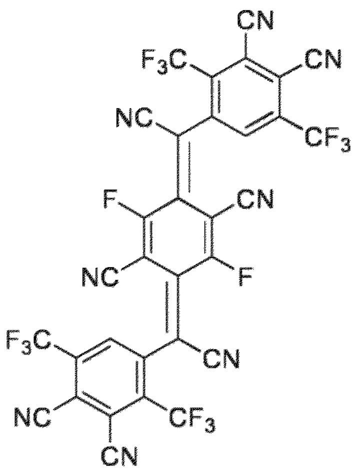 | -5.21 | 3.24 |

(continued)

| Referred to as: | Structure | LUMO (eV) | $E_{gap}$ (eV) |
|---|---|---|---|
| C3 | 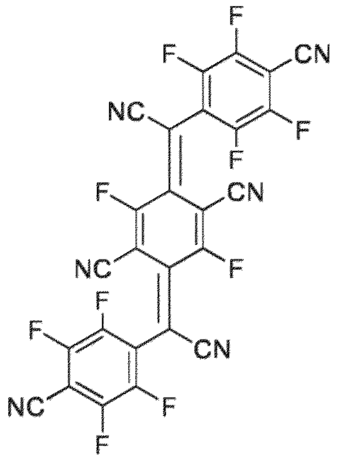 | -5.06 | 3.03 |
| C4 | 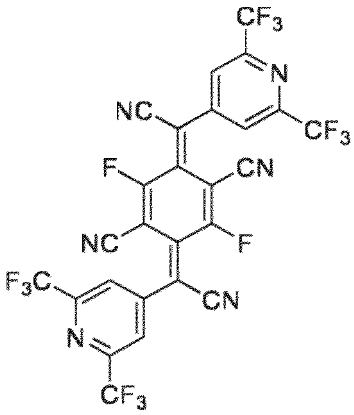 | -5.10 | 3.03 |
| C5 | 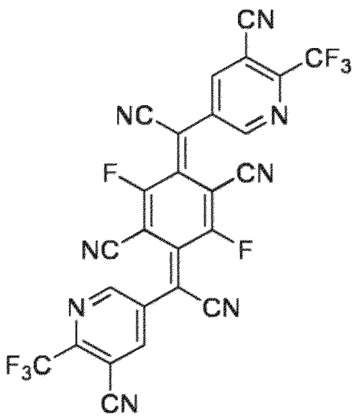 | -5.04 | 3.12 |

(continued)

| Referred to as: | Structure | LUMO (eV) | $E_{gap}$ (eV) |
|---|---|---|---|
| C6 | 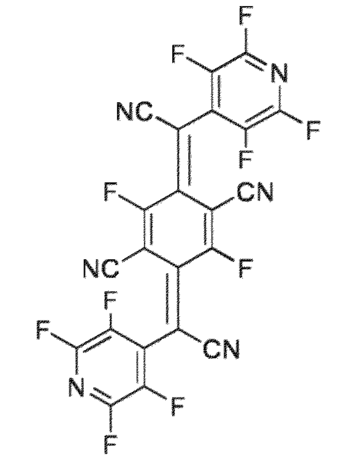 | -4.98 | 2.86 |
| C7 | 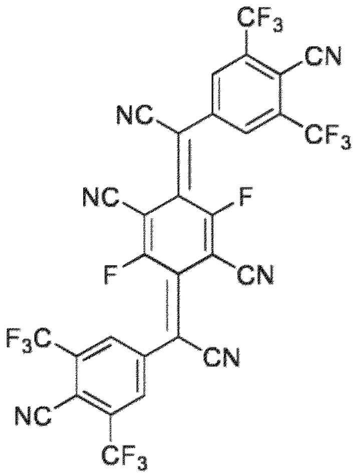 | -5.04 | 3.13 |
| C8 | 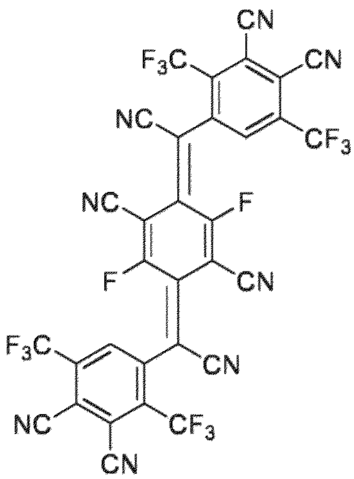 | -5.18 | 3.29 |

(continued)

| Referred to as: | Structure | LUMO (eV) | $E_{gap}$ (eV) |
|---|---|---|---|
| C9 | 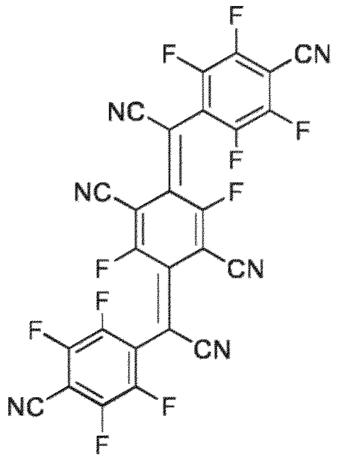 | -4.96 | 3.20 |
| C10 | 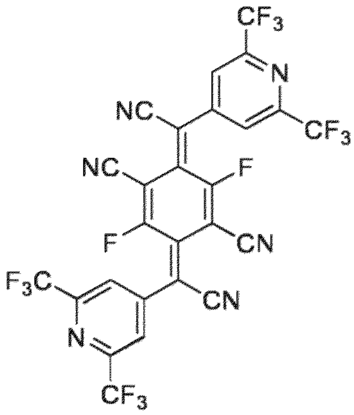 | -5.11 | 3.02 |
| C11 | 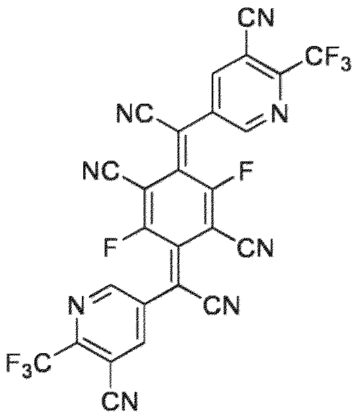 | -5.04 | 3.17 |

(continued)

| Referred to as: | Structure | LUMO (eV) | $E_{gap}$ (eV) |
|---|---|---|---|
| C12 | 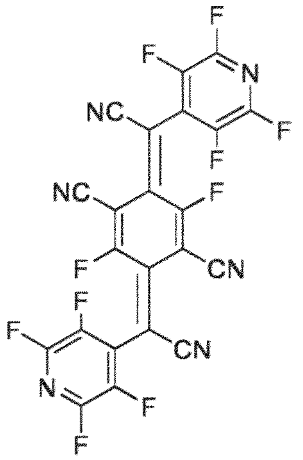 | -4.98 | 2.96 |
| C13 | 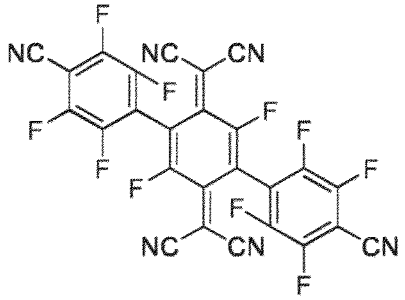 | -5.27 | 2.86 |
| C14 | 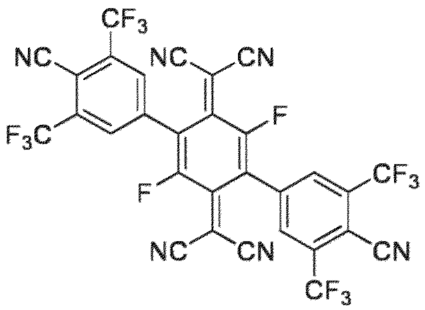 | -5.31 | 2.99 |
| C15 | 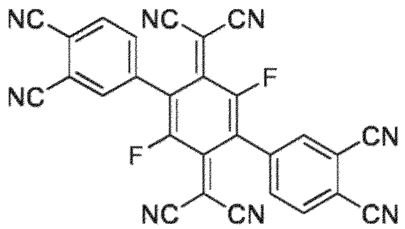 | -5.23 | 2.98 |
| C16 | 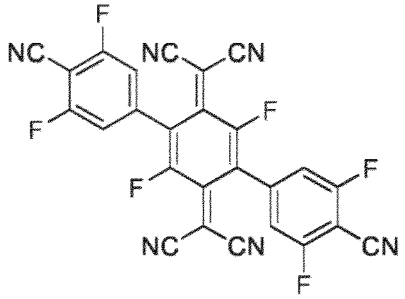 | -5.13 | 2.94 |

(continued)

| Referred to as: | Structure | LUMO (eV) | $E_{gap}$ (eV) |
|---|---|---|---|
| C17 | 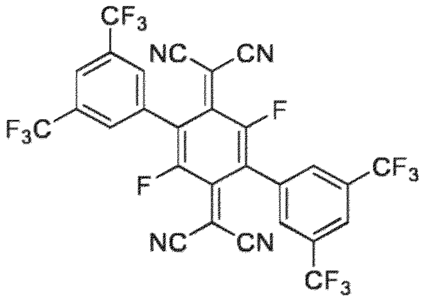 | -4.92 | 3.01 |
| C18 | 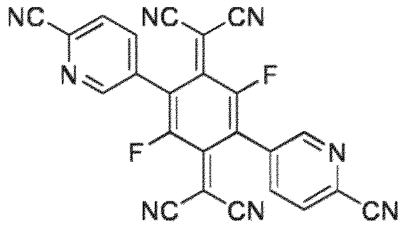 | -5.07 | 2.95 |
| C19 | 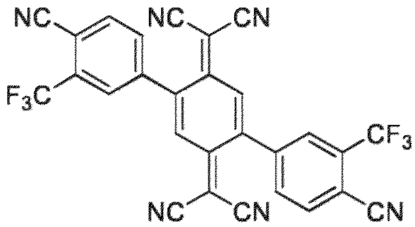 | -5.00 | 2.95 |
| C20 | 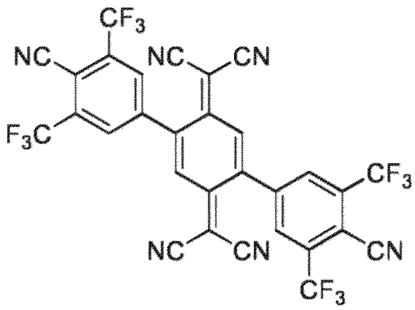 | -5.22 | 2.98 |
| C21 | 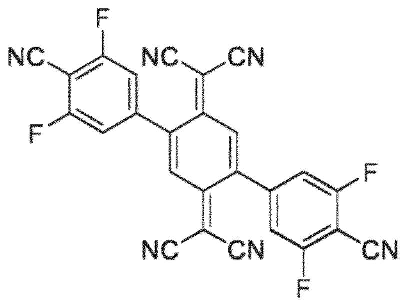 | -5.04 | 2.94 |

(continued)

| Referred to as: | Structure | LUMO (eV) | $E_{gap}$ (eV) |
|---|---|---|---|
| C22 | 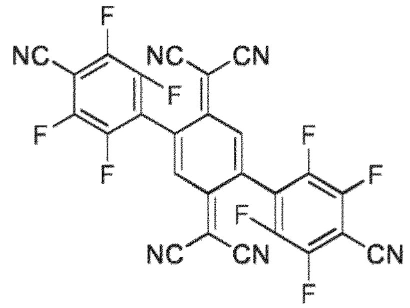 | -5.15 | 2.91 |
| C23 | 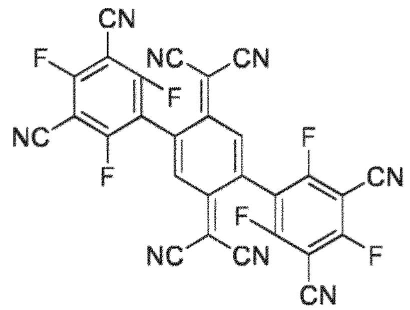 | -5.35 | 2.98 |
| C24 | 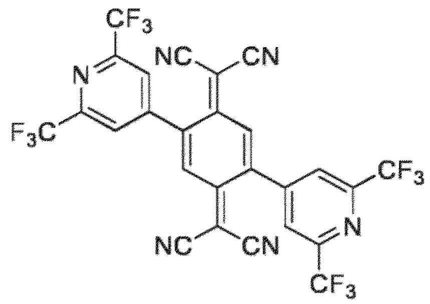 | -5.18 | 3.06 |
| C25 | 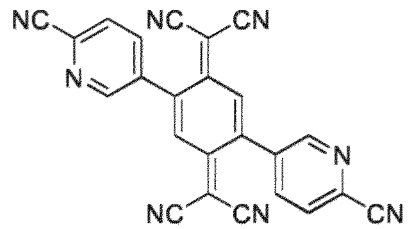 | -4.99 | 2.95 |
| C26 | 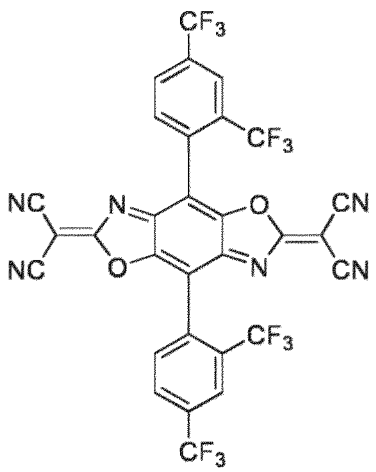 | -5.11 | 2.61 |

(continued)

| Referred to as: | Structure | LUMO (eV) | $E_{gap}$ (eV) |
|---|---|---|---|
| C27 | 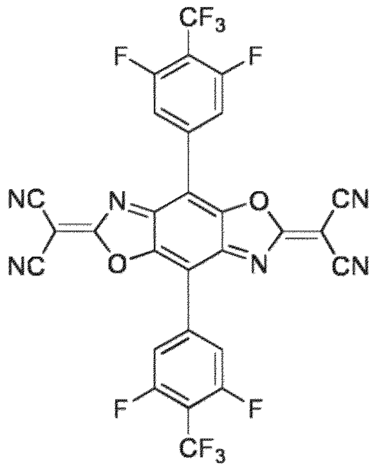 | -5.42 | 2.43 |
| C28 | 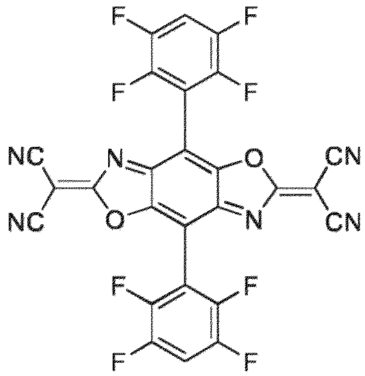 | -5.11 | 2.44 |
| C29 | 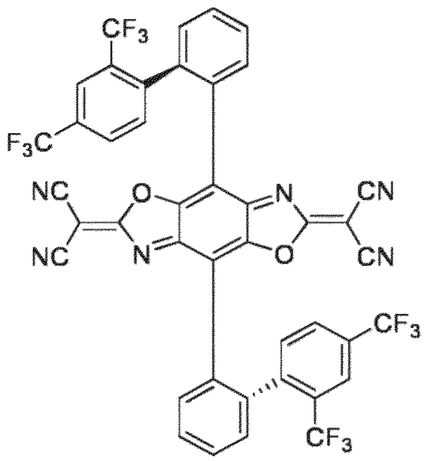 | -4.81 | 2.52 |

(continued)

| Referred to as: | Structure | LUMO (eV) | $E_{gap}$ (eV) |
|---|---|---|---|
| C30 | 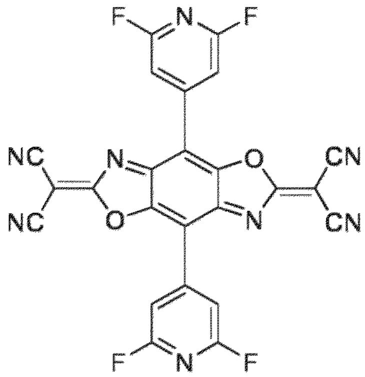 | -5.48 | 2.45 |

Comparative compound 1 (CC-1), also named HAT-CN, is a state of the art compound used in the p-type charge generation layer. In comparative compound 1 (CC-1), the LUMO is -4.74 eV. The energy gap $E_{gap}$ is 4.35 eV.

For p-type dopants of formula (I), the LUMO is improved to ≤ -4.8 eV and ≥ -6 eV. Thereby, improved generation of positive charges in the p-type charge generation layer and improved operating voltage may be obtained.

The energy gap $E_{gap}$ of p-type dopants of formula (I) is in a range suitable for use in organic electroluminescent devices, in particular organic electroluminescent devices which emit light in the blue region of the spectrum.

In Table 2 are shown the LUMO energy and energy gap $E_{gap}$ of p-type dopants of formula (II) and comparative compound 1 (CC-1).

Table 2: Properties of p-type dopants of formula (II) and comparative compound

| Referred to as: | Structure | LUMO (eV) | $E_{gap}$ (eV) |
|---|---|---|---|
| Comparative compound 1 (CC-1) | 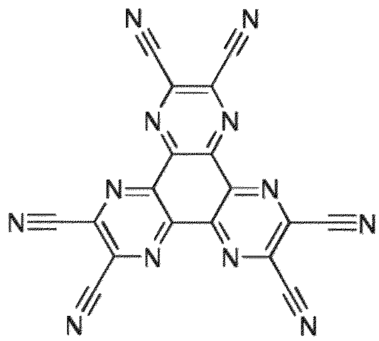 | -4.74 | 4.35 |
| F1 | 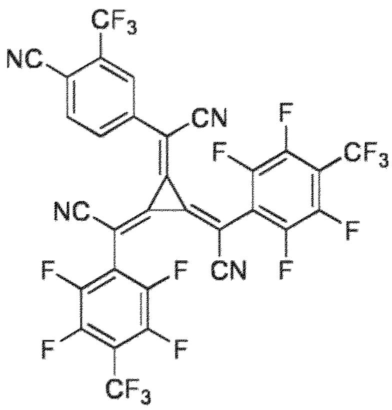 | -4.97 | 2.83 |

(continued)

| Referred to as: | Structure | LUMO (eV) | $E_{gap}$ (eV) |
|---|---|---|---|
| F2 | 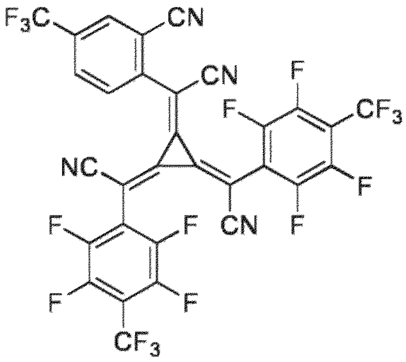 | -4.81 | 2.88 |
| F3 | 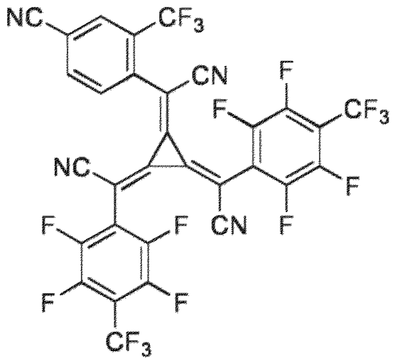 | -4.86 | 2.94 |
| F4 | 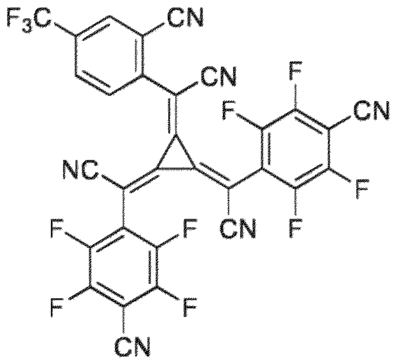 | -5.00 | 2.95 |
| F5 | 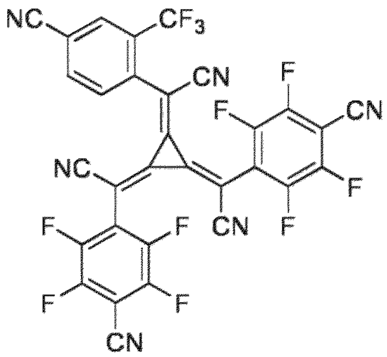 | -5.04 | 3.03 |

(continued)

| Referred to as: | Structure | LUMO (eV) | $E_{gap}$ (eV) |
|---|---|---|---|
| F6 | 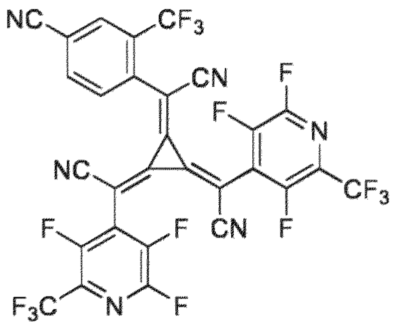 | -5.08 | 3.15 |
| F7 | 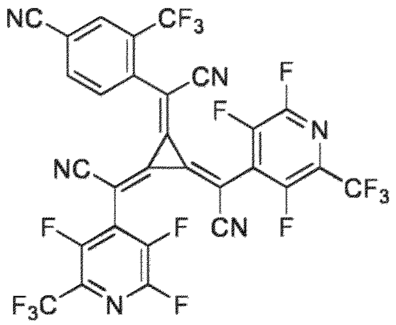 | -5.08 | 3.15 |
| F8 | 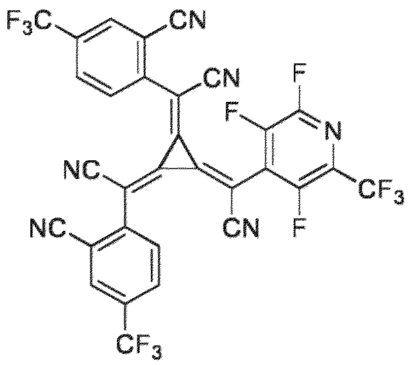 | -4.80 | 3.15 |
| F9 | 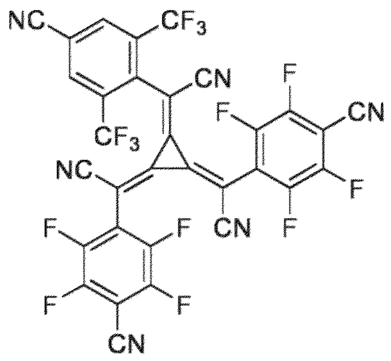 | -5.09 | 3.01 |

(continued)

| Referred to as: | Structure | LUMO (eV) | $E_{gap}$ (eV) |
|---|---|---|---|
| F10 | 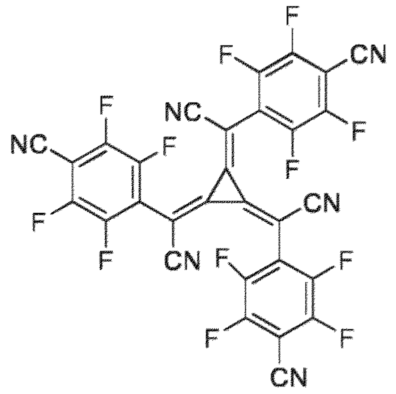 | -5.20 | 2.92 |
| F11 | 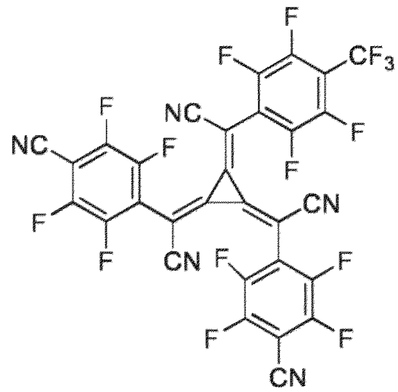 | -5.11 | 2.83 |
| F12 | 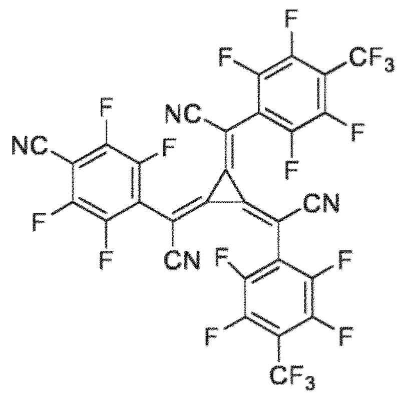 | -5.02 | 2.85 |
| F13 | 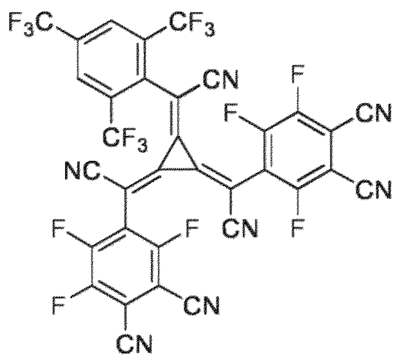 | -5.25 | 3.11 |

(continued)

| Referred to as: | Structure | LUMO (eV) | $E_{gap}$ (eV) |
|---|---|---|---|
| F14 | 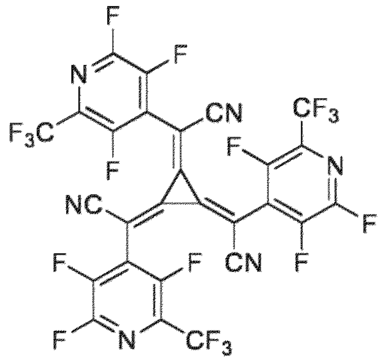 | -5.24 | 3.05 |
| F15 | 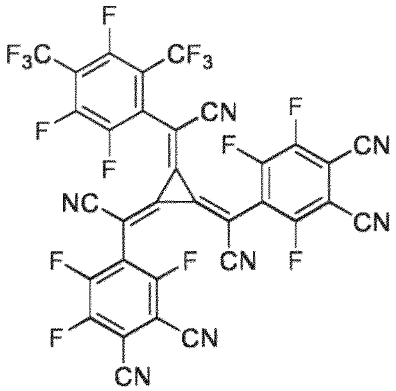 | -5.39 | 2.98 |
| F16 | 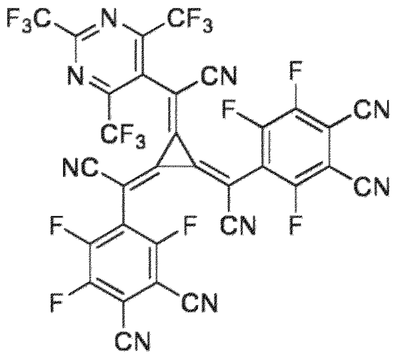 | -5.46 | 3.03 |
| F17 | 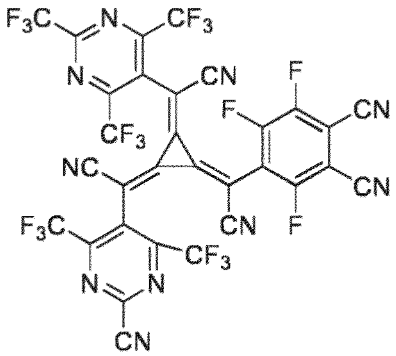 | -5.36 | 3.15 |

(continued)

| Referred to as: | Structure | LUMO (eV) | $E_{gap}$ (eV) |
|---|---|---|---|
| F18 | 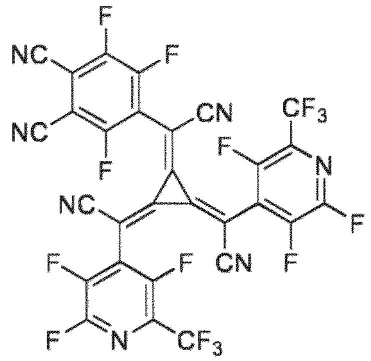 | -5.37 | 2.96 |
| F19 | 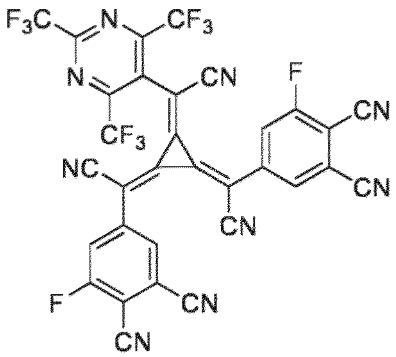 | -5.39 | 2.88 |
| F20 | 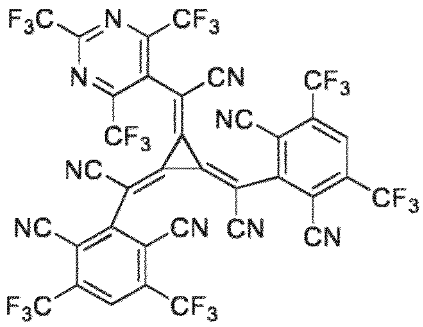 | -5.22 | 3.26 |
| F21 | 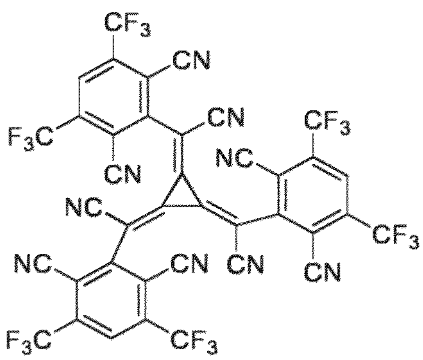 | -5.21 | 3.32 |

(continued)

| Referred to as: | Structure | LUMO (eV) | $E_{gap}$ (eV) |
|---|---|---|---|
| F22 | 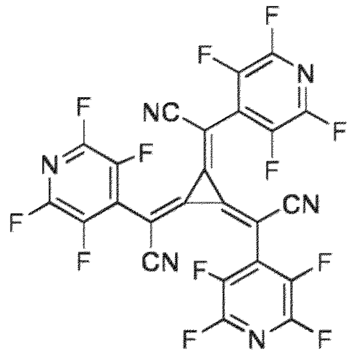 | -5.10 | 2.70 |
| F23 | 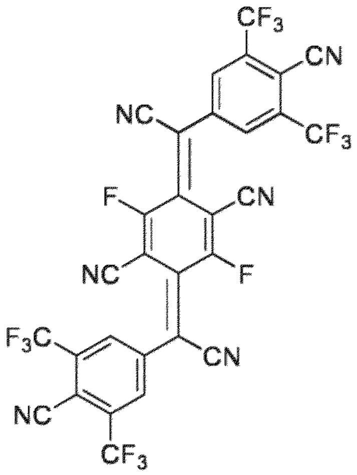 | -5.06 | 3.05 |
| F24 | 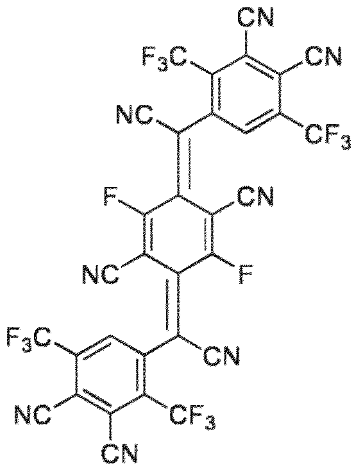 | -5.21 | 3.24 |

(continued)

| Referred to as: | Structure | LUMO (eV) | $E_{gap}$ (eV) |
|---|---|---|---|
| F25 | 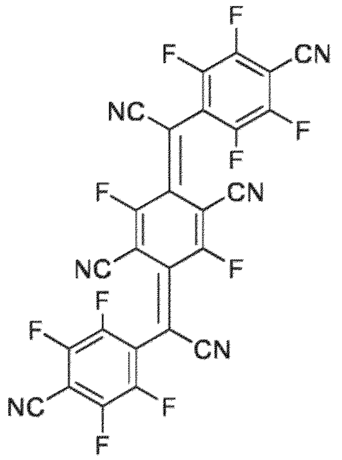 | -5.06 | 3.03 |
| F26 | 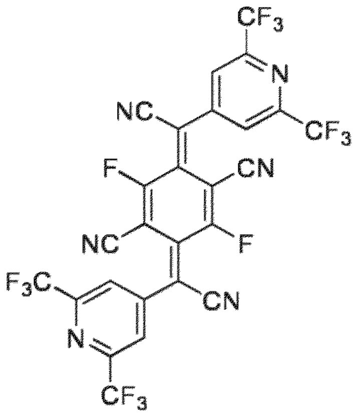 | -5.10 | 3.03 |
| F27 | 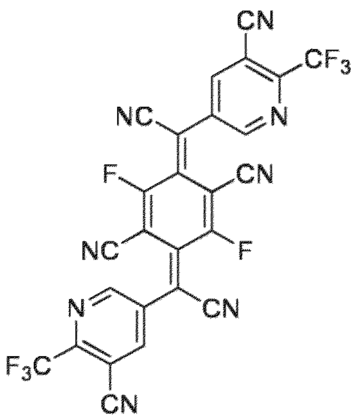 | -5.04 | 3.12 |

(continued)

| Referred to as: | Structure | LUMO (eV) | $E_{gap}$ (eV) |
|---|---|---|---|
| F28 | 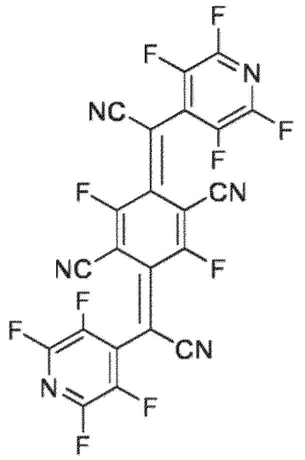 | -4.98 | 2.86 |
| F29 | 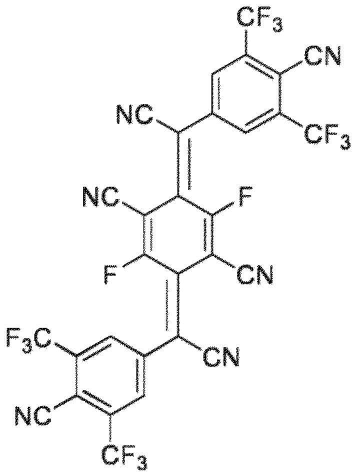 | -5.04 | 3.13 |
| F30 | 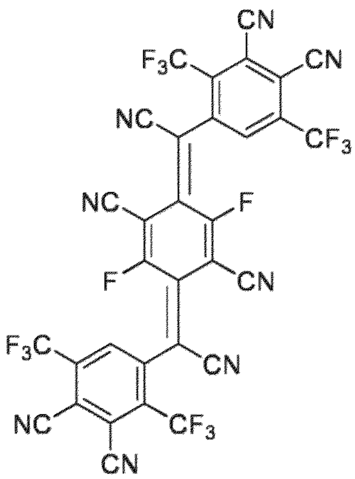 | -5.18 | 3.29 |

(continued)

| Referred to as: | Structure | LUMO (eV) | $E_{gap}$ (eV) |
|---|---|---|---|
| F31 | 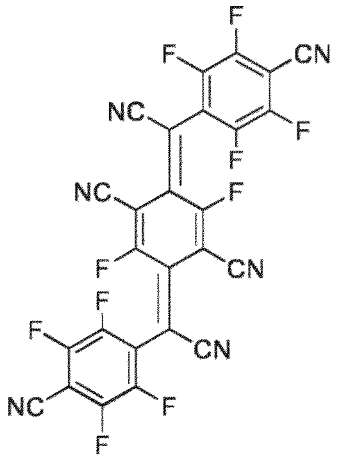 | -4.96 | 3.20 |
| F32 | 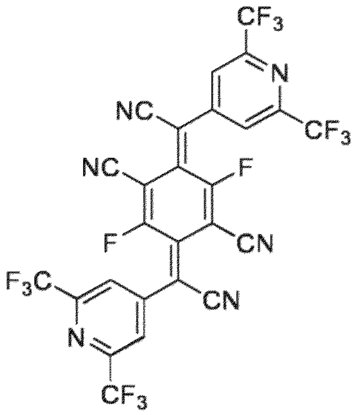 | -5.11 | 3.02 |
| F33 | 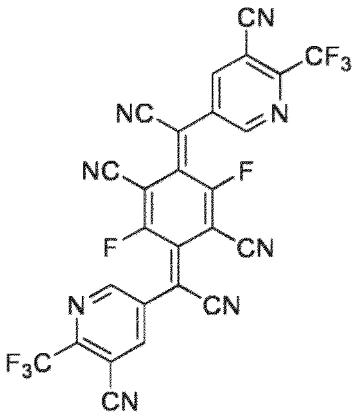 | -5.04 | 3.17 |

(continued)

| Referred to as: | Structure | LUMO (eV) | $E_{gap}$ (eV) |
|---|---|---|---|
| F34 | 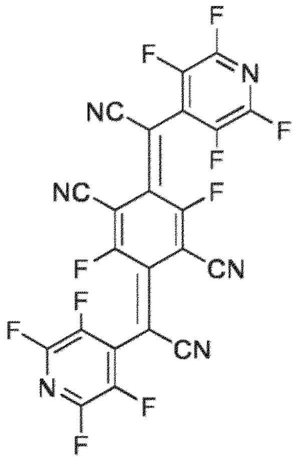 | -4.98 | 2.96 |
| F35 | 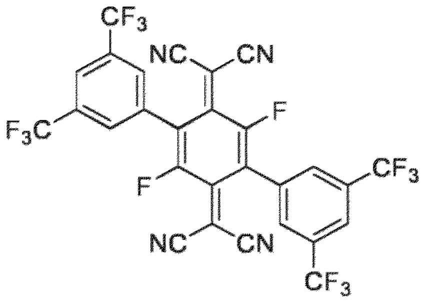 | -4.92 | 3.01 |
| F36 | 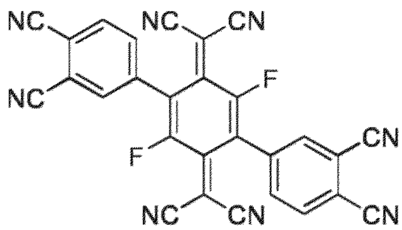 | -5.23 | 2.98 |
| F37 | 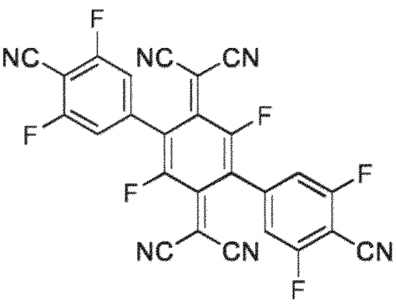 | -5.13 | 2.94 |
| F38 | 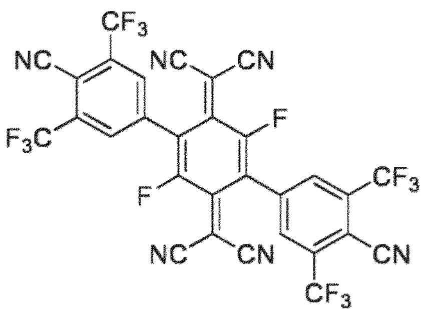 | -5.31 | 2.99 |

(continued)

| Referred to as: | Structure | LUMO (eV) | $E_{gap}$ (eV) |
|---|---|---|---|
| F39 | 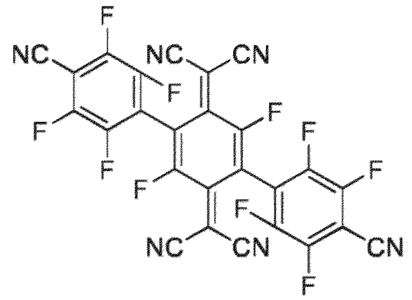 | -5.27 | 2.86 |
| F40 | 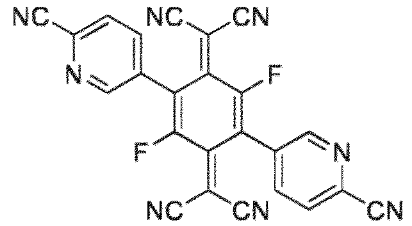 | -5.07 | 2.95 |
| F41 | 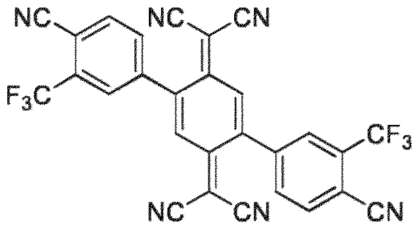 | -5.00 | 2.95 |
| F42 | 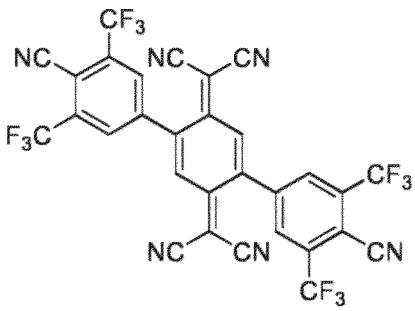 | -5.22 | 2.98 |
| F43 | 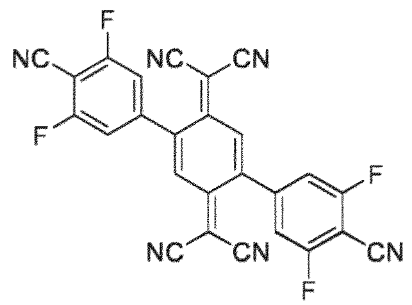 | -5.04 | 2.94 |

(continued)

| Referred to as: | Structure | LUMO (eV) | $E_{gap}$ (eV) |
|---|---|---|---|
| F44 | 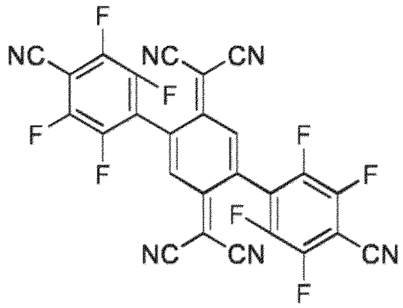 | -5.15 | 2.91 |
| F45 | 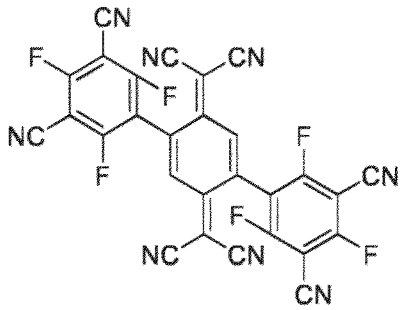 | -5.35 | 2.98 |
| F46 | 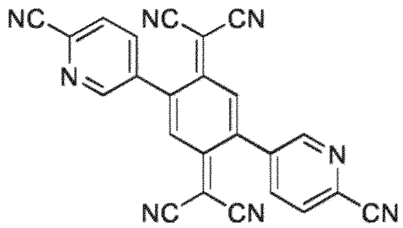 | -4.99 | 2.95 |
| F47 | 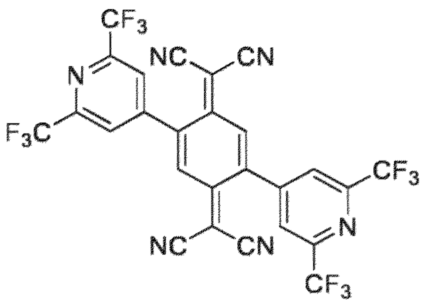 | -5.18 | 3.06 |
| F48 | 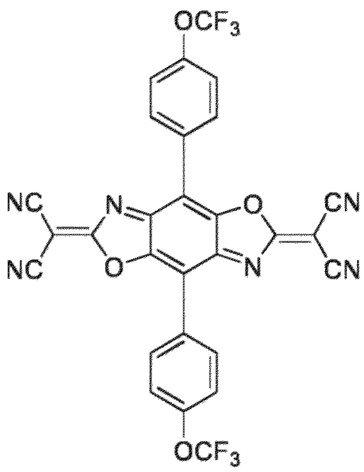 | -5.00 | 2.11 |

(continued)

| Referred to as: | Structure | LUMO (eV) | $E_{gap}$ (eV) |
|---|---|---|---|
| F49 | 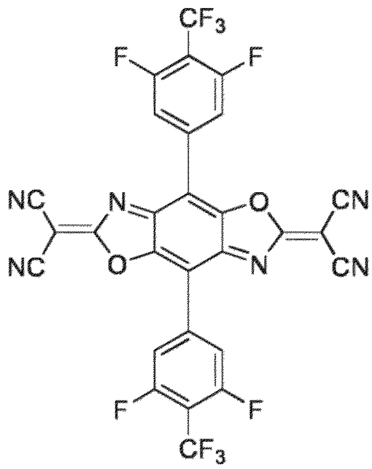 | -5.42 | 2.43 |
| F50 | 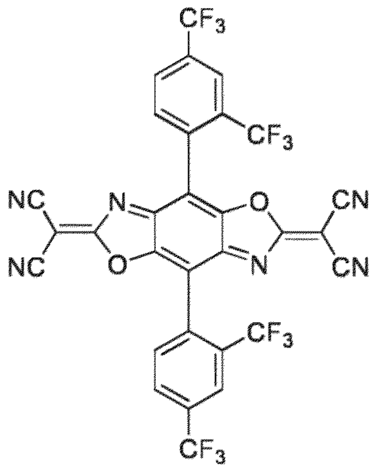 | -5.11 | 2.61 |
| F51 | 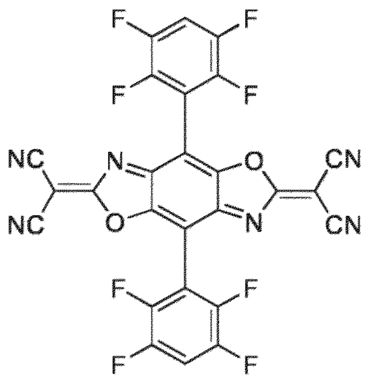 | -5.11 | 2.44 |

(continued)

| Referred to as: | Structure | LUMO (eV) | $E_{gap}$ (eV) |
|---|---|---|---|
| F52 | 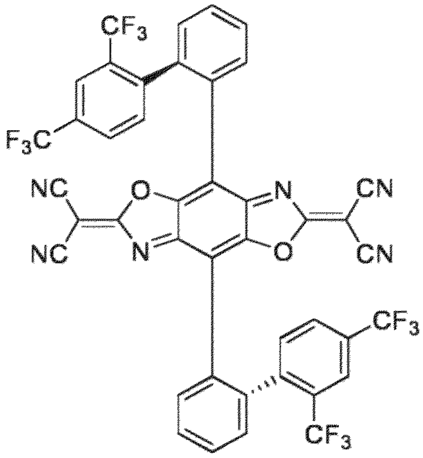 | -4.81 | 2.52 |
| F53 | 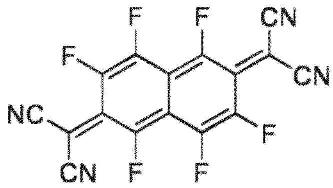 | -5.13 | 2.39 |
| F54 | 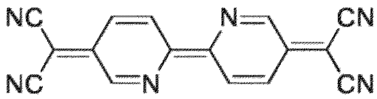 | -4.81 | 2.23 |

Comparative compound 1 (CC-1), also named HAT-CN, is a state of the art compound used in the p-type charge generation layer. The LUMO of comparative compound 1 (CC-1) is -4.74 eV. The energy gap $E_{gap}$ is 4.35 eV.

For p-type dopants of formula (II), the LUMO is improved to ≤ -4.75 eV and ≥ -5.6 eV. Thereby, improved generation of positive charges in the p-type charge generation layer and improved operating voltage may be obtained.

The energy gap $E_{gap}$ of p-type dopants of formula (II) is in a range suitable for use in organic electroluminescent devices, in particular organic electroluminescent devices which emit light in the blue region of the spectrum.

In Table 3 are shown performance data of an organic electroluminescent device according to the present invention and comparative examples.

In Examples 1-1 to 1-18 and comparative examples 1-1 and 1-2, the n-type charge generation layer (n-CGL) comprises 98 vol.-% n-CGL matrix compound MX-1 and 2 vol.-% metal dopant Yb.

In comparative example 1-1, the first p-CGL sub-layer (p-CGL1) comprises 85 vol.-% first hole transport matrix compound U18 and 15 vol.-% comparative compound CC-1. The chemical formula of CC-1 can be seen in Table 1 above. The operating voltage of the organic electroluminescent device is over 10 V. Therefore, the efficiency, lifetime, voltage rise over time and sheet resistance of the charge generation layer were not determined.

Without being bound by theory, the LUMO of CC-1 may be in a range which is not suitable for efficient hole generation.

In comparative example 1-2, the first p-CGL sub-layer (p-CGL1) comprises 93 vol.-% first hole transport matrix compound U18 and 7 vol.-% p-type dopant of formula (I) C26. In formula C26, A is selected from formula B2, see Table 1. The second p-CGL sub-layer (p-CGL2) comprises 85 vol.-% second hole transport matrix compound U18 and 15 vol.-% comparative compound CC-1. The operating voltage of the organic electroluminescent device is over 10 V. Therefore, the efficiency, lifetime, voltage rise over time and sheet resistance of the charge generation layer were not determined.

In Example 1-1, the second p-CGL sub-layer comprises 85 vol.-% second hole transport matrix compound U18 and 15 vol.-% p-type dopant of formula (II) F1. In formula F1, $A^1$ is selected from formula P1, see Table 2. Example 1-1 differs from comparative example 1-2 in the p-type dopant. As can be seen in Table 3, the operating voltage is improved to 6.45 V, the efficiency CEff/CIE-y is 302 cd/A, the lifetime is 101 hours and the voltage rise over time is 0.09 V. The sheet resistance of the charge generation layer is 1856 GΩ/sq.

In Example 1-2, the second p-CGL sub-layer comprises 85 vol.-% second hole transport matrix compound U18 and 15 vol.-% p-type dopant of formula (II) F34. In formula F34, $A^1$ is selected from formula P2, see Table 2. Example 1-2

differs from comparative example 1-2 in the p-type dopant. As can be seen in Table 3, the operating voltage is improved to 6.38 V, the efficiency CEff/CIE-y is improved to 305 cd/A, the lifetime is 98 hours and the voltage rise over time is 0.09 V. The sheet resistance of the charge generation layer is 640 GS2/sq.

In Example 1-3, the second p-CGL sub-layer comprises 85 vol.-% second hole transport matrix compound U18 and 15 vol.-% p-type dopant of formula (II) F35. In formula F35, $A^1$ is selected from formula P2, see Table 2. Example 1-3 differs from comparative example 1-2 in the p-type dopant. As can be seen in Table 3, the operating voltage is improved to 7.04 V, the efficiency CEff/CIE-y is improved to 297 cd/A, the lifetime is improved to 201 hours and the voltage rise over time is -0.01 V. The sheet resistance of the charge generation layer is improved to 3239 GΩ/sq.

In Example 1-4, the second p-CGL sub-layer comprises 85 vol.-% second hole transport matrix compound U18 and 15 vol.-% p-type dopant of formula (II) F53. In formula F53, $A^1$ is selected from formula P4, see Table 2. Example 1-4 differs from comparative example 1-2 in the p-type dopant. As can be seen in Table 3, the operating voltage is improved to 6.56 V, the efficiency CEff/CIE-y is improved to 306 cd/A, the lifetime is 79 hours and the voltage rise over time is 0.10 V. The sheet resistance of the charge generation layer is improved to 1870 GΩ/sq.

In Example 1-5, the first p-CGL sub-layer comprises 89 vol.-% first hole transport matrix compound U18 and 11 vol.-% p-type dopant of formula (I) C1. In formula C1, A is selected from formula B1. The second p-CGL sub-layer comprises 93 vol.-% second hole transport matrix compound U18 and 7 vol.-% p-type dopant of formula (II) F25. In formula F25, $A^1$ is selected from formula P2, see Table 2. Example 1-5 differs from comparative example 1-2 in the composition of first p-CGL sub-layer and second p-CGL sub-layer. As can be seen in Table 3, the operating voltage is improved to 6.42 V, the efficiency CEff/CIE-y is improved to 300 cd/A, the lifetime is 109 hours and the voltage rise over time is 0.10 V. The sheet resistance of the charge generation layer is improved to 341 GS2/sq.

In Example 1-6, the second p-CGL sub-layer comprises 85 vol.-% second hole transport matrix compound U18 and 15 vol.-% p-type dopant of formula (II) F34. In formula F34, $A^1$ is selected from formula P2, see Table 2. Example 1-6 differs from comparative example 1-2 in the composition of first p-CGL sub-layer and second p-CGL sub-layer. As can be seen in Table 3, the operating voltage is improved to 6.42 V, the efficiency CEff/CIE-y is improved to 298 cd/A, the lifetime is 109 hours and the voltage rise over time is 0.12 V. The sheet resistance of the charge generation layer is improved to 231 GS2/sq.

In Example 1-7, the second p-CGL sub-layer comprises 85 vol.-% second hole transport matrix compound U18 and 15 vol.-% p-type dopant of formula (II) F1. In formula F1, $A^1$ is selected from formula P1, see Table 2. Example 1-7 differs from comparative example 1-2 in the composition of first p-CGL sub-layer and second p-CGL sub-layer. As can be seen in Table 3, the operating voltage is improved to 6.43 V, the efficiency CEff/CIE-y is improved to 298 cd/A, the lifetime is 108 hours and the voltage rise over time is 0.01 V. The sheet resistance of the charge generation layer is improved to 920 GΩ/sq.

In Example 1-8, the first p-CGL sub-layer comprises 89 vol.-% first hole transport matrix compound U18 and 11 vol.-% p-type dopant of formula (I) C24. In formula C24, A is selected from formula B1, see Table 1. The second p-CGL sub-layer comprises 85 vol.-% second hole transport matrix compound U18 and 15 vol.-% p-type dopant of formula (II) F34. In formula F34, $A^1$ is selected from formula P2, see Table 2. Example 1-7 differs from comparative example 1-2 in the composition of first p-CGL sub-layer and second p-CGL sub-layer. As can be seen in Table 3, the operating voltage is improved to 6.48 V, the efficiency CEff/CIE-y is improved to 288 cd/A, the lifetime is 109 hours and the voltage rise over time is 0.11 V. The sheet resistance of the charge generation layer is improved to 355 GΩ/sq.

In summary, an improvement in operating voltage, efficiency, lifetime, voltage rise over time and/or sheet resistance has been obtained.

Low operating voltage and/or high efficiency may be important for reduced power consumption, in particular in mobile devices.

Improved lifetime and reduced voltage rise over time may be important for improved stability of the organic electroluminescent device.

Improved sheet resistance of the charge generation layer may result in improved pixel crosstalk. Thereby, the colour purity in a display device may be improved.

Table 3: Performance of organic electroluminescent devices and comparative examples

| | n-CGL | p-CGL1 | p-CGL2 | Voltage at 10 mA/cm2 [V] | CEff/CIE-y at 10 mA/cm2 [cd/A] | LT97 at 30 mA/cm2 [h] | Voltage rise at 30mA/cm2 (1-100h) [V] | CGL-Rs [GΩ/sq] |
|---|---|---|---|---|---|---|---|---|
| Comparative example 1-1 | MX-1:Yb (2 vol.-%) | 10 nm U18 : CC-1 (15 vol.-%) | -- | >10 | n.d. 1) | n.d. | n.d. | n.d. |
| Comparative example 1-2 | MX-1:Yb (2 vol.-%) | 2 nm U18 : C26 (7 vol.-%) | 8 nm U18 : CC-1 (15 vol.-%) | >10 | n.d. | n.d. | n.d. | n.d. |
| Example 1-1 | MX-1:Yb (2 vol.-%) | 2 nm U18 :C26 (7 vol.-%) | 8 nm U18 : F1 (15 vol.-%) | 6.45 | 302 | 101 | 0.09 | 1856 |
| Example 1-2 | MX-1:Yb (2 vol.-%) | 2 nm U18 : C26 (7 vol.-%) | 8 nm U18 : F34 (15 vol.-%) | 6.38 | 305 | 98 | 0.09 | 640 |
| Example 1-3 | MX-1:Yb (2 vol-%) | 2 nm U18 : C26 (7 vol.-%) | 8 nm U18 : F35 (15 vol.-%) | 7.04 | 297 | 201 | -0.01 | 3239 |
| Example 1-4 | MX-1:Yb (2 vol.-%) | 2 nm U18: C26 (7 vol.-%) | 8nmU18 : F53 (15 vol.-%) | 6.56 | f306 | 79 | 0.10 | 1870 |
| Example 1-5 | MX-1:Yb (2 vol.-%) | 5 nm U18: C1 (11 vol.-%) | 5 nm U18: F25 (7 vol.-%) | 6.42 | 300 | 109 | 0.10 | 341 |
| Example 1-6 | MX-1:Yb (2 vol.-%) | 5nmU18: C1 (11 vol.-%) | 5 nm U18: F34 (15 vol.-%) | 6.42 | 298 | 109 | 0.12 | 231 |
| Example 1-7 | MX-1:Yb (2 vol.-%) | 5nmU18: C1 (11 vol.-%) | 5 nm U18: F1 (15 vol.-%) | 6.43 | 298 | 108 | 0.01 | 920 |
| Example 1-8 | MX-1:Yb (2 vol.-%) | 5 nm U:18 C24 (11 vol.-%) | 5 nm U18: F34 (15 vol.-%) | 6.48 | 288 | 109 | 0.11 | 355 |
| 1) "n.d." = not determined | | | | | | | | |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

**1.** An organic electroluminescent device comprising an anode layer, a cathode layer, a first light-emitting unit, a second light-emitting unit, and at least one charge generation layer;

wherein

- the at least one charge generation layer is arranged between the first light-emitting unit and the second light-emitting unit;

wherein

- the at least one charge generation layer comprises a n-type charge generation layer, and a p-type charge generation layer, wherein the n-type charge generation layer is arranged closer to the anode layer and the p-type charge generation layer is arranged closer to the cathode layer;

wherein

- the p-type charge generation layer (p-CGL) comprises a first p-CGL sub-layer (p-CGL1) and a second p-CGL sub-layer (p-CGL2);

wherein

- the first p-CGL sub-layer (p-CGL1) comprises a first hole transport matrix compound and a p-type dopant of formula (I):

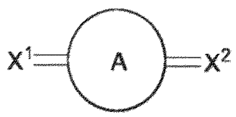
(I),

$X^1$ and $X^2$ are independently selected from formula (Ia):

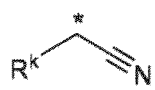
(Ia),

wherein the asterisk "*" denotes the binding position;
$R^k$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
A is selected from a group comprising of B1 or B2:

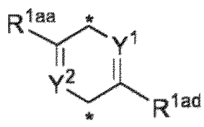 (B1), 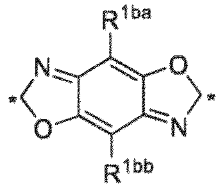 (B2),

wherein each $X^1$ and $X^2$ is conjugated via a double-bond to A;

- $Y^1$ is selected from N or $CR^{1ab}$;
- $Y^2$ is selected from N or $CR^{1ac}$;
- $R^{1aa}$, $R^{1ab}$, $R^{1ac}$, $R^{1ad}$, $R^{1ba}$ and $R^{1bb}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl, wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;
  wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the second p-CGL sub-layer (p-CGL2) comprises a second hole transport matrix compound and a p-type dopant of formula (II);

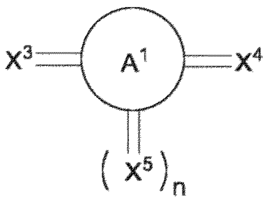 (II),

n is an integer selected from 0 or 1;
$X^3$, $X^4$ and $X^5$ are independently selected from formula (IIa)

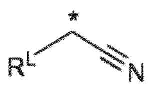 (IIa),

wherein the asterisk "*" denotes the binding position;
$R^L$ is independently selected from the group comprising an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,
wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from the group

comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;

wherein the one or more substituents of the substituted $C_6$ to $C_{12}$ aryl, substituted $C_3$ to $C_{12}$ heteroaryl, substituted $C_1$ to $C_8$ alkyl, substituted $C_1$ to $C_8$ alkoxy are independently selected from the group comprising of D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$A^1$ is selected from a group comprising of P1 to P5:

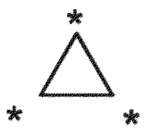
(P1),
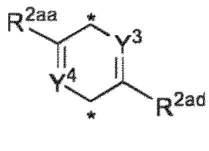
(P2),
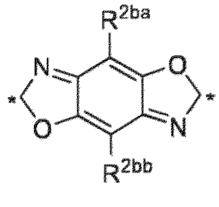
(P3),

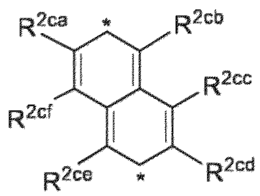
(P4),
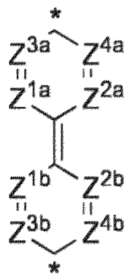
(P5),

wherein each $X^3$, $X^4$, and/or $X^5$ are conjugated via a double-bond to $A^1$;

- $Y^3$ is selected from Nor $CR^{2ab}$;
- $Y^4$ is selected from N or $CR^{2ac}$;
- $Z^{1a}$, $Z^{2a}$, $Z^{3a}$, $Z^{4a}$, $Z^{1b}$, $Z^{2b}$, $Z^{3b}$, $Z^{4b}$ are independently selected from N or $CR^{2da}$, preferably N or CH; more preferred $Z^{1a}$ and $Z^{2b}$ are N or CH, preferably N, and $Z^{2a}$, $Z^{3a}$, $Z^{4a}$, $Z^{1b}$, $Z^{3b}$, $Z^{4b}$ are CH;
- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{30}$ aryl, substituted or unsubstituted $C_3$ to $C_{30}$ heteroaryl,

  wherein the one or more substituents of the substituted $C_6$ to $C_{30}$ aryl, substituted $C_3$ to $C_{30}$ heteroaryl, substituted $C_1$ to $C_8$ alkyl, substituted $C_1$ to $C_8$ alkoxy are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$, substituted or unsubstituted $C_6$ to $C_{12}$ aryl, substituted or unsubstituted $C_3$ to $C_{12}$ heteroaryl;

  wherein the one or more substituents of the substituted $C_6$ to $C_{12}$ aryl, substituted $C_6$ to $C_{12}$ heteroaryl, substituted $C_1$ to $C_8$ alkyl, substituted $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein

- the p-type dopant of formula (I) is different from the p-type dopant of formula (II);
- the first p-CGL sub-layer (p-CGL1) is in direct contact with the second p-CGL sub-layer (p-CGL2);
- the first p-CGL sub-layer (p-CGL1) is in direct contact to the n-type charge generation layer and the second p-CGL sub-layer (p-CGL2) is arranged closer to the cathode layer;
- the n-type charge generation layer (n-CGL) comprises a n-CGL matrix compound and a metal dopant.

**2.** The organic electroluminescent device according to claim 1, wherein the organic electroluminescent device further comprises a hole injection layer, preferably the hole injection layer is in direct contact with the anode layer.

**3.** The organic electroluminescent device according to claim 2, wherein the hole injection layer comprises one p-type dopant of formula (I) or one p-type dopant of formula (II); preferably the concentration of the p-type dopant of formula (I) or the p-type dopant of formula (II) in the hole injection layer is lower than the concentration of p-type dopant of formula (I) in the first p-CGL sub-layer and/or the concentration of the p-type dopant of formula (II) in the second p-CGL sub-layer.

**4.** The organic electroluminescent device according to any of the preceding claims 1 to 3, wherein the p-type dopant of formula (I) and/or the p-type dopant of formula (II) comprises at least two groups independently selected from substituted $C_6$ to $C_{30}$ aryl groups or substituted $C_3$ to $C_{30}$ heteroaryl groups, wherein the one or more substituents are independently selected from the group comprising of D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $-NO_2$, $SF_5$; preferably F, $CF_3$, $OCF_3$, CN, isocyano, SCN, OCN, $-NO_2$, $SF_5$; more preferred F, $CF_3$, $OCF_3$, CN, $-NO_2$.

**5.** The organic electroluminescent device according to any of the preceding claims 1 to 4, wherein the p-dopant of formula (I) and/or the p-type dopant of formula (II) comprises at least two 6-membered carbocyclic rings, at least two groups selected from substituted $C_6$ to $C_{12}$ aryl groups or at least two groups selected from substituted $C_3$ to $C_{12}$ heteroaryl groups.

**6.** The organic electroluminescent device according to any of the preceding claims 1 to 5, wherein the absolute value of the LUMO energy level of the p-type dopant of formula (I) is larger than the absolute value of the LUMO energy level of the p-type dopant of formula (II), when determined by the same method under the same conditions.

**7.** The organic electroluminescent device according to any of the preceding claims 1 to 6,

wherein the energy gap $E_{gap}$ of the p-type dopant of formula (I) is selected in the range of ≥ 2.4 and ≤ 5 eV, preferably in the range of ≥ 2.45 and ≤ 4.5 eV, more preferred in the range of ≥ 2.5 and ≤ 3.5 eV; and/or wherein the energy gap $E_{gap}$ of the p-type dopant of formula (II) is selected in the range of ≥ 2.3 and ≤ 5 eV, preferably in the range of ≥ 2.35 and ≤ 4 eV, more preferred in the range of ≥ 2.4 and ≤ 3.5 eV.

**8.** The organic electroluminescent device according to any of the preceding claims 1 to 7, wherein the p-type dopant of formula (I) and/or the p-type dopant of formula (II) comprises:

- ≥ 2 to ≤ 10 cyano moieties and ≥ 1 to ≤ 4 nitrogen atoms, preferably ≥ 4 to ≤ 8 cyano moieties and ≥ 1 to ≤ 4 nitrogen atoms, further preferred ≥ 3 to ≤ 7 cyano moieties and ≥ 1 to ≤ 4 nitrogen atoms, further more preferred ≥ 4 to ≤ 6 cyano moieties and ≥ 1 to ≤ 4 N atoms, also preferred ≥ 4 to ≤ 8 cyano moieties and ≥ 1 to 2 N atoms; or
- ≥ 2 and ≤ 8 cyano moieties, ≥ 3 and ≤ 8 cyano moieties, ≥ 4 and ≤ 8 cyano moieties or ≥ 5 and ≤ 6 cyano moieties; or
- ≥ 2 fluorine atoms, ≥ 4 fluorine atoms, ≥ 6 fluorine atoms, ≥ 8 fluorine atoms, ≥ 12 fluorine atoms; or
- ≥ 2 to ≤ 14 fluorine atoms, ≥ 2 to ≤ 12 fluorine atoms or ≥ 4 to ≤ 10 fluorine atoms;
- ≥ 4 to ≤ 8 cyano moieties and ≥ 2 to ≤ 14 fluorine atoms; or
- ≥ 2 to ≤ 8 cyano moieties and ≥ 2 to ≤ 14 nitrogen atoms, and ≥ 2 to ≤ 12 fluorine atoms; or
- ≥ 2 to ≤ 7 cyano moieties and ≥ 1 to ≤ 3 nitrogen atoms and ≥ 4 to ≤ 14 fluorine atoms;
- ≥ 3 to ≤ 8 cyano moieties and ≥ 1 to ≤ 4 nitrogen atoms and ≥ 6 to ≤ 12 fluorine atoms; or
- ≥ 5 to ≤ 8 cyano moieties and ≥ 2 to ≤ 4 nitrogen atoms and ≥ 8 to ≤ 14 fluorine atoms; preferably the p-type dopant of formula (I) comprises:
- ≥ 3 to ≤ 7 cyano moieties, ≥ 1 to ≤ 4 nitrogen atoms, and ≥ 4 to ≤ 14 fluorine atoms, or ≥ 3 to ≤ 7 cyano moieties, ≥ 1 to ≤ 3 nitrogen atoms, and ≥ 6 to ≤ 12 fluorine atoms, or ≥ 4 to ≤ 8 cyano moieties and ≥ 1 to ≤ 4 nitrogen atoms, and ≥

6 to ≤ 12 fluorine atoms, or ≥ 5 to ≤ 8 cyano moieties, ≥ 1 to ≤ 4 N nitrogen atoms, and ≥ 4 to ≤ 14 fluorine atoms.

**9.** The organic electroluminescent device according to any of the preceding claims 1 to 8, wherein

- $X^1$ and $X^2$ of the p-type dopant of formula (I) are selected the same; and/or
- $X^3$ and $X^4$ of the p-type dopant of formula (II) are selected the same; and/or
- $X^3$, $X^4$ and $X^5$ of the p-type dopant of formula (II) are selected the same.

**10.** The organic electroluminescent device according to any of the preceding claims 1 to 9, wherein each $R^k$ according to formula (Ia) and/or each $R^L$ of formula (IIa) is independently selected from CN or substituted $C_6$ to $C_{12}$ aryl or substituted $C_3$ to $C_{12}$ heteroaryl,
wherein the substituent of the substituted $C_6$ to $C_{12}$ aryl or substituted $C_3$ to $C_{12}$ heteroaryl is selected from halogen, F, Cl, CN, substituted or unsubstituted C1 to C4 alkyl, partially fluorinated C1 to C4 alkyl, perfluorinated C1 to C4 alkyl, substituted or unsubstituted C1 to C4 alkoxy, partially fluorinated C1 to C4 alkoxy, perfluorinated C1 to C4 alkoxy, preferably F, CN, CF3.

**11.** The organic electroluminescent device according to any of the preceding claims 1 to 10, wherein each $R^k$ according to formula (Ia) and/or each $R^L$ according to formula (IIa) is independently selected from CN or formulae D1 to D80:

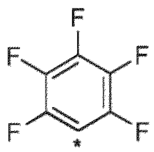 (D1), 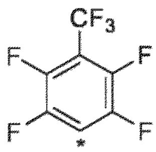 (D2), 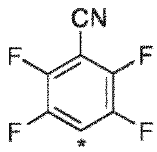 (D3), 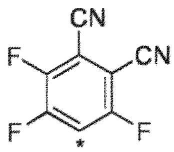 (D4),

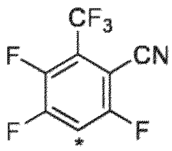 (D5), 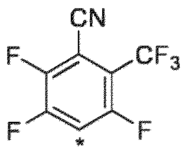 (D6), 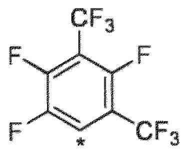 (D7), 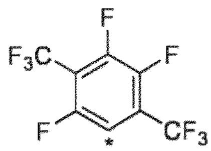 (D8),

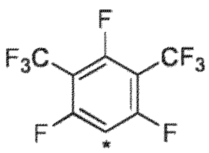 (D9), 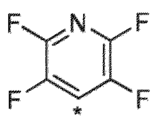 (D10), 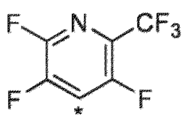 (D11), 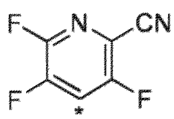 (D12),

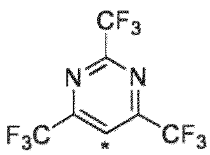 (D13), 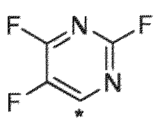 (D14), 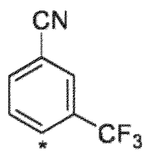 (D15), 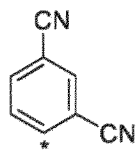 (D16),

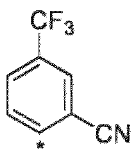 (D17), 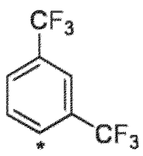 (D18), 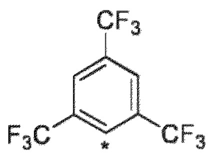 (D19), 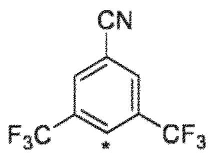 (D20),

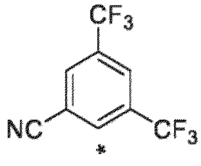 (D21), 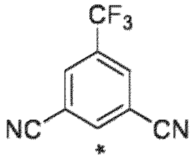 (D22), 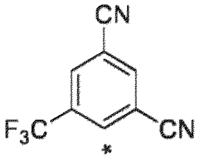 (D23), 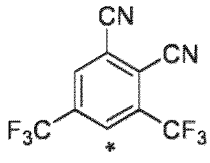 (D24),

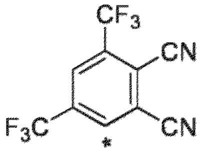 (D25), 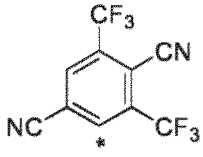 (D26), 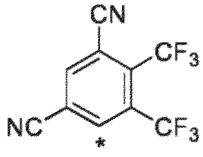 (D27), 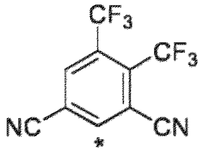 (D28),

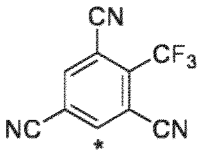 (D29), 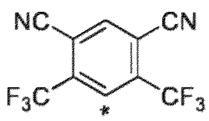 (D30), 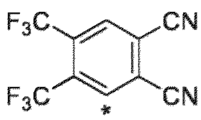 (D31),

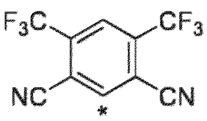 (D32), 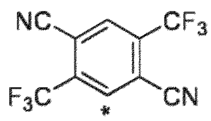 (D33), 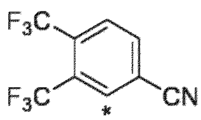 (D34),

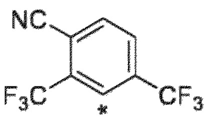 (D35), 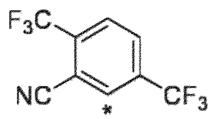 (D36), 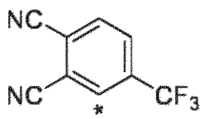 (D37),

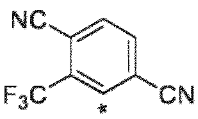 (D38), 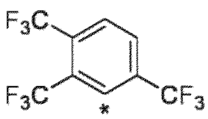 (D39), 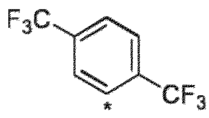 (D40),

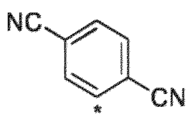 (D41), 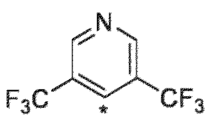 (D42), 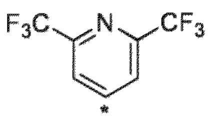 (D43), 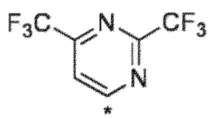 (D44),

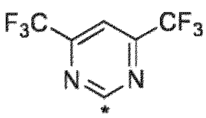 (D45), 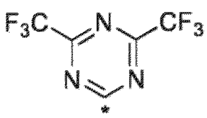 (D46), 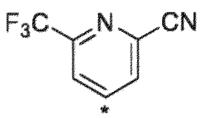 (D47), 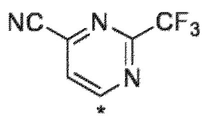 (D48),

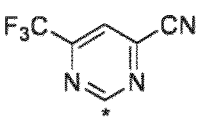 (D49), 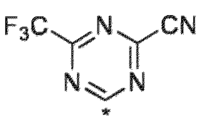 (D50), 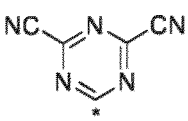 (D51), 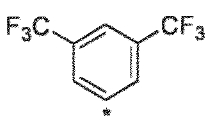 (D52),

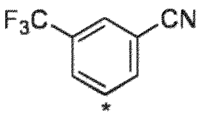 (D53), 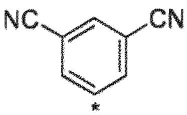 (D54), 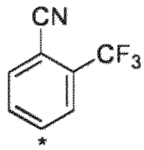 (D55), 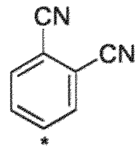 (D56),

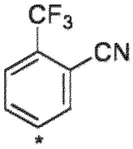 (D57), 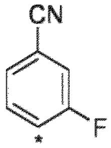 (D58), 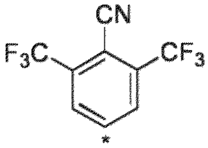 (D59), 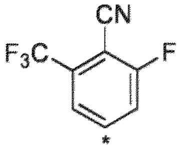 (D60),

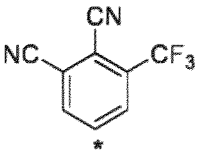 (D61), 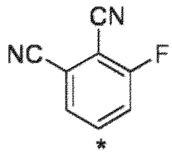 (D62), 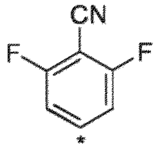 (D63), 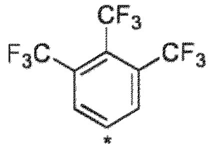 (D64),

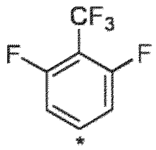 (D65), 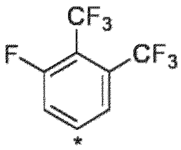 (D66), 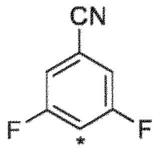 (D67), 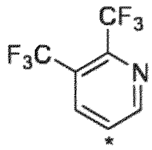 (D68),

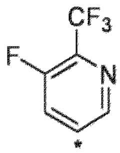 (D69), 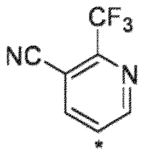 (D70), 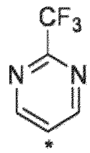 (D71), 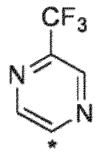 (D72), 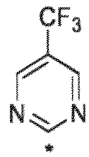 (D73),

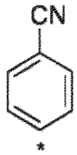 (D74), 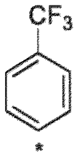 (D75), 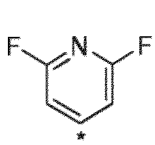 (D76), 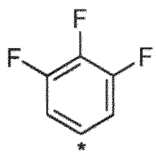 (D77), 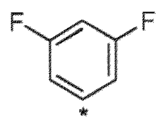 (D78),

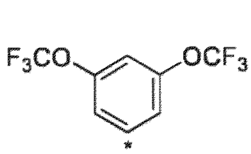 (D79), 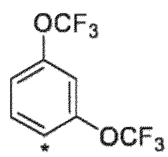 (D80),

wherein the asterisk "*" denotes the binding position.

**12.** The organic electroluminescent device according to any of the preceding claims 1 to 11, wherein A of formula (I) is selected from formulae (Bl) and/or (B2):

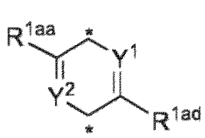 (B1), 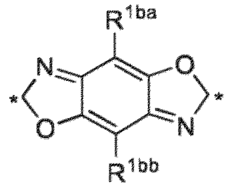 (B2),

wherein each $X^1$ and $X^2$ are conjugated via a double-bond to A;
wherein $X^1$ and $X^2$ are independently selected from formula (Ia); and
wherein in formula (Ia) each $R^k$ is independently selected from CN or formulae D1 to D80.

**13.** The organic electroluminescent device according to any of the preceding claims 1 to 12, wherein in formulae (B1) and/or (B2):

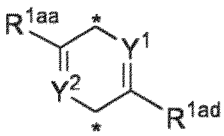 (B1), 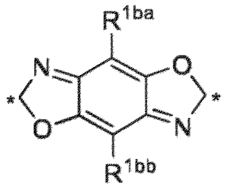 (B2),

- $R^{1aa}$, $R^{1ad}$, $R^{1ba}$ and $R^{1bb}$ are independently selected from formulae E1 to E73:

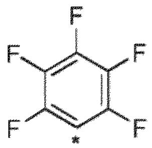 (E1), 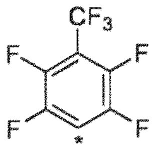 (E2), 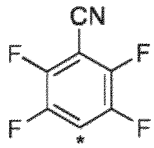 (E3), 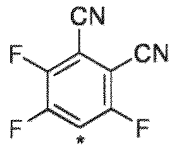 (E4), 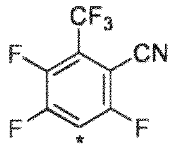 (E5),

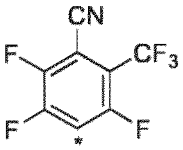 (E6), 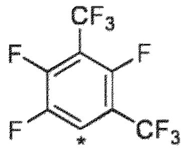 (E7), 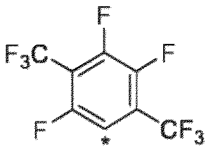 (E8), 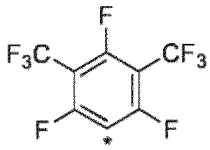 (E9),

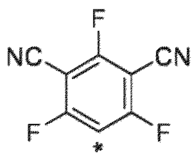 (E10), 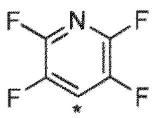 (E11), 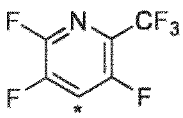 (E12), 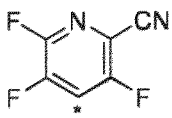 (E13),

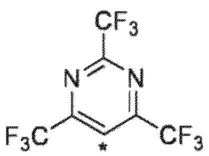 (E14), 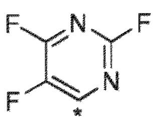 (E15), 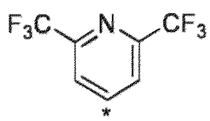 (E16), 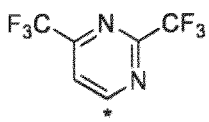 (E17),

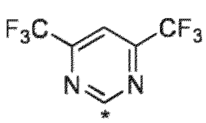 (E18), 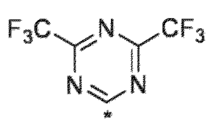 (E19), 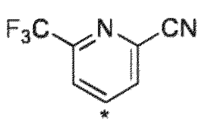 (E20), 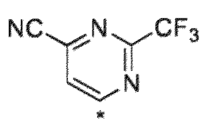 (E21),

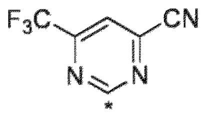 (E22), 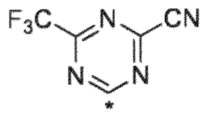 (E23), 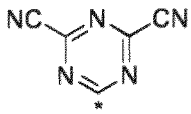 (E24), 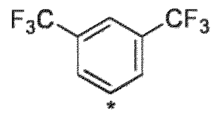 (E25),

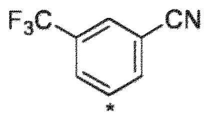 (E26), 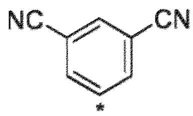 (E27), 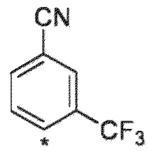 (E28), 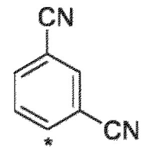 (E29),

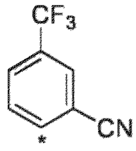 (E30), 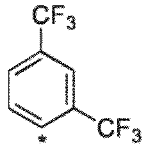 (E31), 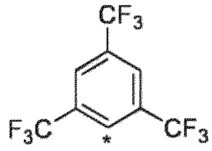 (E32), 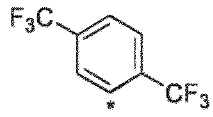 (E33),

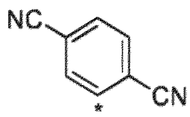 (E34), 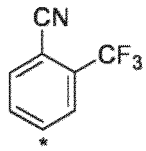 (E35), 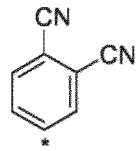 (E36), 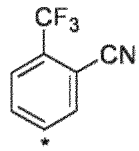 (E37),

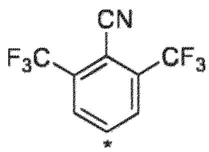 (E38), 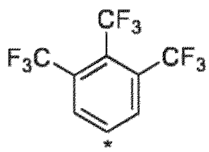 (E39), 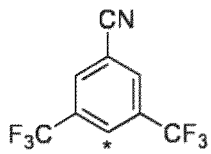 (E40), 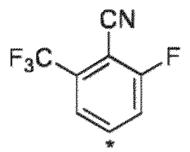 (E41),

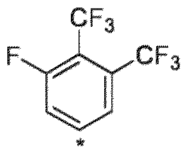 (E42), 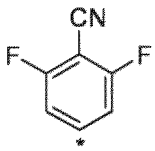 (E43), 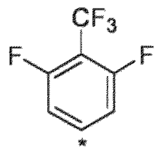 (E44), 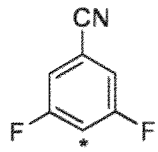 (E45),

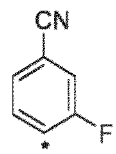 (E46), 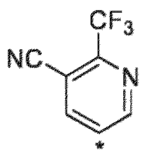 (E47), 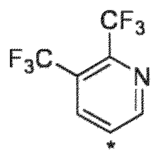 (E48), 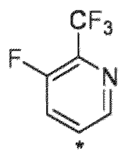 (E49), 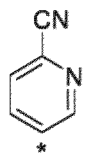 (E50),

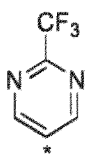 (E51), 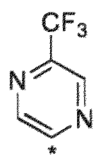 (E52), 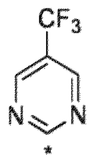 (E53), 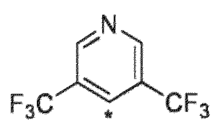 (E54), 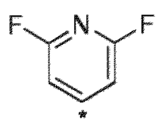 (E55),

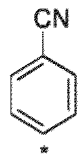 (E56), 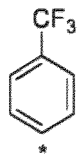 (E57), 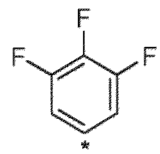 (E58), 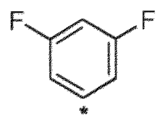 (E59), 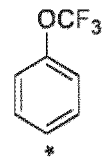 (E60),

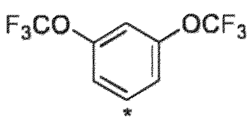 (E61), 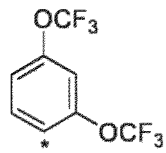 (E62), 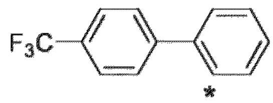 (E63),

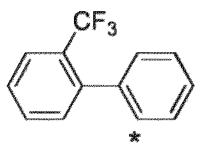 (E64), 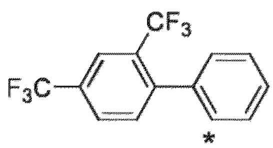 (E65), 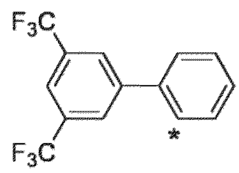 (E66),

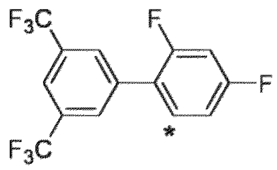 (E67), 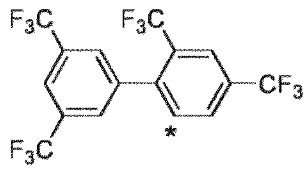 (E68), 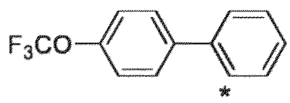 (E69),

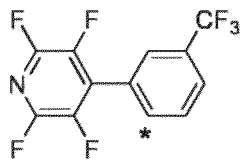 (E70), 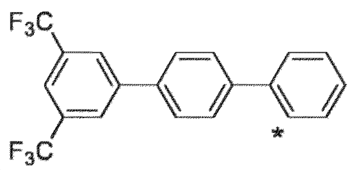 (E71),

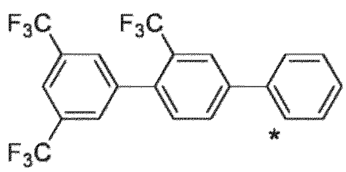 (E72), 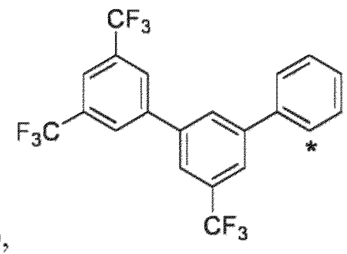 (E73);

wherein the asterix "*" denotes the binding position;
- in formula (Ia) $R^k$ is selected from CN or formulae D1 to D80, preferably $R^k$ is CN; preferably $R^{1aa}$, $R^{1ad}$, $R^{1ba}$ and $R^{1bb}$ are selected the same;
- $Y^1$ is selected from $CR^{1ab}$;
- $Y^2$ is selected from $CR^{1ac}$; and

wherein $R^{1ab}$ and $R^{1ac}$ are independently selected from H, D, an electron-withdrawing group, halogen, Cl, F, CN; preferably $R^{1ab}$ and $R^{1ac}$ are selected from H, D, F or CN.

**14.** The organic electroluminescent device according to any of the preceding claims 1 to 13, wherein in formula (1) A is selected from formulae (B1):

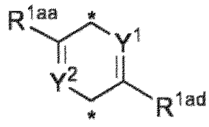
(B1),

- $Y^1$ is selected from $CR^{1ab}$;
- $Y^2$ is selected from $CR^{1ac}$;
- $R^{1aa}$, $R^{1ab}$, $R^{1ac}$, $R^{1ad}$ are independently selected from H, D, an electron-withdrawing group, halogen, Cl, F, CN; preferably $R^{1aa}$, $R^{1ab}$, $R^{1ac}$, $R^{1ad}$ are selected from H, D, F or CN, most preferred $R^{1aa}$, $R^{1ab}$, $R^{1ac}$, $R^{1ad}$ are selected form F or CN, also preferred two of $R^{1aa}$, $R^{1ab}$, $R^{1ac}$, - $R^{1ad}$ are selected from F and two $R^{1aa}$, $R^{1ab}$, $R^{1ac}$, $R^{1ad}$ are selected from CN; and
- in formula (Ia) each $R^k$ is selected from formulae D1 to D80.

**15.** The organic electroluminescent device according to any of the preceding claims 1 to 14, wherein the p-type dopant of formula (I) is selected from formulae C1 to C30:

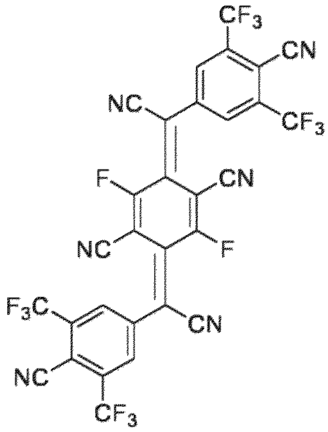
(C1),
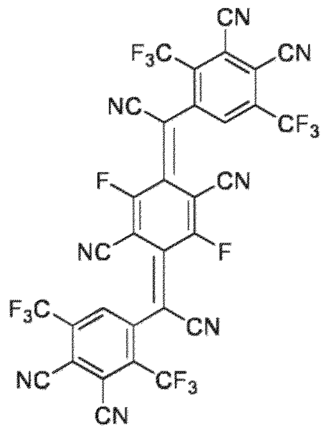
(C2),

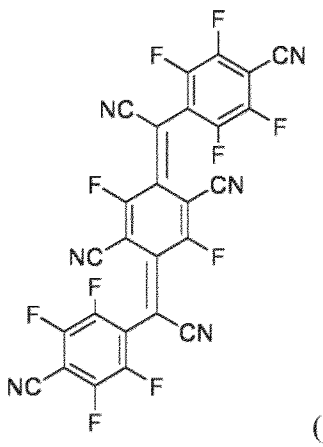
(C3),
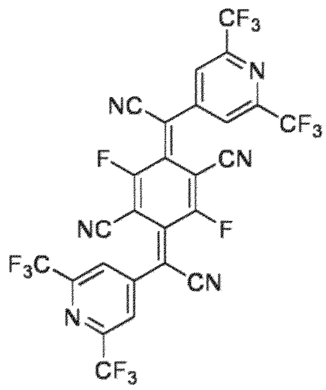
(C4),

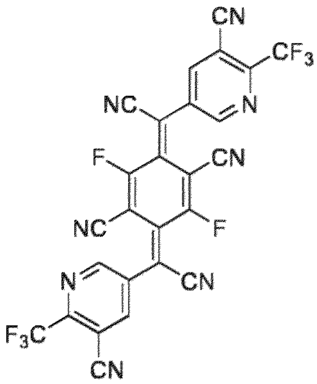 (C5), 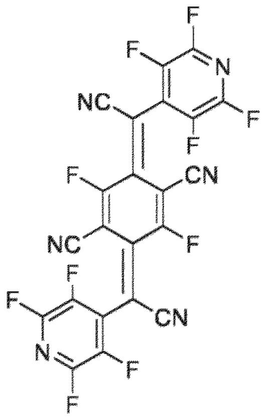 (C6),

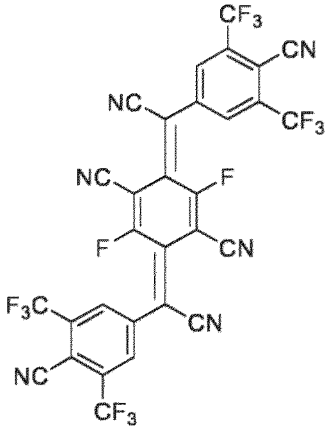 (C7), 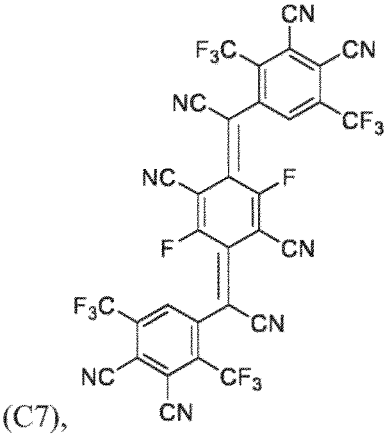 (C8),

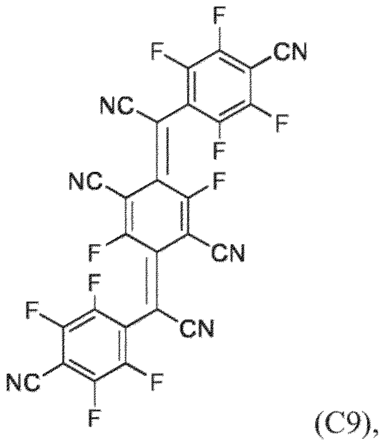 (C9), 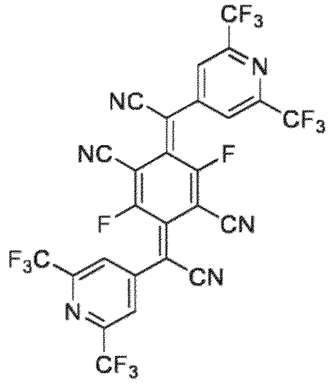 (C10),

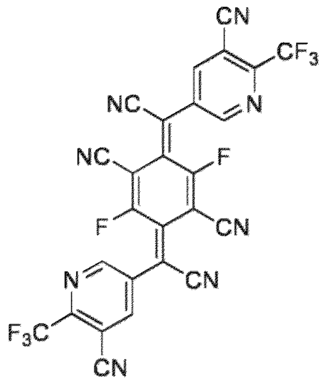 (C11), 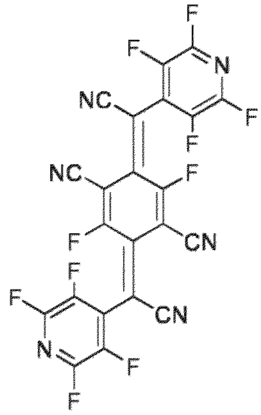 (C12),

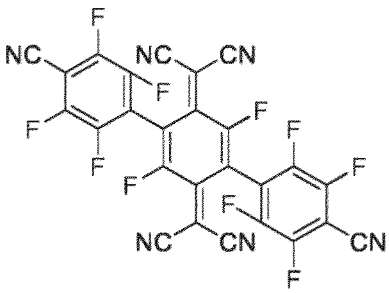 (C13), 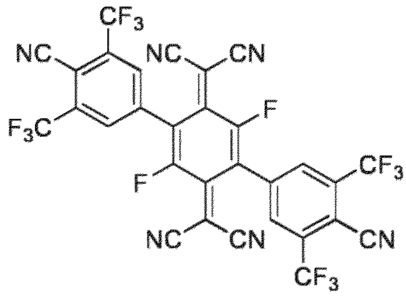 (C14),

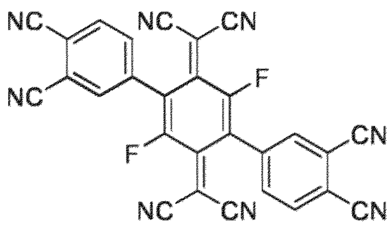 (C15), 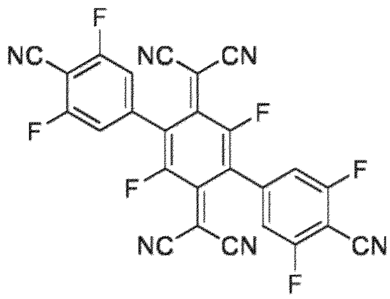 (C16),

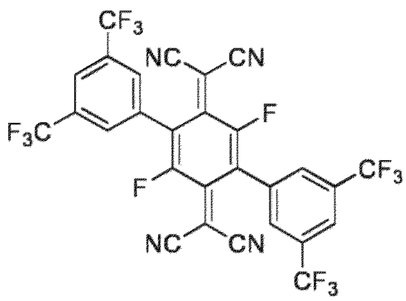 (C17), 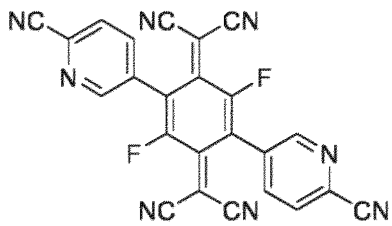 (C18),

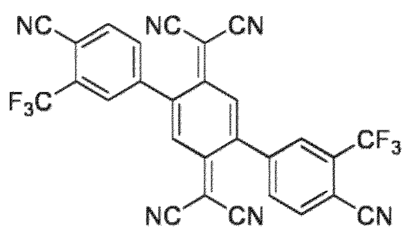 (C19),

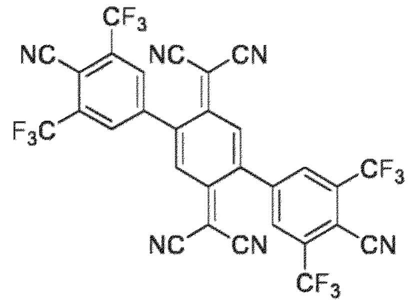 (C20),

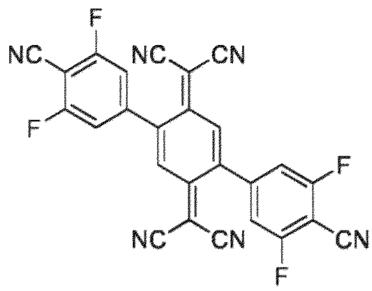 (C21),

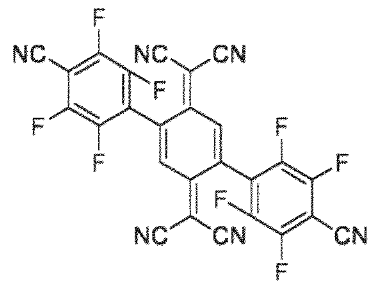 (C22),

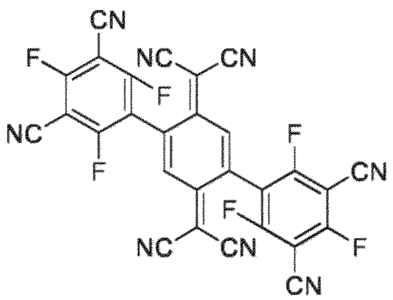 (C23),

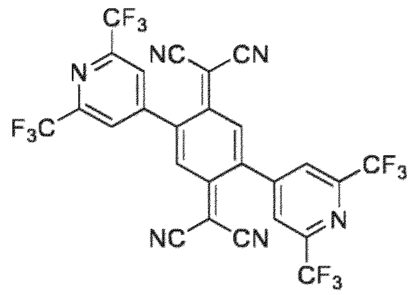 (C24),

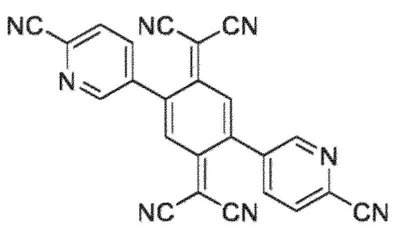 (C25),

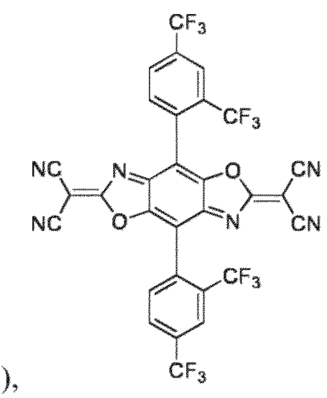 (C26),

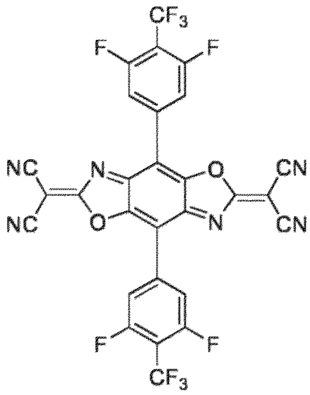
(C27),
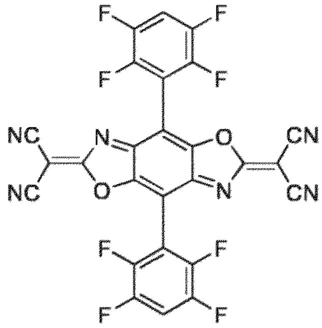
(C28),

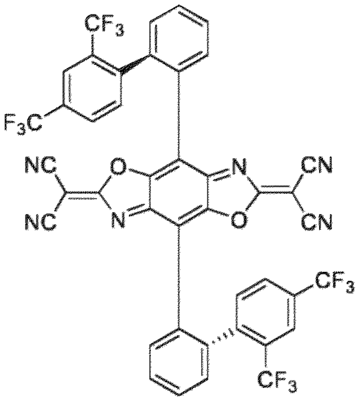
(C29),
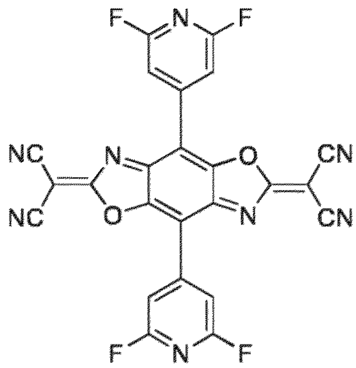
(C30).

**16.** The organic electroluminescent device according to any of the preceding claims 1 to 15, wherein in formulae (P1) and/or (P2):

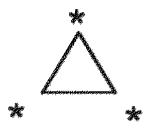
(P1),
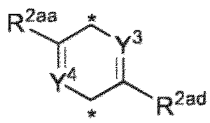
(P2),

- $Y^3$ is selected from $CR^{2ab}$;
- $Y^4$ is selected from $CR^{2ac}$;
- $R^{2aa}$, $R^{2ab}$, $R^{2ac}$, $R^{2ad}$ are independently selected from H, D, an electron-withdrawing group, halogen, Cl, F, CN; preferably $R^{2aa}$, $R^{2ab}$, $R^{2ac}$, $R^{2ad}$ are selected from H, D, F or CN, most preferred $R^{2aa}$, $R^{2ab}$, $R^{2ac}$, $R^{2aa}$ are selected form F or CN, also preferred two of $R^{2aa}$, $R^{2ab}$, $R^{2ac}$, $R^{2ad}$ are selected from F and two $R^{2aa}$, $R^{2ab}$, $R^{2ac}$, $R^{2ad}$ are selected from CN; and
- each $R^L$ according to formula (IIa) is independently selected from formulae D1 to D80, preferably D1 to D78, more preferred D1 to D67;

preferably $A^1$ is (P1) and each $R^L$ may be selected the same or differently; and/or $A^1$ is (P2) and each $R^L$ is selected the same.

**17.** The organic electroluminescent device according to any of the preceding claims 1 to 16, wherein in formulae (P2) to (P4):

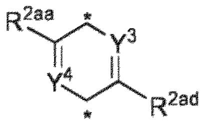 (P2), 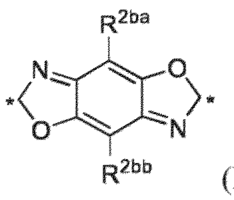 (P3), 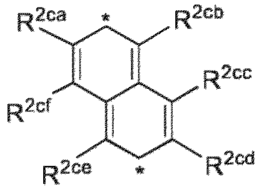 (P4),

- $R^{2aa}$, $R^{2ab}$, $R^{2ac}$, $R^{2ad}$, $R^{2ba}$, $R^{2bb}$, $R^{2ca}$, $R^{2cb}$, $R^{2cc}$, $R^{2cd}$, $R^{2ce}$, $R^{2cf}$ and $R^{2da}$ are independently selected from H, D, an electron-withdrawing group, halogen, Cl, F, CN, a substituted $C_6$ to $C_{30}$ aryl, or a substituted $C_3$ to $C_{30}$ heteroaryl,
wherein the one or more substituents are independently selected D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN;
wherein the one or more substituents of the substituted $C_1$ to $C_8$ alkyl, substituted $C_1$ to $C_8$ alkoxy are independently selected D, an electron-withdrawing group, halogen, Cl, F, CN, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

**18.** The organic electroluminescent device according to any of the preceding claims 1 to 17, wherein in formulae (P2) and/or (P3):

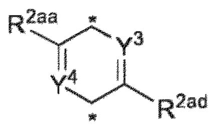 (P2), 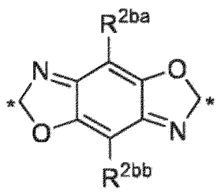 (P3),

- $R^{2aa}$, $R^{2ad}$, $R^{2ba}$ and $R^{2bb}$ are independently selected from formulae E1 to E73;
preferably $R^{2aa}$, $R^{2ad}$, $R^{2ba}$ and $R^{2bb}$ are selected the same;
- $Y^3$ is selected from $CR^{2ab}$;
- $Y^4$ is selected from $CR^{2ac}$;
- $R^{2ab}$ and $R^{2ac}$ are independently selected from H, D, an electron-withdrawing group, halogen, Cl, F, CN; preferably $R^{2ab}$ and $R^{2ac}$ are selected from H, D, F or CN.

**19.** The organic electroluminescent device according to any of the preceding claims 1 to 18, wherein the p-type dopant of formula (II) is selected from formulae F1 to F60:

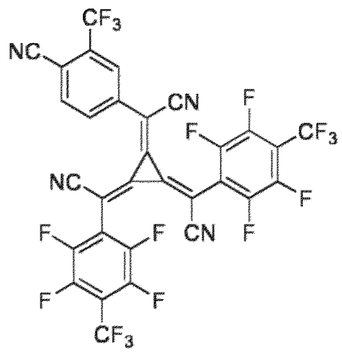 (F1), 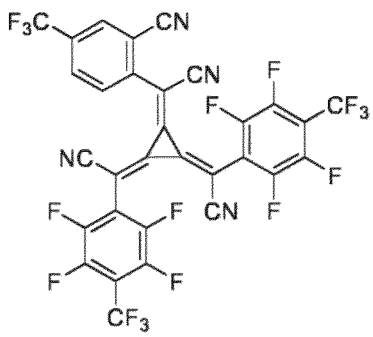 (F2),

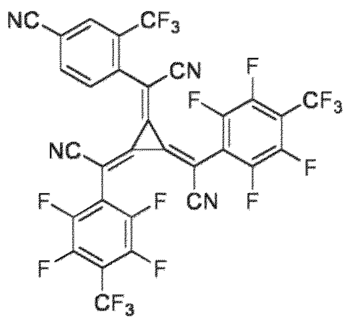
(F3),
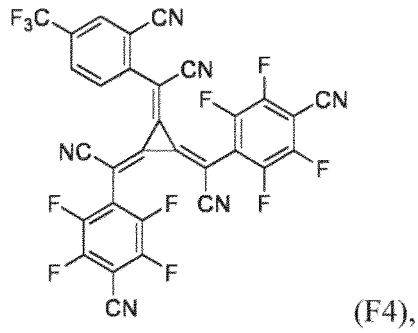
(F4),

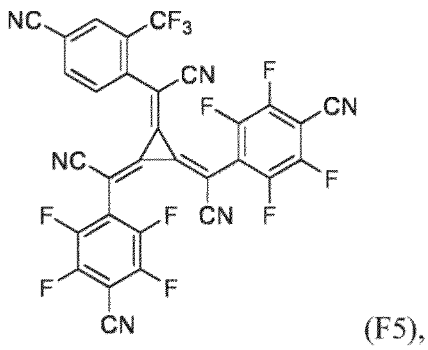
(F5),
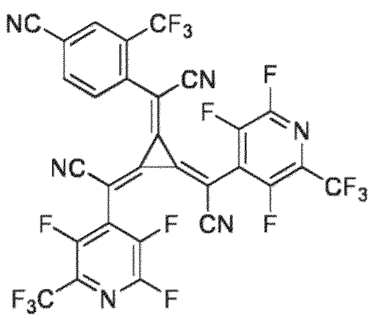
(F6),

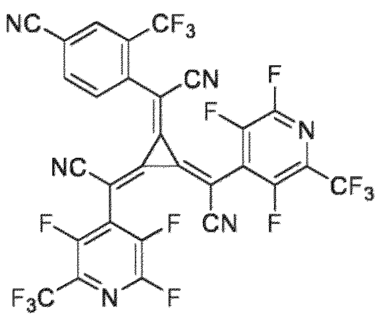
(F7),
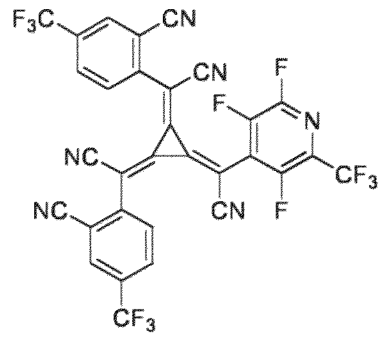
(F8),

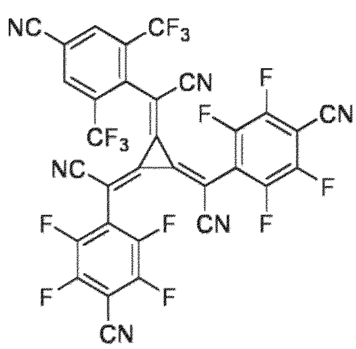
(F9),
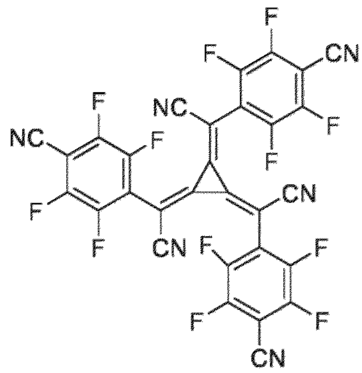
(F10),

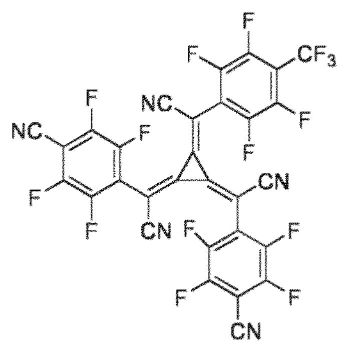 (F11), 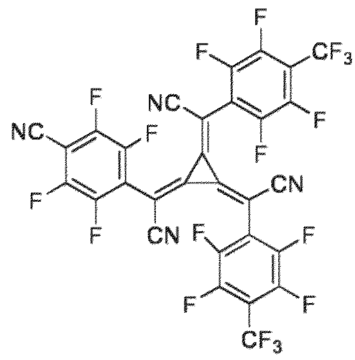 (F12),

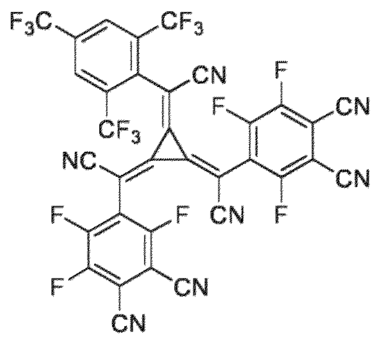 (F13), 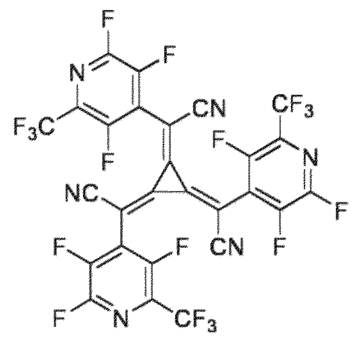 (F14),

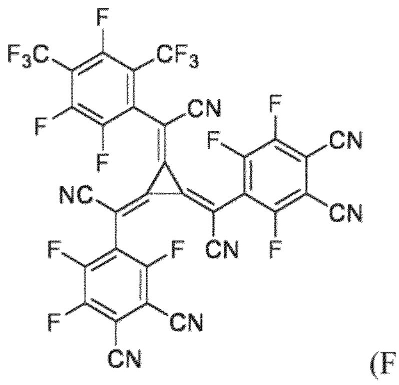 (F15), 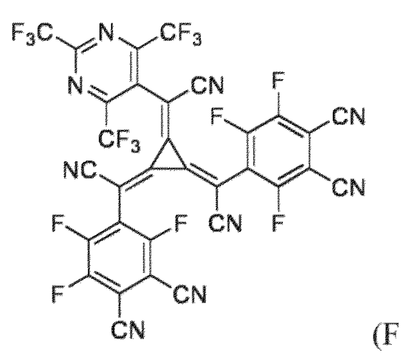 (F16),

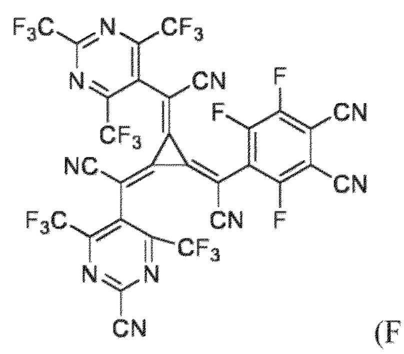 (F17), 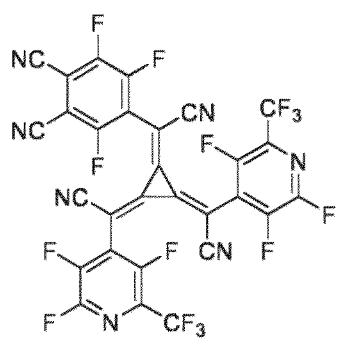 (F18),

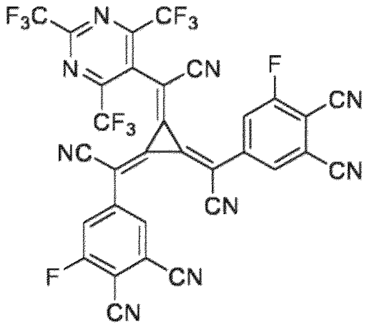 (F19), 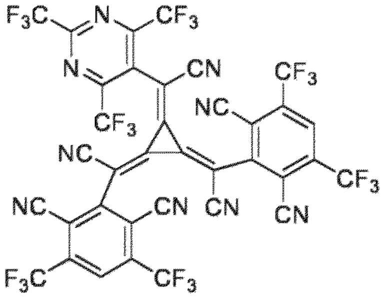 (F20),

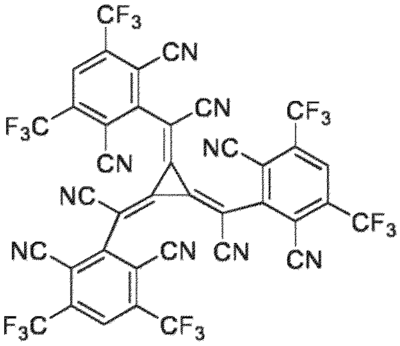 (F21), 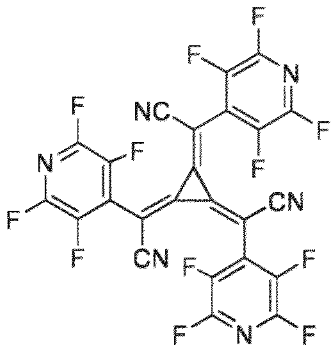 (F22),

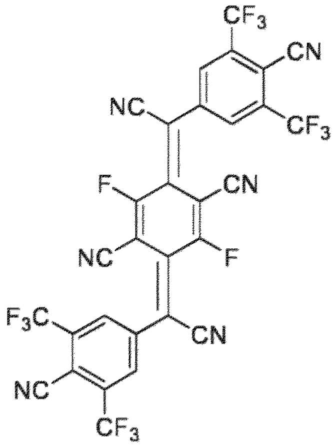 (F23), 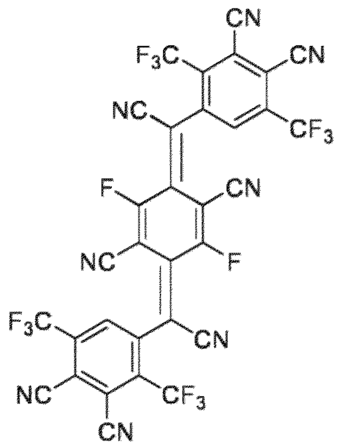 (F24),

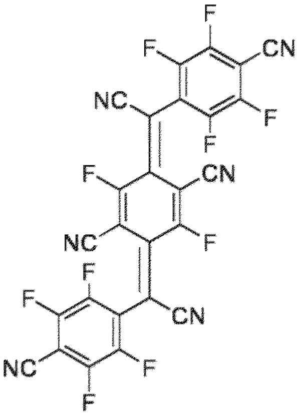 (F25), 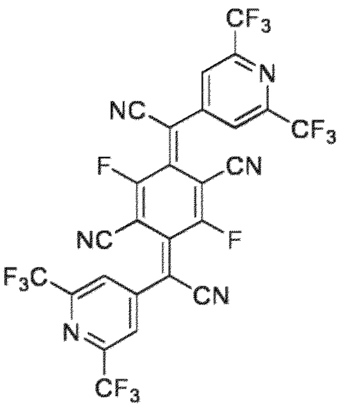 (F26),

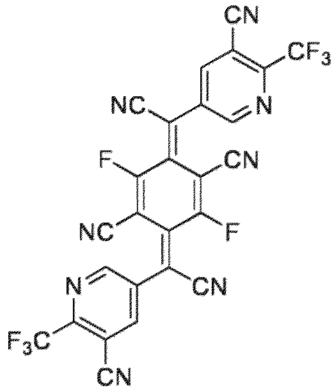 (F27), 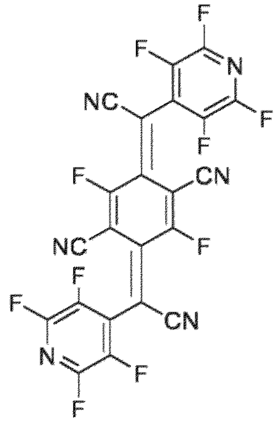 (F28),

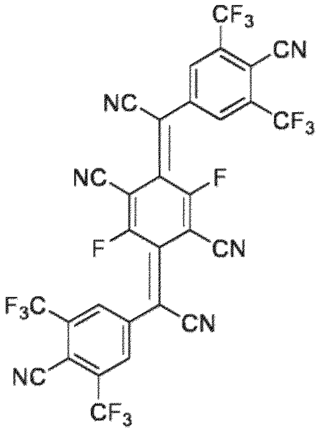 (F29), 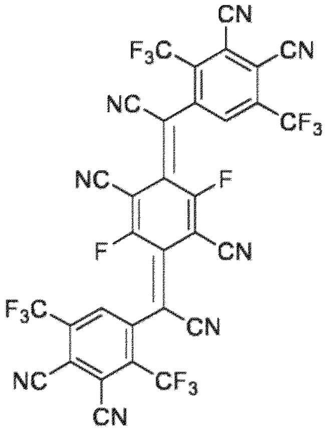 (F30),

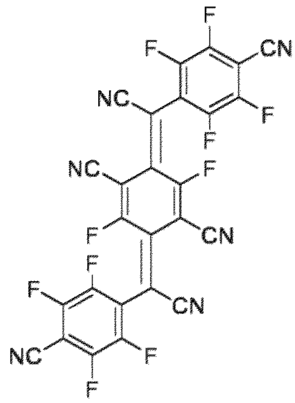 (F31), 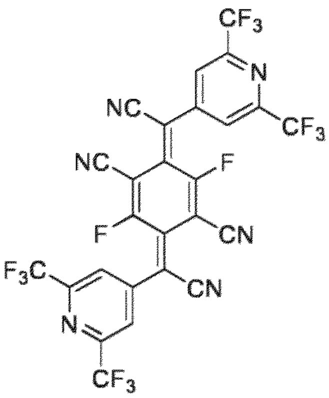 (F32),

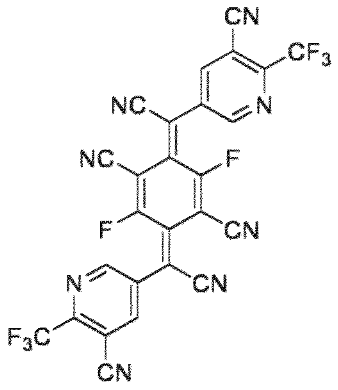
(F33),
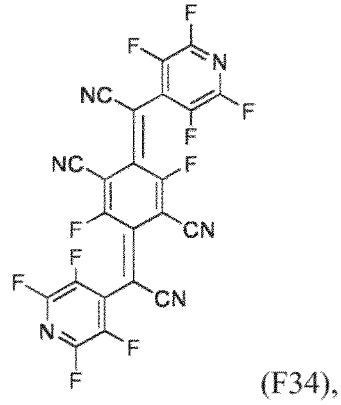
(F34),

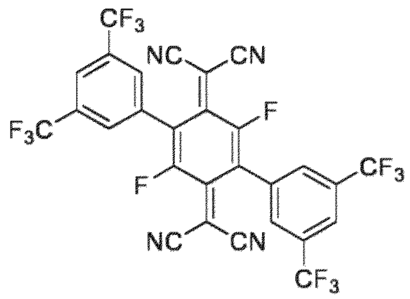
(F35),
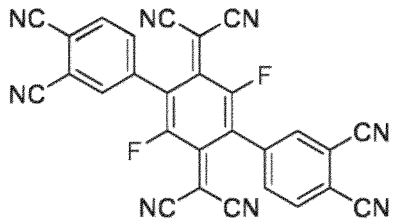
(F36),

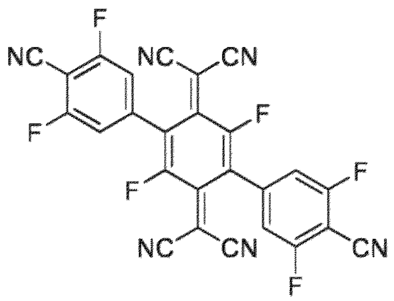
(F37),
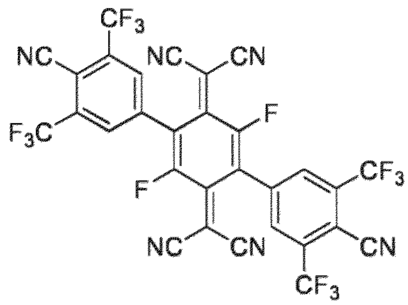
(F38),

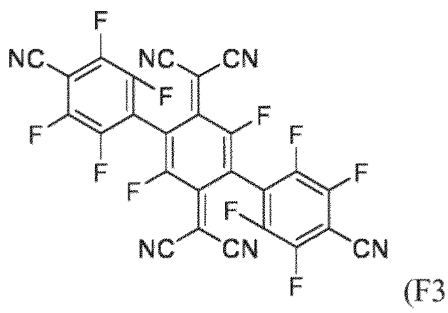
(F39),
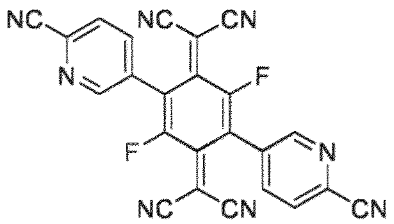
(F40),

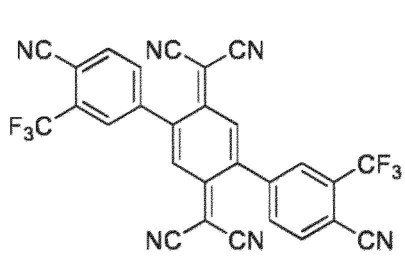
(F41),
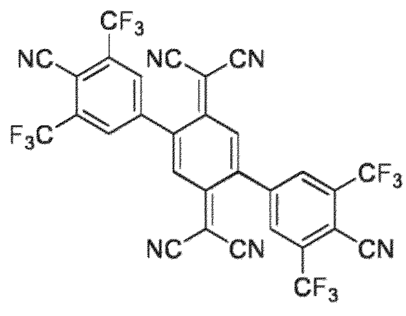
(F42),

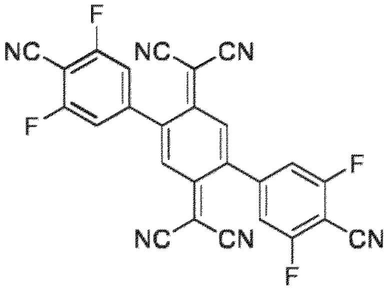 (F43), 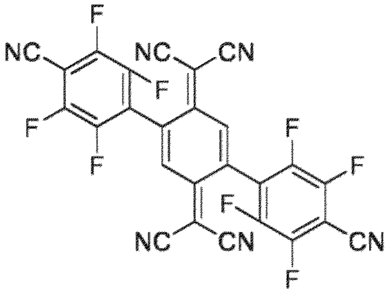 (F44),

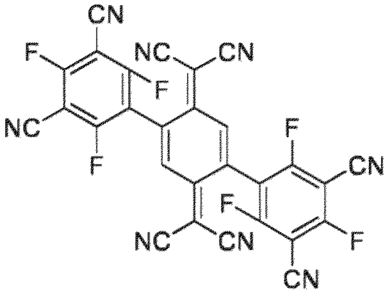 (F45), 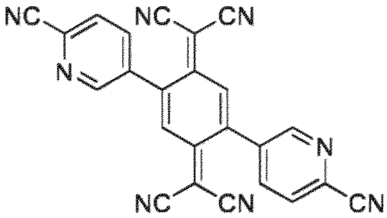 (F46),

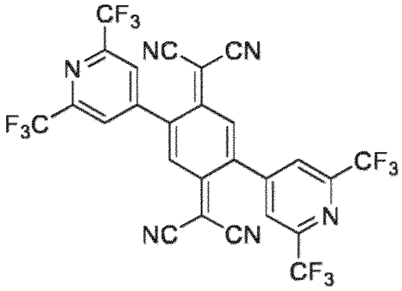 (F47), 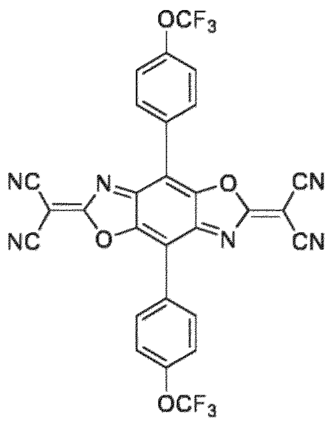 (F48),

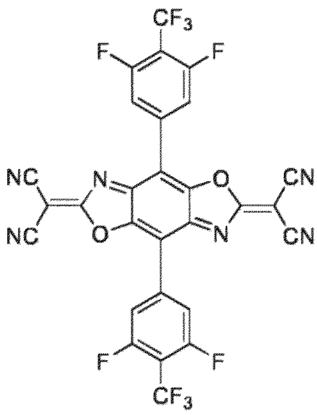 (F49), 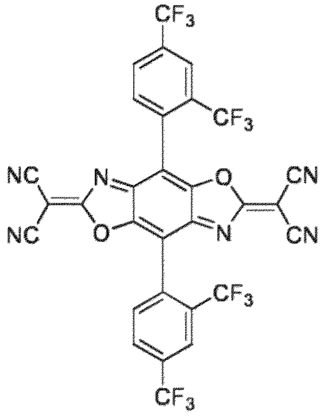 (F50),

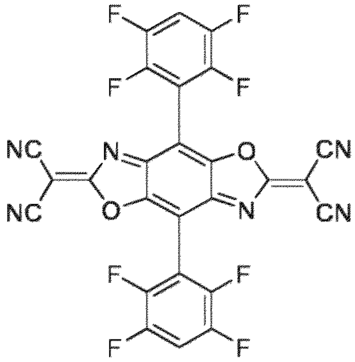
(F51),

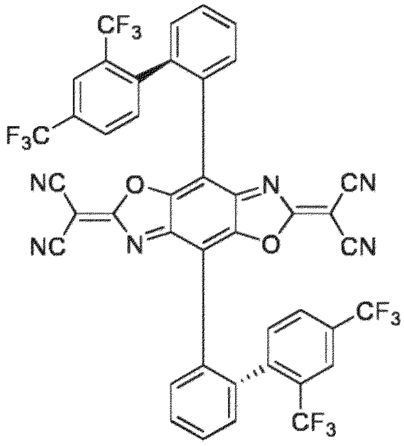
(F52),

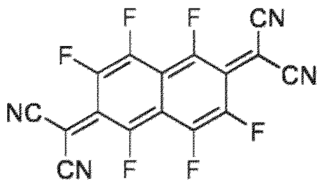
(F53),

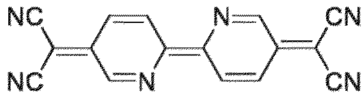
(F54),

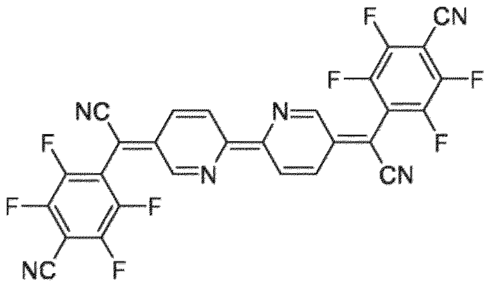
(F55),

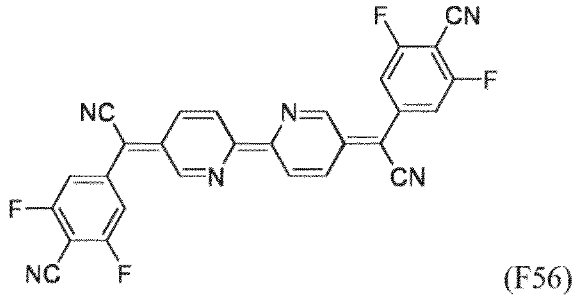
(F56),

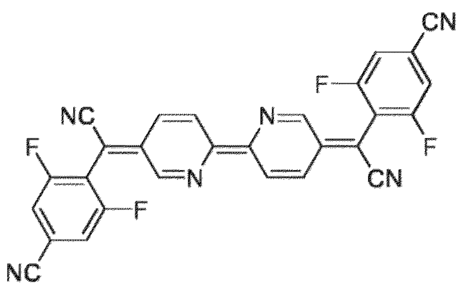
(F57),

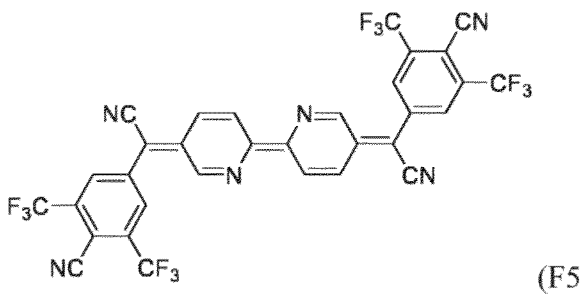
(F58),

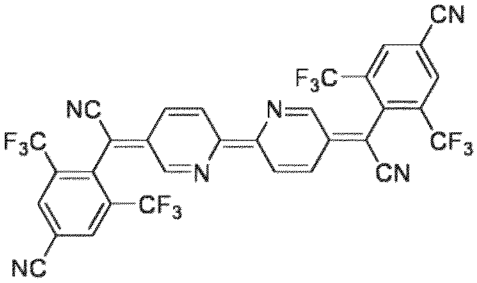
(F59),

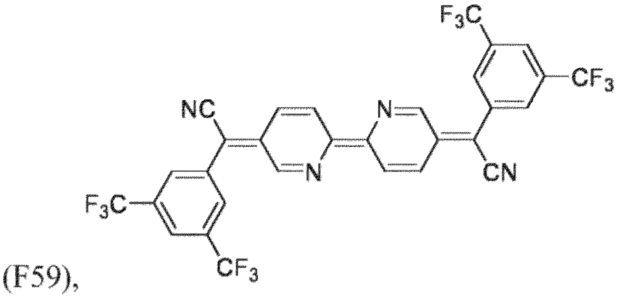
(F60).

**20.** The organic electroluminescent device according to any of the preceding claims 1 to 19, wherein the first hole transport matrix compound and/or the second hole transport matrix are selected the same or different from the group

comprising an arylamine compound, diarylamine compound, triarylamine compound, a compound of formula (IVa) or a compound of formula (IVb):

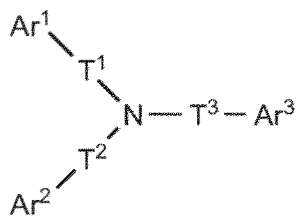 (IVa), 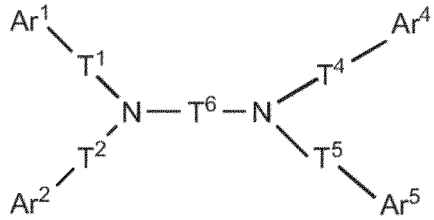 (IVb),

wherein:

$T^1$, $T^2$, $T^3$, $T^4$ and $T^5$ are independently selected from a single bond, phenylene, biphenylene, terphenylene or naphthenylene, preferably a single bond or phenylene;
$T^6$ is phenylene, biphenylene, terphenylene or naphthenylene;
$Ar^1$, $Ar^2$, $Ar^3$, $Ar^4$ and $Ar^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spuobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein the substituents of $Ar^1$, $Ar^2$, $Ar^3$, $Ar^4$ and $Ar^5$ are selected the same or different from the group comprising H, D, F, C(=O)$R'^1$, CN, $Si(R'^1)_3$, $P(=O)(R'^1)_2$, $OR'^1$, $S(=O)R'^1$, $S(=O)_2R'^1$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein $R'^1$ is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C6 to $C_{18}$ aryl or $C_3$ to $C_{18}$ heteroaryl.

**21.** The organic electroluminescent device according to any of the preceding claims 1 to 20, wherein

- the n-CGL matrix compound is selected from an azine compound, preferably an azine compound comprising at least one phenanthrolinyl moiety; and/or
- the metal dopant is selected from an alkali, alkaline earth metal or rare earth metal dopant, preferably Li or Yb.

**22.** An electronic device comprising an organic electroluminescent device according to any of the claims 1 to 21, wherein the electronic device is preferably a display device.

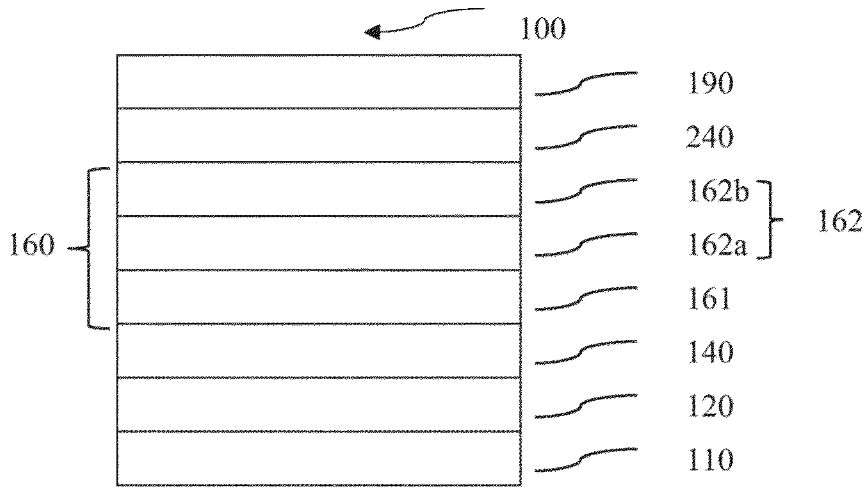
100
190
240
162b
162a
162
160
161
140
120
110

Fig. 1

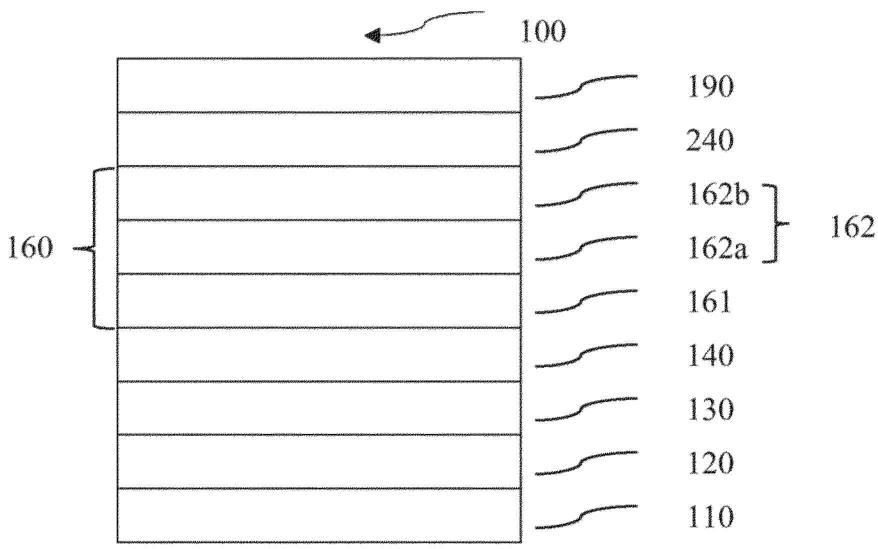
100
190
240
162b
162a
162
160
161
140
130
120
110

Fig. 2

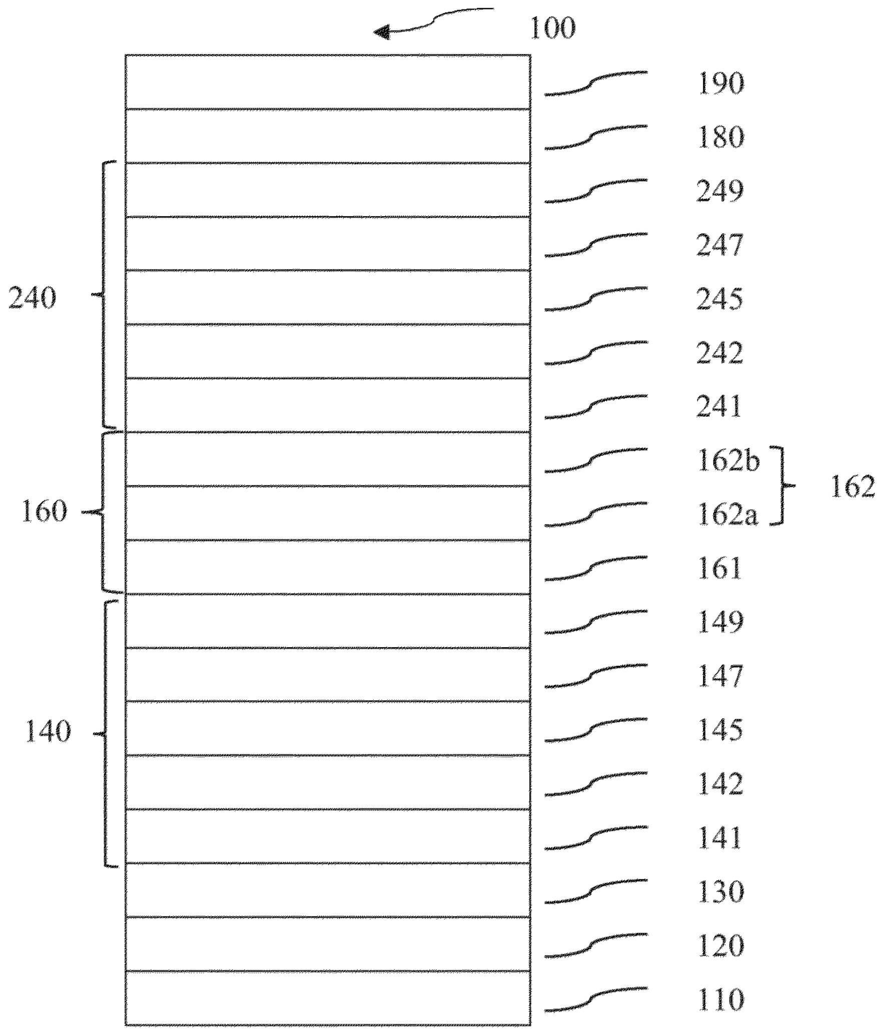
100
190
180
249
247
245
242
241
162b
162a
161
149
147
145
142
141
130
120
110
240
160
140
162

**Fig. 3**

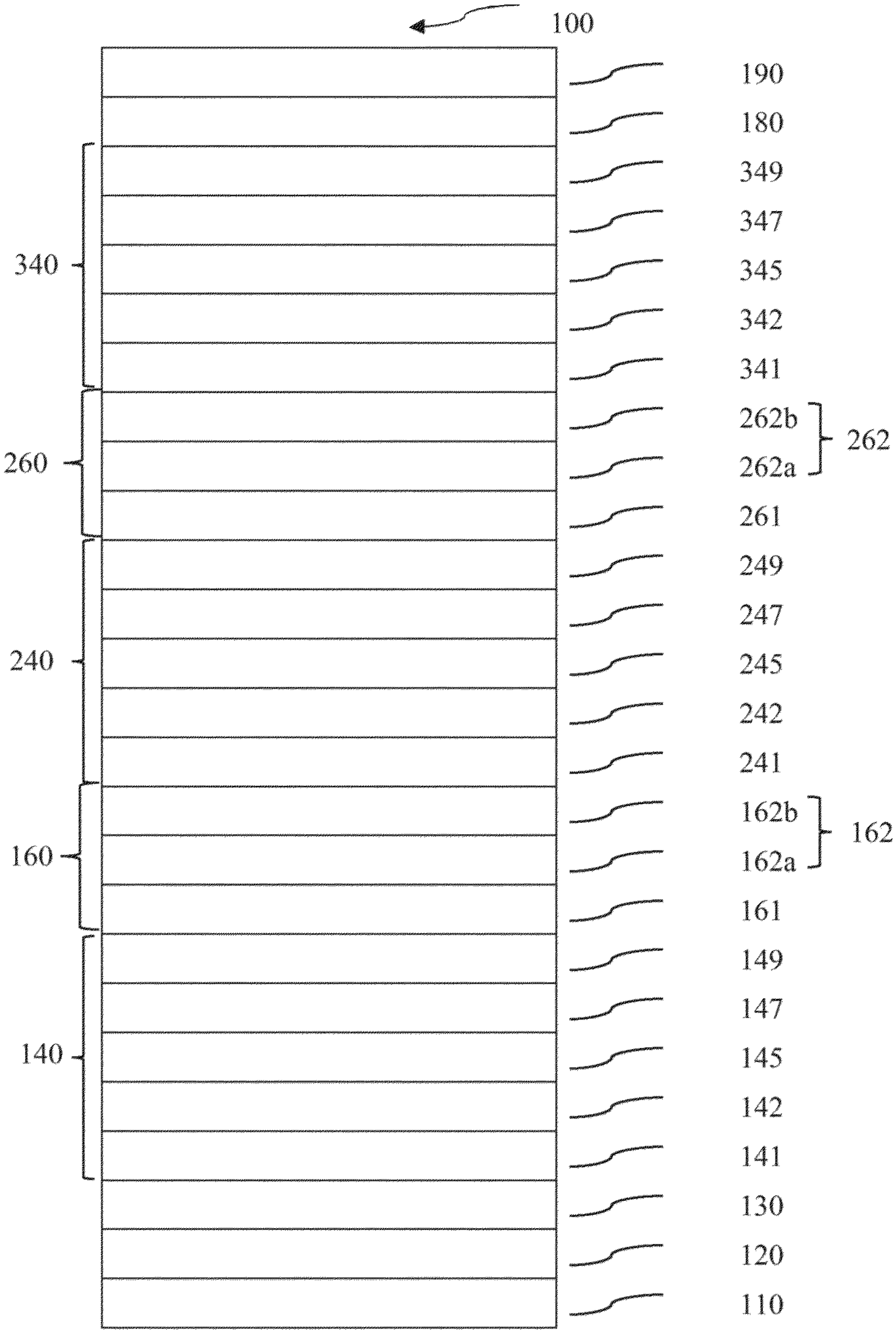
100
190
180
349
347
345
342
341
262b
262a
262
261
249
247
245
242
241
162b
162a
162
161
149
147
145
142
141
130
120
110
340
260
240
160
140

Fig. 4

Europäisches Patentamt
European Patent Office
Office européen des brevets

# EUROPEAN SEARCH REPORT

Application Number
EP 24 19 5613

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KR 102 081 122 B1 (GLDS) 25 February 2020 (2020-02-25) * the whole document * ----- | 1-22 | INV. H10K59/32 ADD. H10K85/60 |
| A | US 2023/329103 A1 (CHOI JUNGHO [KR] ET AL) 12 October 2023 (2023-10-12) * the whole document * ----- | 1-22 | |
| | | | TECHNICAL FIELDS SEARCHED (IPC) |
| | | | H10K |

The present search report has been drawn up for all claims

1

| Place of search | Date of completion of the search | Examiner |
|---|---|---|
| The Hague | 14 January 2025 | Parashkov, Radoslav |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 24 19 5613

This annex lists the patent family members relating to the patent documents cited in the above-mentioned European search report. The members are as contained in the European Patent Office EDP file on
The European Patent Office is in no way liable for these particulars which are merely given for the purpose of information.

14-01-2025

| Patent document cited in search report | Publication date | Patent family member(s) | Publication date |
|---|---|---|---|
| KR 102081122 B1 | 25-02-2020 | NONE | |
| US 2023329103 A1 | 12-10-2023 | CN 116896910 A | 17-10-2023 |
| | | KR 20230145615 A | 18-10-2023 |
| | | US 2023329103 A1 | 12-10-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2023329103 A
- US 2023422538 A1
- EP 2722908 A1
- WO 2022263524 A1


### Non-patent literature cited in the description


- **YASUHIKO SHIROTA** ; **HIROSHI KAGEYAMA**. *Chem. Rev*, 2007, vol. 107, 953-1010
- *CHEMICAL ABSTRACTS*, 2457172-82-4
- *CHEMICAL ABSTRACTS*, 2482607-57-6